# EUROPÄISCHE PATENTSCHRIFT

(11) **EP 3 137 574 B1**
(45) Veröffentlichungstag und Bekanntmachung des Hinweises auf die Patenterteilung: **04.04.2018**
(21) Anmeldenummer: 15778218.6
(22) Anmeldetag: 17.09.2015
(51) Int. Cl.: C09K 11/06, H01L 51/50

(54) **ORGANISCHE MOLEKÜLE ZUR VERWENDUNG ALS EMITTER**
ORGANIC MOLECULES FOR USE AS EMITTERS
MOLÉCULES ORGANIQUES DESTINÉES À ÊTRE UTILISÉES EN TANT QU'ÉMETTEURS

(30) Priorität: 17.09.2014 EP 14185118; 18.11.2014 EP 14193686
(43) Veröffentlichungstag der Anmeldung: 08.03.2017
(60) Teilanmeldung: 17176049.9
(73) Patentinhaber: cynora GmbH, 76646 Bruchsal (DE)
(72) Erfinder: DANZ, Michael, 76344 Eggenstein-Leopoldshafen (DE)
(74) Vertreter: Hoppe, Georg Johannes
(86) Internationale Anmeldenummer: PCT/EP2015/071309
(87) Internationale Veröffentlichungsnummer: WO 2016/042070

(56) Entgegenhaltungen:
- CN-A- 102 086 181
- JP-A- 2007 191 636
- US-A1- 2010 148 662

## Beschreibung

Die Erfindung betrifft rein organische Moleküle (Farbstoffe) ohne Metallzentren der allgemeinen Formel A, und deren Verwendung als Emitter in OLEDs (organic light emitting diodes) und in anderen opto-elektronischen Bauelementen.

### Einleitung

Optoelektronische Bauteile zeichnen sich dadurch aus, dass entweder elektrische Energie in Photonen umgewandelt werden (OLED, LEEC) oder der umgekehrte Prozess abläuft (OPV). Dabei ist es wichtig, dass diese Prozesse möglichst effizient ablaufen. Für den Bereich von OLEDs müssen daher idealerweise Materialien mit möglichst hoher photolumineszenter Quantenausbeute verwendet werden. Es muss jedoch ebenfalls in Betracht gezogen werden, dass, wie dem Fachmann bekannt ist, in einer OLED 25 % Singulett-Excitonen und 75 % Triplett-Excitonen gebildet werden. Dies führt dazu, dass ein normaler Fluoreszenzemitter eine maximale interne Quantenausbeute von 25 % erreichen kann, Ebenso entsteht durch die gebildeten langlebigen, nicht emittierenden Triplettzustände das Problem einer stark abfallenden Effizienz bei höheren Strömen (sog. Effizienz roll-off).

Um diese Nachteile zu umgehen und möglichst alle Ladungsträger zu nutzen, kann das dem Fachmann bekannte Konzept des Triplett-Harvesting genutzt werden. Hierzu müssen in der Regel teure Schweratom-Komplexe (z. B. Iridium oder Platin) verwendet werden (siehe hierzu z. B.: M. A. Baldo, D. F. O'Brian, M. E. Thompson, S. R. Forrest, Phys. Rev. B 1999, 60, 14422 and H. Yersin, Top. Curr. Chem. 2004, 241, 1).

Eine andere Alternative ist die Verwendung von Materialien, die thermisch aktivierte verzögerte Fluoreszenz (TADF) zeigen. Hierbei können auch die entstandenen Triplett-Excitonen in Singulett-Excitonen überführt werden, aus welchem Zustand dann Photonen emittiert werden können. Voraussetzung für eine solche thermische Rückbesetzung ist dabei ein geringer energetischer Abstand zwischen dem niedrigsten angeregten Singulett- (S₁) und Triplett-Niveau (T₁). Dies kann beispielweise durch Verwendung von Kupfer-(I)-Komplexen (siehe hierzu z. B.: H. Yersin, U. Monkowius, T. Fischer, T. Hofbeck, WO 2010/149748 A1, 2010) aber auch durch rein organische Materialien (siehe hierzu z. B.: K. Shizu, H. Tanaka, H. Nakanotani, C. Adachi, WO 2013/172255 A1; H. Uoyama, K. Goushi, K. Shizu, H. Nomura, C. Adachi, Nature 2012, 492, 234) erreicht werden.

Die intensive Forschung in diesem Bereich zeigt, dass es trotz einiger bereits bestehender Konzepte für derartige Emittermaterialien weiterhin einen großen Bedarf an neuen Materialien gibt. Unter anderem ist hierfür ursächlich, dass es sowohl unterschiedliche Anwendungsbereiche (Bildschirmtechnologie, Beleuchtung, smarte Verpackungen, usw.) als auch Herstellungsweisen (Vakuum, Flüssig oder hybride Prozessierungen) gibt. Besonders für den Bereich der Flüssigprozessierung muss ebenso die gezielte Löslichkeit bzw. Unlöslichkeit in speziellen Lösungsmitteln beachtet werden (Orthogonalität), damit Schichten nachfolgend aufgebracht werden können, ohne dass sich die zuvor abgeschiedene Schicht wieder anlöst. Neben den erwähnten Eigenschaften dieser Materialien ist für eine Kommerzialisierung ebenso die Zugänglichkeit relevant. Dies schließt die Verfügbarkeit von Synthesebausteinen, als auch den Aufwand für die eigentliche Synthese des funktionellen Materials, insbesondere dessen Aufreinigung mit ein.

Die CN 102086181 A betrifft ein Syntheseverfahren eines 2,2'-Diaryl-4,4',5,5'-biphenyl-tetraacid-dianhydrid-Monomers. In der JP 2007191636 A ist eine Tintenzusammensetzung beschrieben.

### Beschreibung der Erfindung

Die Erfindung betrifft in einem Aspekt die Bereitstellung von Molekülen, die eine Struktur der allgemeinen Formel A umfassen oder daraus bestehen. 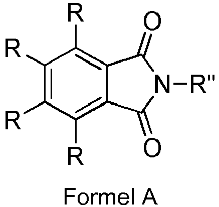 wobei mindestens ein R am Arylring einen Donor D darstellt, der eine Struktur der Formel I aufweist: 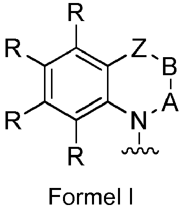 wobei
A und B = unabhängig voneinander ausgewählt aus der Gruppe bestehend aus CRR', CR, NR, N, wobei zwischen A und B eine Einfach- oder Doppelbindung vorliegt und zwischen B und Z eine Einfach- oder Doppelbindung vorliegt;
Z = eine direkte Bindung oder eine divalente organische Brücke, die eine substituierte oder unsubstituierte C1-C9-Alkylen-, C2-C8-Alkenylen-, C2-C8-Alkinylen- oder Arylen-Gruppe oder eine Kombination dieser, -CRR', -C=CRR', -C=NR, -NR-, -O-, -SiRR'-, -S-, -S(O)-, -S(O)₂-, durch O unterbrochene substituierte oder unsubstituierte C1-C9-Alkylen-, C2-C8-Alkenylen-, C2-C8-Alkinylen-oder Arylen-Gruppe, Phenyl- oder substituierte Phenyleinheiten ist; wobei die gewellte Linie die Position kennzeichnet, über die der Donor D an den Phenylring in Formel A gebunden ist;
   wobei
jedes R und R' bei jedem Auftreten gleich oder verschieden ist H, Deuterium, Azid, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme, oder eine quervernetzbare Einheit QE ist, die durch säurekatalytische, basenkatalytische, thermische oder UV-Quervernetzungsverfahren in Anwesenheit oder Abwesenheit eines Photoinitiators oder durch Mikrowellenstrahlung quervernetzt werden kann; dabei können zwei oder mehrere der Substituenten R*, R und R' auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden; und wobei R" die gleiche Bedeutung wie R hat oder eine organische Brücke ist, worüber eine zweite gleiche oder verschiedene Einheit der Formel A verbunden ist und somit ein dimeres System ausgebildet wird.

Bei den quervernetzbaren Einheiten QE handelt es sich in einer Ausführungsform um eine Verbindung ausgewählt aus der Gruppe bestehend aus Oxetanen, Alkinen und Aziden, insbesondere für eine Clickreaktion, sowie folgenden Alkenderivaten:

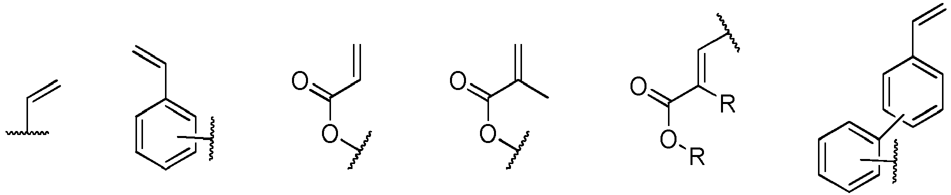

In einer alternativen Ausführungsform handelt es sich bei Z um eine kovalente Einfachbindung oder eine bivalente organische Brücke ausgewählt aus substituierten und unsubstituierten Alkylen- (auch verzweigt oder zyklisch), Alkenylen-, Alkinylen-, Arylen- und Heteroarylen-Gruppen, O, NR, C=CR₂, C=NR, SiR₂ S, S(O), S(O)₂, BR, PR, P(O)R, wobei auch Kombinationen dieser Einheiten möglich sind (z.B. durch O unterbrochene Alkylen- (auch verzweigt oder zyklisch), Alkenylen-, Alkinylen-, Arylen-und Heteroarylen-Gruppen).

Die erfindungsgemäßen Moleküle bieten die Möglichkeit, über die Einführung der Reste R', R², R³ und insbesondere R* und R diverse Eigenschaften zu implementieren: die Löslichkeit in unterschiedlichen Lösungsmitteln kann eingestellt werden; es können leicht Gruppen zur Quervernetzung eingeführt werden (z. B. Alkene, Alkine, Oxetane), die Akzeptorstärke kann variiert werden, durch mehr oder weniger Elektronenschiebende bzw. -ziehende Substituenten, wodurch die Emissionsfarbe des Gesamtmoleküls beeinflusst werden kann.

Eine Arylgruppe enthält 6 bis 40 C-Atome; eine Heteroarylgruppe enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.
Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroaryl-gruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als aromatisches bzw. heteroaromatisches Ringsystem verstanden werden.
Unter einer cyclischen Alkyl-, Alkoxy- oder Thioalkoxygruppe wird eine monocyclische, eine bicyclische oder eine polycyclische Gruppe verstanden.
Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluor-methyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl-und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁ bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.
Unter einem aromatischen oder heteroaromatischen Ringsystem mit 5-60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spiro-bifluoren, Dihydrophenanthren, Dihydropyren, Tetrahydropyren, cis-oder trans-Indenofluoren, cis- oder trans-Monobenzoindenofluoren, cis- oder trans-Dibenzoindenofluoren, Truxen, Isotruxen, Spirotruxen, Spiroiso-truxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazin-imidazol, Chinoxalinimidazol, Oxazol, Benzoxazol, Naphthoxazol, Anthroxazol, Phenanthroxazol, Isoxazol, 1,2-Thiazol, 1,3-Thiazol, Benzo-thiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Aza-carbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thia-diazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer Ausführungsform ist R" ausgewählt aus folgenden Gruppen:
- Alkylreste (lineare, verzweigte, teilweise fluoriert, (Hetero-)Aryl-substituiert, (Poly-)Ether, Ester, Alkoholsubstituiert) wie beispielsweise 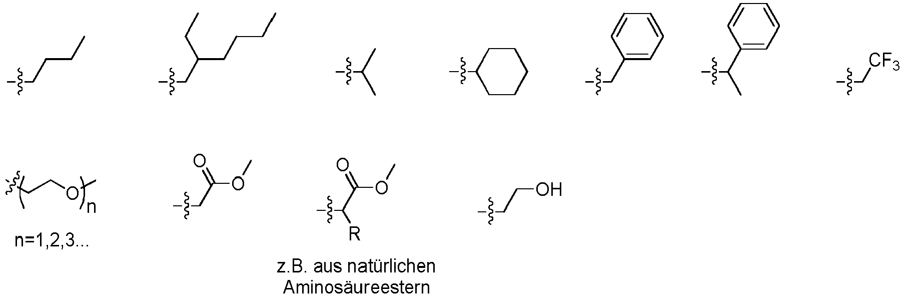
- (Hetero-)Arylreste (Alkylsubstituiert, mit elektronenziehenden und/oder elektronenschiebenden Gruppen substituiert) wie beispielsweise

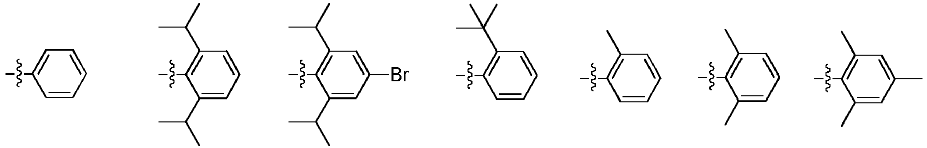

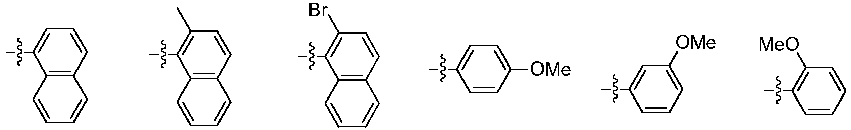

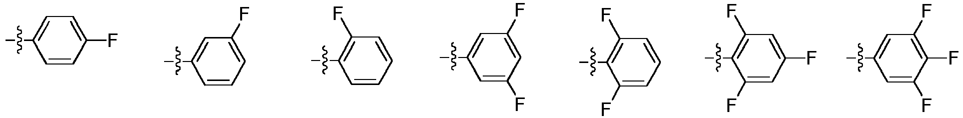

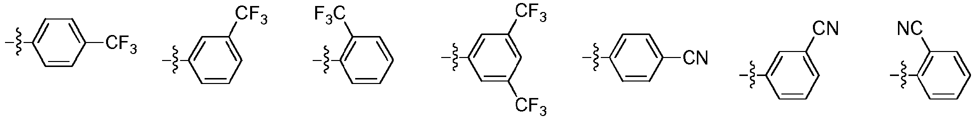

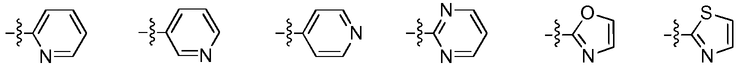

In einer bevorzugten Ausführungsform weist das organische Molekül eine Struktur der Formel D* auf: 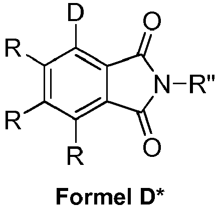 wobei R, R" und D wie bei Formel D definiert sind, mit der Maßgabe, dass R kein Donor sein kann.

In einer besonders bevorzugten Ausführungsform weist das organische Molekül eine Struktur der Formel D** auf: 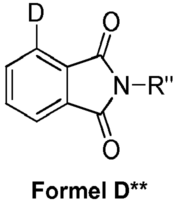 wobei R" und D wie bei Formel D definiert sind.

In einer weiteren Ausführungsform der Erfindung weist das Organische Molekül eine Struktur der Formel E auf: 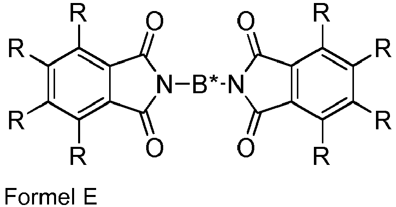 wobei mindestens ein R am Arylring einen Donor D darstellt, mit
D = jeweils eine Donorgruppe mit elektronenschiebenden Eigenschaften, die eine Struktur der Formel I aufweist: 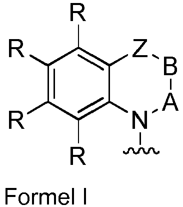 wobei
   A und B = unabhängig voneinander ausgewählt aus der Gruppe bestehend aus CRR', CR, NR, N, wobei zwischen A und B eine Einfach- oder Doppelbindung vorliegt und zwischen B und Z eine Einfach- oder Doppelbindung vorliegt;
   Z = eine direkte Bindung oder eine divalente organische Brücke, die eine substituierte oder unsubstituierte C1-C9-Alkylen-, C2-C8-Alkenylen-, C2-C8-Alkinylen- oder Arylen-Gruppe oder eine Kombination dieser, -CRR', -C=CRR', -C=NR, -NR-, -O-, -SiRR'-, -S-, -S(O)-, -S(O)₂-, durch O unterbrochene substituierte oder unsubstituierte C1-C9-Alkylen-, C2-C8-Alkenylen-, C2-C8-Alkinylen-oder Arylen-Gruppe, Phenyl- oder substituierte Phenyleinheiten ist; wobei die gewellte Linie die Position kennzeichnet, über die D an den Phenylring in Formel E gebunden ist;
   B* = eine organische Brücke, die eine substituierte oder unsubstituierte Alkylen-, Alkenylen-, Alkinylen- oder Arylen-Gruppe oder eine Kombination dieser, oder -O-, -NR-, -C=CR₂, -C=NR, -SiR₂-S-, -S(O)-, -S(O)₂-, durch O unterbrochene Alkyl- (auch verzweigt oder zyklisch), Heteroalkyl-, Aryl-, Heteroaryl-, Alkenyl-Gruppen, Phenyl- und substituierte Phenyleinheiten ist,
wobei jedes R und R' bei jedem Auftreten gleich oder verschieden ist H, Deuterium, Azid, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme, oder eine quervernetzbare Einheit QE ist, die durch säurekatalytische, basenkatalytische, thermische oder UV-Quervernetzungsverfahren in Anwesenheit oder Abwesenheit eines Photoinitiators oder durch Mikrowellenstrahlung quervernetzt werden kann; dabei können zwei oder mehrere dieser Substituenten R und R' auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

Beispielhaft aber nicht erschöpfend kann B* sein:

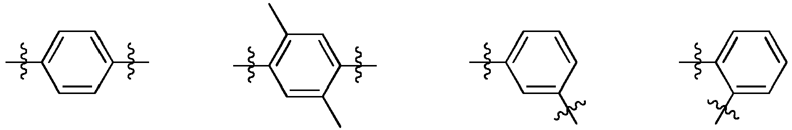

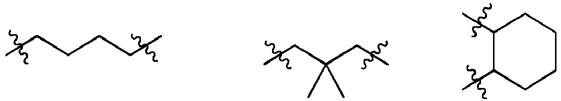

Bei den quervernetzbaren Einheiten QE handelt es sich in einer Ausführungsform um eine Verbindung ausgewählt aus der Gruppe bestehend aus Oxetanen, Alkinen und Aziden für eine Clickreaktion sowie folgenden Alkenderivaten:

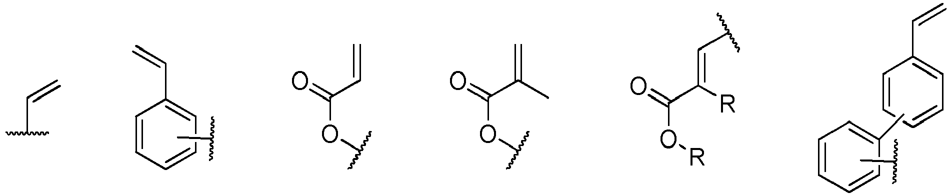

Bei Z handelt es sich in einer alternativen Ausführungsform um eine kovalente Einfachbindung oder eine bivalente organische Brücke ausgewählt aus substituierten und unsubstituierten Alkylen- (auch verzweigt oder zyklisch), Alkenylen-, Alkinylen-, Arylen- und Heteroarylen-Gruppen, O, NR, C=CR₂, C=NR, SiR₂ S, S(O), S(O)₂, BR, PR, P(O)R, wobei auch Kombinationen dieser Einheiten möglich sind (z.B. durch O unterbrochene Alkylen- (auch verzweigt oder zyklisch), Alkenylen-, Alkinylen-, Arylen-und Heteroarylen-Gruppen).

In einer alternativen Ausführungsform handelt es sich bei B um eine bivalente organische Brücke ausgewählt aus substituierten und unsubstituierten Alkylen- (auch verzweigt oder zyklisch), Alkenylen-, Alkinylen-, Arylen- und Heteroarylen-Gruppen, O, NR, C=CR₂, C=NR, SiR₂ S, S(O), S(O)₂, BR, PR, P(O)R, wobei auch Kombinationen dieser Einheiten möglich sind (z.B. durch O unterbrochene Alkylen- (auch verzweigt oder zyklisch), Alkenylen-, Alkinylen-, Arylen- und Heteroarylen-Gruppen).

In einer Ausführungsform ist D unabhängig voneinander jeweils eine Donorgruppe mit elektronenschiebenden Eigenschaften, die ausgewählt ist aus der Gruppe bestehend aus substituierten und unsubstituierten Carbazol, substituierten und unsubstituierten Indol, substituierten und unsubstituierten Indolin, substituierten und unsubstituierten Dihydroacridin, substituierten und unsubstituierten Benzimidazol, substituierten und unsubstituierten 2,3,4,9-Tetrahydrocarbazol, substituierten und unsubstituierten 1,2,3,4-Tetrahydrochinolin, substituierten und unsubstituierten Phenothiazin, substituierten und unsubstituierten Phenoxazin, substituierten und unsubstituierten Dihydrophenazin, substituierten und unsubstituierten Spiroverbindungen.

In einer weiteren Ausführungsform der Erfindung weist die Donorgruppe mit elektronenschiebenden Eigenschaften der Formel I eine Struktur der Formel II auf: 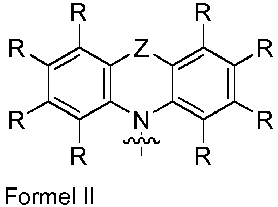 wobei
Z = eine direkte Bindung oder eine divalente organische Brücke, die eine substituierte oder unsubstituierte C1-C9-Alkylen-, C2-C8-Alkenylen-, C2-C8-Alkinylen- oder Arylen-Gruppe oder eine Kombination dieser, -CRR', -C=CRR', -C=NR, -NR-, -O-, -SiRR'-, -S-, -S(O)-, -S(O)₂-, durch O unterbrochene substituierte oder unsubstituierte C1-C9-Alkylen-, C2-C8-Alkenylen-, C2-C8-Alkinylen-oder Arylen-Gruppe, Phenyl- oder substituierte Phenyleinheiten ist; wobei die gewellte Linie die Position kennzeichnet, über die D an Ar gebunden ist;
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme, oder eine quervernetzbare Einheit QE ist, die durch säurekatalytische, basenkatalytische, thermische oder UV-Quervernetzungsverfahren in Anwesenheit oder Abwesenheit eines Photoinitiators oder durch Mikrowellenstrahlung quervernetzt werden kann; dabei können zwei oder mehrere dieser Substituenten R und R'auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

Bei den quervernetzbaren Einheiten QE handelt es sich in einer Ausführungsform um eine Verbindung ausgewählt aus der Gruppe bestehend aus Oxetanen, Alkinen und Aziden für eine Clickreaktion sowie folgenden Alkenderivaten:

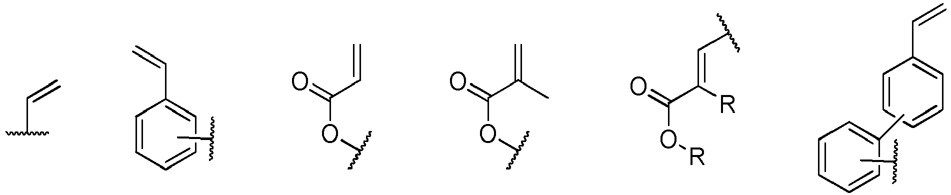

In einer alternativen Ausführungsform handelt es sich bei Z um eine kovalente Einfachbindung oder eine bivalente organische Brücke ausgewählt aus substituierten und unsubstituierten Alkylen- (auch verzweigt oder zyklisch), Alkenylen-, Alkinylen-, Arylen- und Heteroarylen-Gruppen, O, NR, C=CR₂, C=NR, SiR₂ S, S(O), S(O)₂, BR, PR, P(O)R, wobei auch Kombinationen dieser Einheiten möglich sind (z.B. durch O unterbrochene Alkylen- (auch verzweigt oder zyklisch), Alkenylen-, Alkinylen-, Arylen-und Heteroarylen-Gruppen).

In einer weiteren Ausführungsform der Erfindung weist die Donorgruppe mit elektronenschiebenden Eigenschaften der Formel I eine Struktur der Formel III auf: 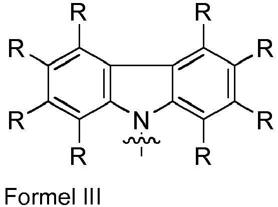 wobei
jedes R bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme, oder eine quervernetzbare Einheit QE ist, die durch säurekatalytische, basenkatalytische, thermische oder UV-Quervernetzungsverfahren in Anwesenheit oder Abwesenheit eines Photoinitiators oder durch Mikrowellenstrahlung quervernetzt werden kann; dabei können zwei oder mehrere dieser Substituenten R auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

Bei den quervernetzbaren Einheiten QE handelt es sich in einer Ausführungsform um eine Verbindung ausgewählt aus der Gruppe bestehend aus Oxetanen, Alkinen und Aziden für eine Clickreaktion sowie folgenden Alkenderivaten:

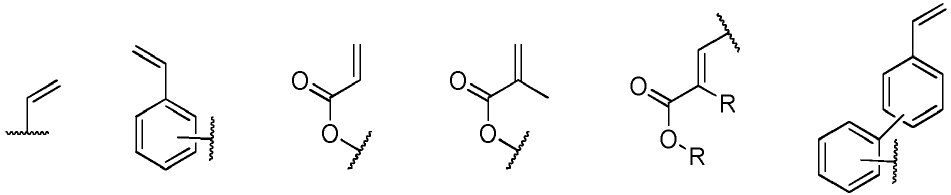

Beispiele für erfindungsgemäße Donoren

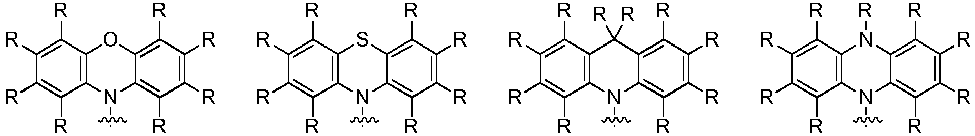

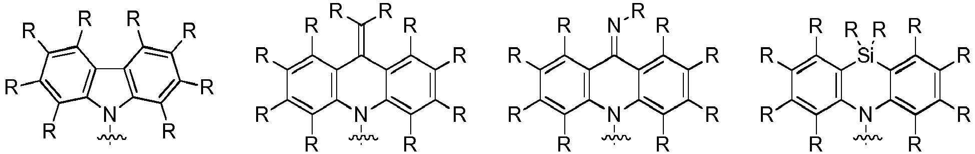

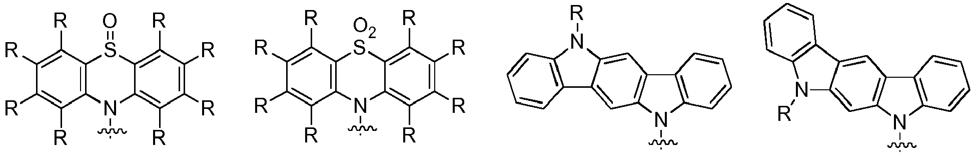

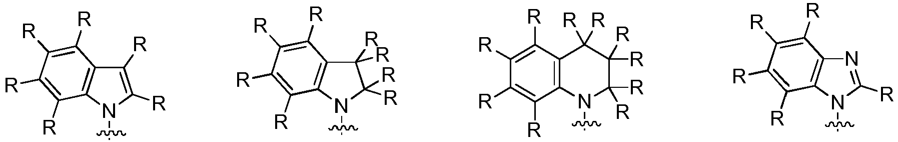

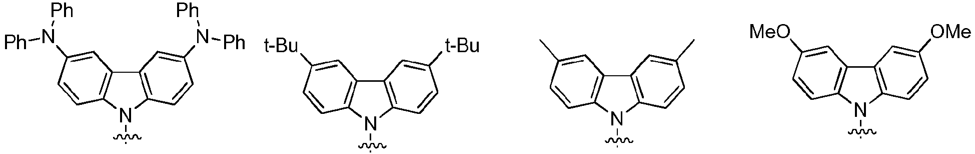

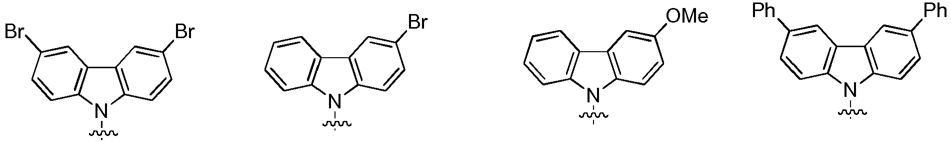

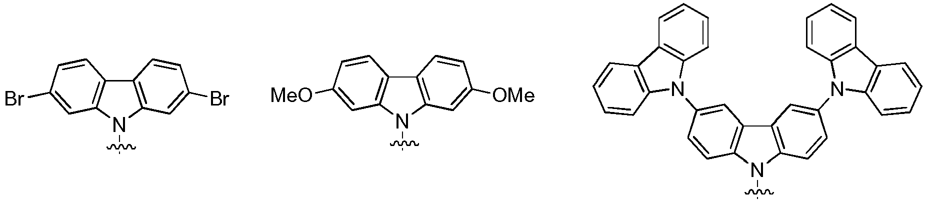

Beispiele für unterschiedliche Substitutionsmuster der Grundstruktur der Formel A:

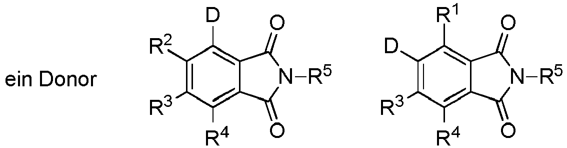

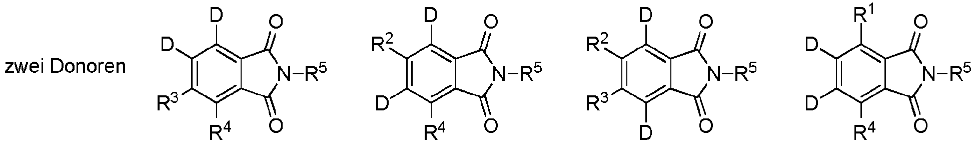

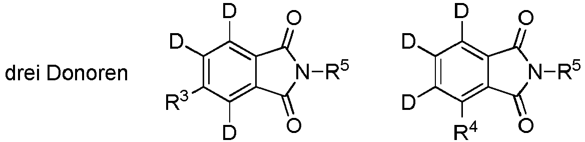

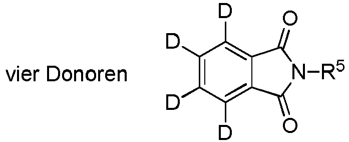

Die erfindungsgemäßen Moleküle sind in einer Ausführungsform mit ein, zwei oder vier Donoren D substituiert.

Die Beschreibung betrifft auch ein Verfahren zur Herstellung erfindungsgemäßer organischer Moleküle.

In einer Ausführungsform weist das Verfahren den Schritt einer nukleophilen aromatischen Substitution (S_{N}Ar) eines N-Nukleophils mit einer Verbindung, aufweisend eine Struktur der Formel A* 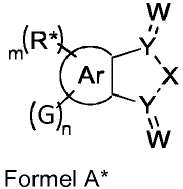
auf, wobei Ar = eine substituierte Aryl- oder Heteroarylgruppe mit 5 bis 40 aromatischen Ringatomen, die mit m gleichen oder verschiedenen Resten R* und mit n gleichen oder verschiedenen Gruppen G substituiert ist, wobei m + n gleich der Anzahl der substituierbaren Ringatome ist;
wobei G = Cl oder F
und im Übrigen die für Formel A angegebenen Definitionen gelten.

In einer Ausführungsform weist das erfindungsgemäße Verfahren die nukleophile aromatische Substitution (S_{N}Ar) eines N-Nukleophils mit einem Chlor oder Fluor-substituierten Phthalimids auf. Das Verfahren weist in einer anderen Ausführungsform zusätzlich die Synthese des Chlor/Fluor-substituierten Phthalimid durch Umsetzung des entsprechenden Anhydrids mit einem entsprechenden primären Amin auf.

In einer weiteren Ausführungsform weist das Verfahren zusätzlich den Schritt der Substitution mindestens einer der Ar-Gruppen und/oder der Donorgruppe mit elektronenschiebenden Eigenschaften mit mindestens einem Substituenten zur Erhöhung der Löslichkeit auf, der ausgewählt ist aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30 und
- kurzkettigen Polyethern mit einer Kettenlänge von 3 bis 50 Wiederholungseinheiten.

Das Verfahren weist in einer weiteren Ausführungsform zusätzlich den Schritt auf der Substitution mindestens einer der Ar-Gruppen und/oder der Donorgruppe mit elektronenschiebenden Eigenschaften und/oder des Restes R' der Formel C und/oder D mit mindestens einer quervernetzbaren Einheit auf, die durch säurekatalytische, basenkatalytische, thermische oder UV-Quervernetzungsverfahren in Anwesenheit oder Abwesenheit eines Photoinitiators oder durch Mikrowellenstrahlung quervernetzt werden kann, und die ausgewählt ist aus der Gruppe bestehend aus:
- Oxetanen, Aziden und Alkinen für eine Clickreaktion, sowie folgenden Alkenderivaten:

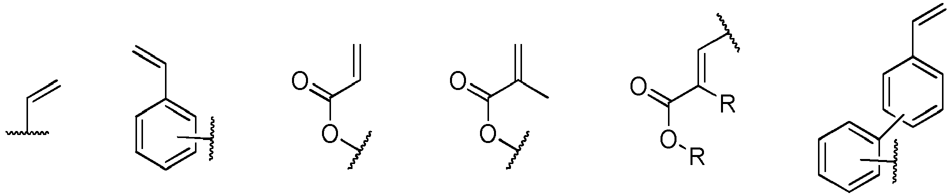

Die Beschreibung betrifft auch die Verwendung der erfindungsgemäßen Moleküle als Emitter oder Absorber in einem optoelektronischen Bauelement, das durch ein Vakuumverdampfungsverfahren oder aus Lösung hergestellt wird, wobei das optoelektronische Bauelement insbesondere ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- Organischen Solarzellen,
- Organischen Feldeffekttransistoren,
- Organischen Lasern und
- Down-Konversions-Elementen.

Gemäß zumindest einer Ausführungsform weist ein organisches Licht emittierendes Bauelement auf einem Substrat zumindest zwei Elektroden auf, von denen zumindest eine durchsichtig ist und zwischen denen ein organischer funktioneller Schichtenstapel angeordnet ist. Der organische funktionelle Schichtenstapel weist zumindest eine organische Licht emittierende Schicht in Form einer organischen elektrolumineszierenden Schicht auf, die im Betrieb des organischen Licht emittierenden Bauelements Licht erzeugt. Das organische Licht emittierende Bauelement kann insbesondere als organische Licht emittierende Diode (OLED) ausgebildet sein.
Mit "transluzent" wird hier und im Folgenden eine Schicht bezeichnet, die durchlässig für sichtbares Licht ist. Dabei kann die transluzente Schicht transparent, also klar durchscheinend, oder zumindest teilweise Licht streuend und/oder teilweise Licht absorbierend sein, so dass die transluzente Schicht beispielsweise auch diffus oder milchig durchscheinend sein kann. Besonders bevorzugt ist eine hier als transluzent bezeichnete Schicht möglichst transparent ausgebildet, so dass insbesondere die Absorption von Licht so gering wie möglich ist.
Der organische funktionelle Schichtstapel kann Schichten mit organischen Polymeren, organischen Oligomeren, organischen Monomeren, organischen kleinen, nicht-polymeren Molekülen ("small molecules") oder Kombinationen daraus aufweisen. Als Materialien für die organische Licht emittierende Schicht eignen sich Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Der organische funktionelle Schichtenstapel kann auch eine Mehrzahl von organischen Licht emittierenden Schichten aufweisen, die zwischen den Elektroden angeordnet sind. Der organische funktionelle Schichtenstapel kann weiterhin eine funktionelle Schicht aufweisen, die als Lochtransportschicht ausgeführt ist, um eine effektive Löcherinjektion in die zumindest eine Licht emittierende Schicht zu ermöglichen. Als Materialien für eine Lochtransportschicht können sich beispielsweise tertiäre Amine, Carbazolderivate, mit Camphersulfonsäure dotiertes Polyanilin oder mit Polystyrolsulfonsäure dotiertes Polyethylendioxythiophen als vorteilhaft erweisen. Der organische funktionelle Schichtenstapel kann weiterhin eine funktionelle Schicht aufweisen, die als Elektronentransportschicht ausgebildet ist. Darüber hinaus kann der Schichtenstapel auch Elektronen- und/oder Löcherblockierschichten aufweisen.
Das Substrat (fester Träger) kann beispielsweise eines oder mehrere Materialien in Form einer Schicht, einer Platte, einer Folie oder einem Laminat aufweisen, die ausgewählt sind aus Glas, Quarz, Kunststoff, Metall, Siliziumwafer. Besonders bevorzugt weist das Substrat Glas, beispielsweise in Form einer Glasschicht, Glasfolie oder Glasplatte, auf oder ist daraus.
Im Hinblick auf den prinzipiellen Aufbau eines organischen Licht emittierenden Bauelements, dabei beispielsweise im Hinblick auf den Aufbau, die Schichtzusammensetzung und die Materialien des organischen funktionellen Schichtenstapels, wird auf die Druckschrift WO 2010/066245 A1 verwiesen, die insbesondere in Bezug auf den Aufbau eines organischen Licht emittierenden Bauelements hiermit ausdrücklich durch Rückbezug aufgenommen wird.
Die zwei Elektroden, zwischen denen der organische funktionelle Schichtenstapel angeordnet ist, können beispielsweise beide transluzent ausgebildet sein, sodass das in der zumindest einen Licht emittierenden Schicht zwischen den beiden Elektroden erzeugte Licht in beide Richtungen, also in Richtung des Substrats als auch in die vom Substrat abgewandte Richtung, abgestrahlt werden können. Weiterhin können beispielsweise alle Schichten des organischen Licht emittierenden Bauelements transluzent ausgebildet sein, sodass das organische Licht emittierende Bauelement eine transluzente und insbesondere eine transparente OLED bildet. Darüber hinaus kann es auch möglich sein, dass eine der beiden Elektroden, zwischen denen der organische funktionelle Schichtenstapel angeordnet ist, nicht-transluzent und vorzugsweise reflektierend ausgebildet ist, sodass das in der zumindest einen Licht emittierenden Schicht zwischen den beiden Elektroden erzeugte Licht nur in eine Richtung durch die transluzente Elektrode abgestrahlt werden kann. Ist die auf dem Substrat angeordnete Elektrode transluzent und ist auch das Substrat transluzent ausgebildet, so spricht man auch von einem so genannten "bottom emitter", während man im Fall, dass die dem Substrat abgewandt angeordnete Elektrode transluzent ausgebildet ist, von einem so genannten "top emitter" spricht.
Gemäß einer weiteren Ausführungsform weist die transluzente Elektrode ein transparentes leitendes Oxid auf oder besteht aus einem transparenten leitenden Oxid. Transparente leitende Oxide (TCO: "transparent conductive oxide") sind transparente, leitende Materialien, in der Regel Metalloxide, wie beispielsweise Zinkoxid, Zinnoxid, Cadmiumoxid, Titanoxid, Indiumoxid, Indiumzinnoxid (ITO) oder Aluminiumzinkoxid (AZO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O4, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Weiterhin kann die transluzente Elektrode eine Metallschicht mit einem Metall oder einer Legierung aufweisen, beispielsweise mit einem oder mehreren der folgenden Materialien: Ag, Pt, Au, Mg, Ag:Mg. Weiterhin sind auch andere Metalle möglich. Besonders bevorzugt werden ein oder mehrere Metalle verwendet, die stabil an Luft sind und/oder die selbstpassivierend, beispielsweise durch Ausbildung einer dünnen schützenden Oxidschicht, sind. Die Metallschicht weist dabei eine derart geringe Dicke auf, dass sie zumindest teilweise durchlässig für das von der zumindest einen organischen Licht emittierenden Schicht im Betrieb erzeugte Licht ist, beispielsweise eine Dicke von kleiner oder gleich 50 nm.
Die transluzente Elektrode kann auch eine Kombination aus zumindest einer oder mehreren TCO-Schichten und zumindest einer transluzenten Metallschicht aufweisen.
Die Elektroden können jeweils großflächig ausgebildet sein. Dadurch kann eine großflächige Abstrahlung des in der zumindest einen organischen Licht emittierenden Schicht erzeugten Lichts ermöglicht werden. "Großflächig" kann dabei bedeuten, dass das organische Licht emittierende Bauelement eine Fläche von grösser oder gleich einigen Quadratmillimetern, bevorzugt grösser oder gleich einem Quadratzentimeter und besonders bevorzugt grösser oder gleich einem Quadratdezimeter aufweist.
Gemäß einer weiteren Ausführungsform weist der organische funktionelle Schichtenstapel unmittelbar angrenzend an beide der zwei Elektroden, zwischen denen der organische funktionelle Schichtenstapel angeordnet ist, jeweils eine ladungserzeugende Schicht auf. In diesem Fall grenzt eine Elektronen leitende Schicht zur als Anode ausgebildeten Elektrode und eine Löcher leitende Schicht zur als Kathode ausgebildeten Elektrode hin an. Der organische funktionelle Schichtenstapel mit den beiden Elektroden bildet in diesem Fall eine so genannte invertierte OLED, bei der die Injektion der entsprechenden Ladungsträgersorte jeweils durch den oben beschriebenen inversen Prozess ersetzt wird.
Gemäß einer weiteren Ausführungsform weist der organische funktionelle Schichtenstapel zwischen den Elektroden zumindest zwei organische Licht emittierende Schichten auf, zwischen denen weiterhin eine weitere ladungserzeugende Schicht angeordnet sein kann. Ein solcher organischer funktioneller Schichtenstapel mit den Elektroden kann auch als so genannte gestapelte OLED bezeichnet werden, bei der mehrere organische OLED-Einheiten durch dazwischen angeordnete ladungserzeugende Schichten vertikal übereinander aufgebracht sind. Durch das Übereinanderstapeln mehrerer organischer Licht emittierender Schichten kann zum einen die Erzeugung von Mischlicht ermöglicht werden. Darüber hinaus können in mehrfach gestapelten OLEDs bei praktisch gleicher Effizienz und identischer Leuchtdichte deutlich längere Lebensdauern gegenüber OLEDs mit nur einer Licht emittierender Schicht erzielt werden, da bei gleichen Stromdichten die mehrfache Leuchtdichte ermöglicht werden kann.
Gemäß einer weiteren Ausführungsform sind über den zwei Elektroden mit dem dazwischen angeordneten organischen funktionellen Schichtenstapel und der zumindest einen ladungserzeugenden Schicht ein weiterer organischer funktioneller Schichtenstapel und darüber eine weitere Elektrode angeordnet. Mit anderen Worten weist das organische Licht emittierende Bauelement zumindest drei Elektroden auf, wobei zwischen jeweils benachbarten Elektroden ein organischer funktioneller Schichtenstapel angeordnet ist. Hierdurch ist die zwischen dem organischen funktionellen Schichtenstapel und dem weiteren organischen funktionellen Schichtenstapel angeordnete Elektrode als so genannte Zwischenelektrode ausgeführt, die beispielsweise zur Steuerung der Emissionsfarbe des organischen Licht emittierenden Bauelements im Falle von unterschiedlichen Licht emittierenden Schichten in den organischen funktionellen Schichtenstapeln direkt angesteuert werden kann. Insbesondere kann der weitere organische funktionelle Schichtenstapel unmittelbar angrenzend an zumindest eine der beiden Elektroden, zwischen denen der weitere organische funktionelle Schichtenstapel angeordnet ist, eine weitere ladungserzeugende Schicht aufweisen.
Gemäß einer weiteren Ausführungsform weist das organische Licht emittierende Bauelement unmittelbar angrenzend an jede Elektrode auf der zu einer organischen Licht emittierenden Schicht zugewandten Seite eine ladungserzeugende Schicht auf.
Beispielsweise kann die ladungserzeugende Schicht als Löcher leitende Schicht eine p-dotierte Schicht aufweisen, die einen anorganischen oder organischen Dotierstoff in einer organischen Löcher leitenden Matrix aufweist. Als anorganischer Dotierstoff kommen beispielsweise Übergangsmetalloxide wie etwa Vanadiumoxid, Molybdänoxid oder Wolframoxid in Frage. Als organische Dotierstoffe kommen beispielsweise Tetrafluorotetracyanoquinodimethan (F4-TCNQ) oder Kupfer-Pentafluorobenzoat (Cu(I)pFBz) in Frage. Weiterhin kommen als organische Dotierstoffe beispielsweise Übergangsmetallkomplexe in Frage. Diese können bevorzugt ein Zentralatom, beispielsweise Cu, mit Liganden aufweisen, beispielsweise Acetylacetonat (acac). Weiterhin kommen beispielsweise Kupferkomplexe, beispielsweise Kupfer-Carboxylate, in Frage. Derartige und weitere Dotierstoffe sind in den Druckschriften WO 2011/033023 A1 und WO 2011/120709 A1 beschrieben, deren jeweiliger Offenbarungsgehalt hiermit in Bezug auf die dort beschriebenen Dotierstoffe vollumfänglich durch Rückbezug aufgenommen wird.
Weiterhin kommen beispielsweise auch Metallkomplexe mit Bismut und/oder Chrom in Frage, wie in DE 10 2012 209 523 A1 und DE 10 2012 209 520 A1 beschrieben ist, deren jeweiliger Offenbarungsgehalt hiermit in Bezug auf die dort beschriebenen Dotierstoffe vollumfänglich durch Rückbezug aufgenommen wird.
Als Elektronen leitende Schicht kann die ladungserzeugende Schicht beispielsweise eine n-dotierte Schicht mit einem n-Dotierstoff in einer organischen Elektronen leitenden Matrix aufweisen, beispielsweise ein Metall mit niedriger Austrittsarbeit wie beispielsweise Cs, Li, Ca, Na, Ba oder Mg oder Verbindungen daraus, beispielsweise Cs₂CO₃ oder CS₃PO₄. Derartige und weitere Dotierstoffe sind beispielsweise in der Druckschrift WO 2011/039323 A2 beschrieben, deren jeweiliger Offenbarungsgehalt hiermit in Bezug auf die dort beschriebenen Dotierstoffe vollumfänglich durch Rückbezug aufgenommen wird.
Weiterhin sind auch organische p- und n-Dotierstoffe erhältlich unter den Markennamen NDP-2®, NDP-9®, NDN-1®, NDN-26® (Novaled GmbH).
Über den Elektroden und den organischen Schichten kann weiterhin noch eine Verkapselungsanordnung angeordnet sein. Die Verkapselungsanordnung kann beispielsweise in Form eines Glasdeckels oder, bevorzugt, in Form einer Dünnschichtverkapselung ausgeführt sein.
Ein Glasdeckel, beispielsweise in Form eines Glassubstrats, das eine Kavität aufweisen kann, kann mittels einer Klebstoffschicht oder eines Glaslots auf dem Substrat aufgeklebt beziehungsweise mit dem Substrat verschmolzen werden. In die Kavität kann weiterhin ein Feuchtigkeit-absorbierender Stoff (Getter), beispielsweise aus Zeolith, eingeklebt werden, um Feuchtigkeit oder Sauerstoff, die durch den Klebstoff eindringen können, zu binden. Weiterhin kann auch ein Klebstoff, der ein Getter-Material enthält, zur Befestigung des Deckels auf dem Substrat verwendet werden.
Unter einer als Dünnschichtverkapselung ausgebildeten Verkapselungsanordnung wird vorliegend eine Vorrichtung verstanden, die dazu geeignet ist, eine Barriere gegenüber atmosphärischen Stoffen, insbesondere gegenüber Feuchtigkeit und Sauerstoff und/oder gegenüber weiteren schädigenden Substanzen wie etwa korrosiven Gasen, beispielsweise Schwefelwasserstoff, zu bilden. Die Verkapselungsanordnung kann hierzu eine oder mehrere Schichten mit jeweils einer Dicke von kleiner oder gleich einigen 100 nm aufweisen.
Insbesondere kann die Dünnschichtverkapselung dünne Schichten aufweisen oder aus diesen bestehen, die beispielsweise mittels eines Atomlagenabscheideverfahrens ("atomic layer deposition", ALD) aufgebracht werden. Geeignete Materialien für die Schichten der Verkapselungsanordnung sind beispielsweise Aluminiumoxid, Zinkoxid, Zirkoniumoxid, Titanoxid, Hafniumoxid, Lanthanoxid, Tantaloxid. Bevorzugt weist die Verkapselungsanordnung eine Schichtenfolge mit einer Mehrzahl der dünnen Schichten auf, die jeweils eine Dicke zwischen einer Atomlage und 10 nm aufweisen, wobei die Grenzen eingeschlossen sind.
Dünnfilmverkapselungen sind beispielsweise aus den Druckschriften WO 2009/095006 A1 und WO 2010/108894 A1 bekannt, deren jeweiliger Offenbarungsgehalt hiermit diesbezüglich vollumfänglich durch Rückbezug aufgenommen wird.
Bei dem hier beschriebenen organischen Licht emittierenden Bauelement, das beispielsweise als Beleuchtungseinrichtung in Form einer OLED-Leuchte ausgeführt sein kann, wird mit Vorteil die Ladungsträgerinjektion in den organischen funktionellen Schichtenstapel zumindest an einer Elektrode, insbesondere an der transluzenten Elektrode, durch den oben beschriebenen inversen Prozess ersetzt. Dadurch kann eine Verringerung des Spannungsabfalls an solchen Grenzflächen erreicht werden. Als Folge hiervon kann ein transparentes leitendes Oxid wie beispielsweise ITO oder AZO als Material für die transluzente Elektrode, allein oder in Kombination mit einem Metall wie beispielsweise Ag, verwendet werden. Insbesondere kann die transluzente Elektrode auch die dem Substrat abgewandte so genannte Deckelektrode bilden. Hierdurch lassen sich OLEDs mit sehr hohen Transparenzwerten realisieren, wodurch auch eine Steigerung der Effizienz eines solchen transparenten Bauelements ermöglicht werden kann. Dadurch kann sich auch ein positiver Einfluss auf die Lebensdauer des organischen Licht emittierenden Bauelements ergeben und es besteht die Möglichkeit, neuartige OLED-Bauelemente zu realisieren.

In einer Ausführungsform beträgt dabei der Anteil des Organischen Moleküls am Emitter oder Absorber 1 % bis 99 %, bevorzugt beträgt der Anteil des Organischen Moleküls als Emitter in organischen Licht emittierenden Bauelementen, insbesondere in OLEDs, zwischen 5 % und 80 %. In einer alternativen Ausführungsform der Anteil des Organischen Moleküls am Emitter oder Absorber 100 %.

Die Beschreibung betrifft auch ein optoelektronisches Bauelement, aufweisend ein erfindungsgemäßes organisches Molekül, wobei das optoelektronische Bauelement insbesondere ausgeformt ist als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

In einer Ausführungsform des optoelektronischen Bauelements ist die erfindungsgemäße Verbindung als Emissionsmaterial in einer lichtemittierenden Schicht eingesetzt ist, wobei sie entweder als Reinschicht oder in Kombination mit einem Matrixmaterial eingesetzt ist.

Der Anteil des erfindungsgemäßen organischen Moleküls als Emissionsmaterial beträgt in einer weiteren Ausführungsform in einer lichtemittierenden Schicht in optischen Licht emittierenden Bauelementen, insbesondere in OLEDs, zwischen 5 % und 80 %. In einer Ausführungsform des optoelektronischen Bauelements ist die lichtemittierende Schicht auf ein Substrat aufgebracht, wobei bevorzugt eine Anode und eine Kathode auf das Substrat aufgebracht sind und die lichtemittierende Schicht zwischen Anode und Kathode aufgebracht ist.

Die lichtemittierende Schicht kann ausschließlich ein erfindungsgemäßes organisches Molekül in 100 % Konzentration aufweisen, wobei die Anode und die Kathode auf das Substrat aufgebracht ist, und die lichtemittierende Schicht zwischen Anode und Kathode aufgebracht ist.

In einer Ausführungsform weist die lichtemittierende Schicht neben dem erfindungsgemäßen organischen Molekül ein Hostmaterial auf, dessen Triplett (T1)- und Singulett (S1)-Energieniveaus energetisch höher liegen als die Triplett (T1)- und Singulett (S1)-Energieniveaus des organischen Moleküls.

In einer Ausführungsform des optoelektronischen Bauelements sind eine löcher- und elektroneninjizierende Schicht zwischen Anode und Kathode, und eine löcher- und elektronentransportierende Schicht zwischen löcher- und elektroneninjizierende Schicht, und die lichtemittierende Schicht zwischen löcher- und elektronentransportierende Schicht aufgebracht.

Das optoelektronische Bauelement weist in einer weiteren Ausführungsform auf: ein Substrat, eine Anode, eine Kathode und mindestens je eine löcher- und elektroneninjizierende Schicht, und mindestens je eine löcher- und elektronentransportierende Schicht, und mindestens eine lichtemittierende Schicht, die erfindungsgemäßes organisches Molekül und ein Hostmaterial aufweist, dessen Triplett (T1)- und Singulett (S1)-Energieniveaus energetisch höher liegen als die Triplett (T1)-und Singulett (S1)-Energieniveaus des organischen Moleküls, auf, wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

Beschrieben ist auch ein lichtemittierendes Material, aufweisend ein erfindungsgemäßes organisches Molekül und ein Hostmaterial, wobei die Triplett (T1)- und Singulett (S1)-Energieniveaus des Hostmaterials energetisch höher liegen als die Triplett (T1)- und Singulett (S1)-Energieniveaus des organischen Moleküls, und wobei das lichtemittierende Material Fluoreszenz oder thermisch aktivierte verzögerte Fluoreszenz emittiert, und einen deltaE(S1-T1)-Wert zwischen dem untersten angeregten Singulett (S1)- und dem darunter liegenden Triplett (T1)-Zustand von kleiner als 3000 cm⁻¹ aufweist.

Die Beschreibung betrifft auch ein Verfahren zur Herstellung eines optoelektronischen Bauelements, wobei ein erfindungsgemäßes organisches Molekül verwendet wird.

In einer Ausführungsform dieses Verfahrens wird das erfindungsgemäße organische Molekül auf einen Träger aufgebracht, wobei das Aufbringen insbesondere nasschemisch, mittels kolloidaler Suspension oder mittels Sublimation erfolgt.

Beschrieben ist auch ein Verfahren zur Herstellung eines optoelektronischen Bauelements, bei dem mindestens eine Schicht des optoelektronischen Bauelements
- mit einem Sublimationsverfahren beschichtet werden,
- mit einem OVPD (Organic Vapour Phase Deposition) Verfahren beschichtet werden,
- mit einer Trägergassublimation beschichtet werden, und/oder
- aus Lösung oder mit einem Druckverfahren hergestellt werden.

Die Beschreibung betrifft ebenfalls ein Verfahren zur Veränderung der Emissions- und/oder Absorptionseigenschaften eines elektronischen Bauelements, gekennzeichnet durch Einbringen eines erfindungsgemäßen organischen Moleküls in ein Matrixmaterial zur Leitung von Elektronen oder Löchern in einem optoelektronischen Bauelement.

Zudem betrifft die Beschreibung auch die Verwendung eines Organischen Moleküls nach Anspruch 1 bis 9, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

### Beispiele

Bei der in den Beispielen angegebenen verzögerten Lebensdauer handelt es sich um die langlebige Komponente der Exzitonenabklingzeit (= ohne spontane Fluoreszenz). Die angegebenen Werte stellen dabei die gewichteten Mittelwerte bi- bzw. triexponentieller Fits dar.

### Beispiel 1

### Stufe 1:

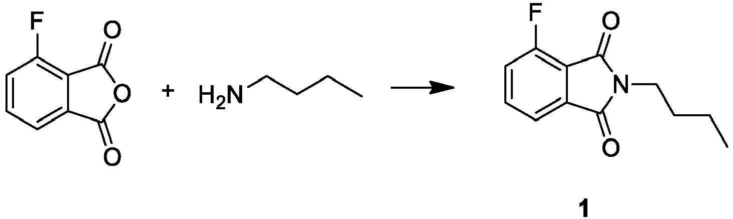

In einem 50 mL Rundkolben mit Rückflusskühler werden 3-Fluorphtalsäureanhydrid (3.32 g, 20 mmol) in 20 mL Eisessig suspendiert. Nach Zugabe von von 1-Butylamin (2.17 mL, 22 mmol) wird zunächst für eine Stunde bei 90 °C, dann eine weitere Stunde bei 100 °C gerührt. Nach abkühlen wird die Reaktionslösung auf 150 mL ges. Na₂CO₃-Lösung geschüttet und mit 2x75 mL EtOAc extrahiert. Die vereinigten organischen Phasen werden über MgSO₄ getrocknet. Das Lösungsmittel wird am Rotationsverdampfer entfernt. Nach Trocknen am Hochvakuum wird das Produkt **1** (3.9 g, 17.6 mmol, 88%) als leicht gelbes Öl erhalten.
¹H-NMR (500 MHz, CDCl₃): δ = 7.72 - 7.66 (m, 1H), 7.65-7.60 (m, 1H), 7.34 (td, *J* = 8.5, 1.7 Hz, 1H), 3.64 (td, *J* = 7.4, 3.1 Hz, 2H), 1.67 - 1.58 (m, 2H), 1.38-1.27 (m, 2H), 0.91 (td, *J* = 7.4, 3.0 Hz, 3H). ¹⁹F NMR (471 MHz, CDCl₃): δ = -113.2.

### Stufe 2:

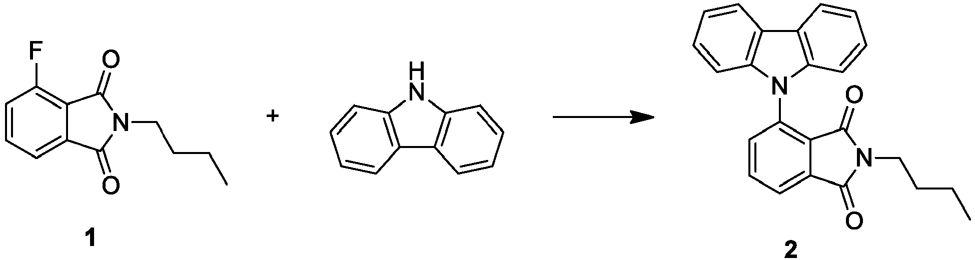

In einem 50 mL Rundkolben werden Imid **1** (1.55 g, 7 mmol), Carbazol (1.17 g, 7 mmol) und K₃PO₄ (2.97 g, 14 mmol) vorgelegt und für 5 min evakuiert. Nach besticken werden 15 mL DMSO (trocken) zugegeben und für 3 h bei 100 °C erhitzt. Die Reaktionslösung wird auf 200 mL Wasser geschüttet und mit 200 mL EtOAc extrahiert, Nach erneuter Extraktion mit 100 mL EtOAc werden die vereinigten organischen Phasen 2x mit je 50 mL Wasser und mit ges. NaCI-Lösung gewaschen. Anschließend wird über MgSO₄ getrocknet und das Lösemittel am Rotationsverdampfer entfernt. Rekristallisation aus EtOH liefert das Produkt **2** (1.21 g, 47%) als leicht gelben Feststoff. Das Produkt kann durch Sublimation weiter aufgereinigt werden.
¹H NMR (500 MHz, CDCl₃): δ = 8.16 (d, *J* = 7.9 Hz, 2H), 7.98 (dd, *J* = 7.2, 1.0 Hz, 1H), 7.91 (t, *J* = 7.6 Hz, 1H), 7.85 (dd, *J* = 8.0, 1.0 Hz, 1H), 7.42 - 7.37 (m, 2H), 7.32 (t, *J* = 7.5 Hz, 2H), 7.16 (d, *J* = 8.1 Hz, 2H), 3.62 (t, *J* = 7.3 Hz, 2H), 1.63 - 1.54 (m, 2H), 1.30 (h, *J* = 7.4 Hz, 2H), 0.89 (t, *J* = 7.3 Hz, 3H). ¹³C NMR (126 MHz, CDCl₃): δ = 167.8, 165.7, 140.7, 135.6, 134.8, 134.4, 134.4, 127.0, 126.1, 124.0, 122.6, 120.8, 120.7, 110.0, 38.1, 30.6, 20.2, 13.7.

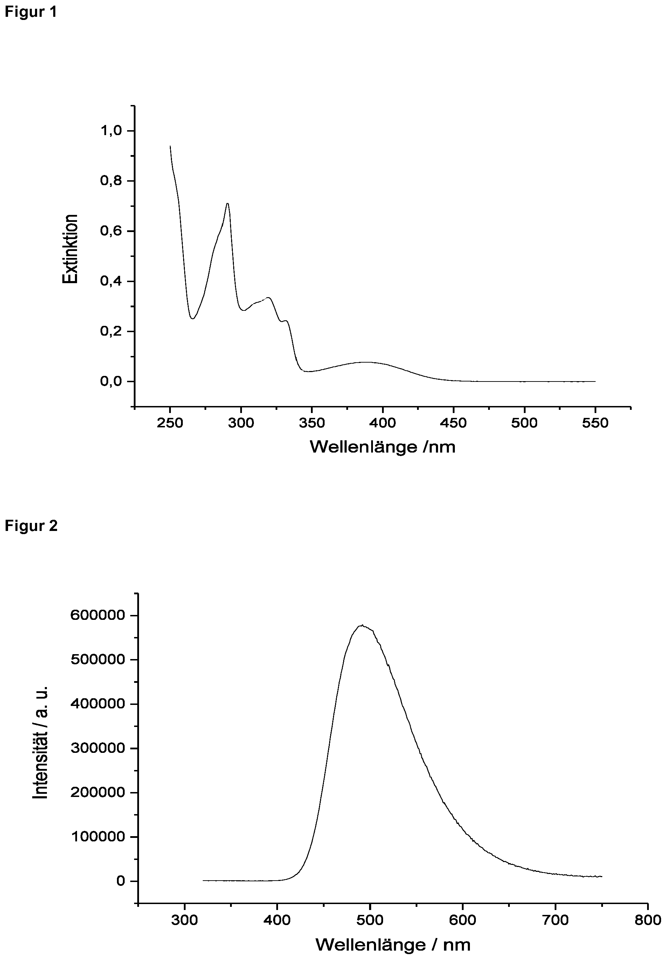

Das Absorptionsspektrum von **2** in Dichlormethan ist in Figur 1 gezeigt.
Die Filmemission von **2** (10 % in PMMA) ist Figur 2 zu entnehmen.

Nach obiger Synthesevorschrift wurden folgende weitere Beispiele hergestellt:

### Beispiel 2

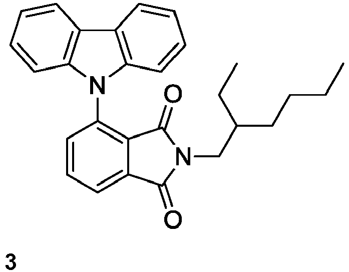

¹H NMR (500 MHz, CDCl₃): δ = 8.16 (d, J = 7.7 Hz, 2H), 7.98 (d, J = 7.2 Hz, 1H), 7.91 (t, J = 7,6 Hz, 1H), 7.85 (d, J = 8.0 Hz, 2H), 7.39 (t, J = 7.7 Hz, 2H), 7.32 (t, J = 7.4 Hz, 2H), 7.17 (d, J = 8.1 Hz, 2H), 3.52 (d, J = 7.3 Hz, 2H), 1.78 (hept, J = 6.3 Hz, 1H), 1.35 - 1.16 (m, 8H), 0.89-0.82 (m, 6H).
¹³C NMR (126 MHz, CDCl₃): δ = 168.0, 165.9, 140.7, 135.6, 134.7, 134.4, 126.9, 126.1, 124.1, 122.6, 120.9, 120.7, 110.1, 42.2, 38.2, 30.6, 28.6, 23.9, 23.1, 14.2.

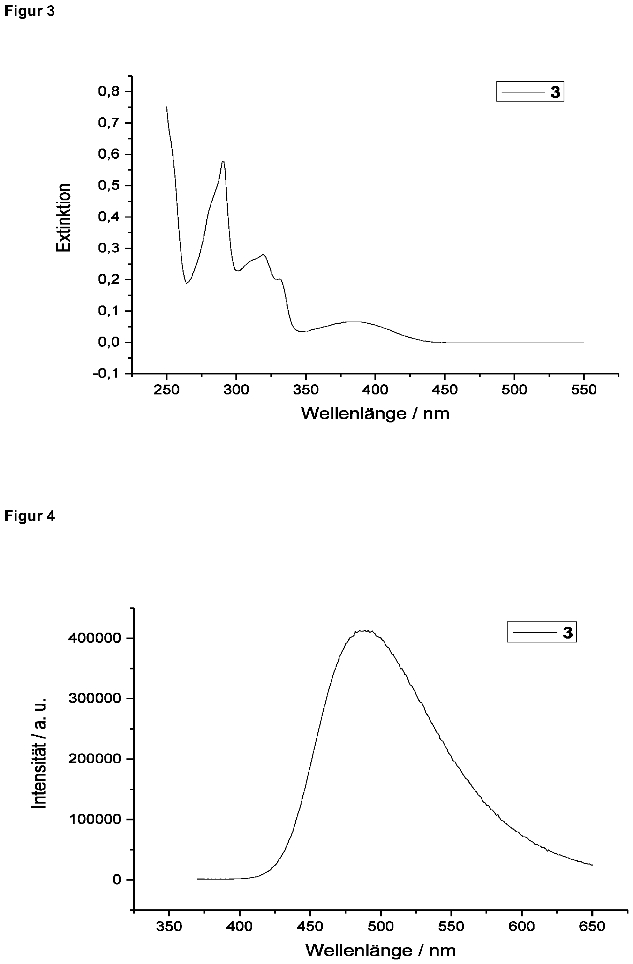

Das Absorptionsspektrum von **3** in Dichlormethan ist in Figur 3 gezeigt.
Die Filmemission von **3** (10 % in PMMA) ist Figur 4 zu entnehmen.

### Beispiel 3

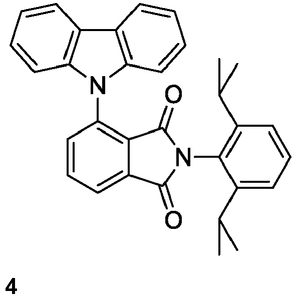

¹H NMR (500 MHz, CDCl₃): δ = 8.13 (d, J = 7.7 Hz, 2H), 8.10 (dd, J = 4.7, 3.6 Hz, 1H), 8.03 - 8.00 (m, 2H), 7.42 - 7.35 (m, 3H), 7.30 (td, J = 7.4, 1.0 Hz, 2H), 7.28-7.25 (m, 2H), 7.23 (d, J = 7.8 Hz, 2H), 2.76 (hept, J = 6.9 Hz, 2H), 1.21 (d, J = 6.8 Hz, 6H), 1.12 (d, J = 6.8 Hz, 6H).
¹³C NMR (126 MHz, CDCl₃): δ = 167.5, 165.3, 147.3, 140.4, 136.0, 134.9, 134.5, 134.3, 130.3, 126.8, 126.1, 126.0, 124.2, 124.0, 123.0, 121.0, 120.7, 110.2, 29.6, 24.2.

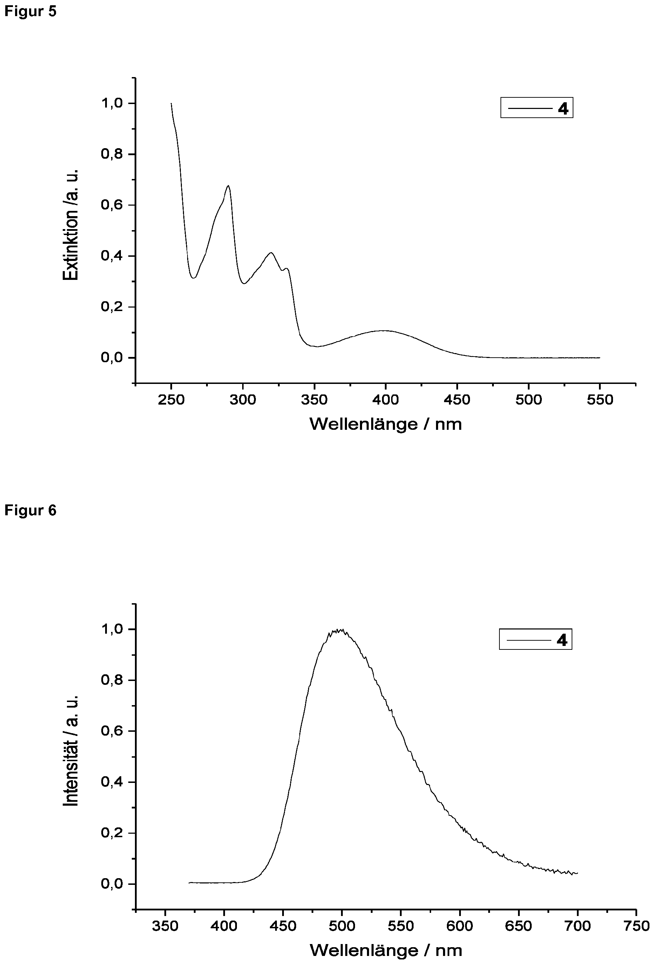

Das Absorptionsspektrum von **4** in Dichlormethan ist in Figur 5 gezeigt.
Die Filmemission von **4** (10 % in PMMA) ist Figur 6 zu entnehmen.
Die Photolumineszenzquantenausbeute von **4** (10% in PMMA) beträgt 48%. Die verzögerte Lebensdauer von **4** (10% in PMMA) beträgt 6,2 µs.

### Beispiel 4

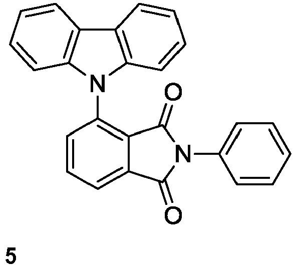

¹H NMR (500 MHz, CDCl₃): δ = 8.15 (dt, J = 7.7, 0.9 Hz, 2H), 8.11 (dd, J = 7.3, 1.0 Hz, 1H), 8.00 (t, J = 7.6 Hz, 1H), 7.94 (dd, J = 8.1, 1.0 Hz, 1H), 7.45 - 7.37 (m, 6H), 7.36 - 7.29 (m, 3H), 7.21 (dt, J = 8.2, 0.9 Hz, 2H).
¹³C NMR (126 MHz, CDCl₃): δ = 166.6, 164.4, 140.8, 136.1, 135.1, 135.0, 134.4, 131.5, 129.1, 128.2, 126.7, 126.5, 126.2, 124.1, 123.3, 120.9, 120.7, 110.0.

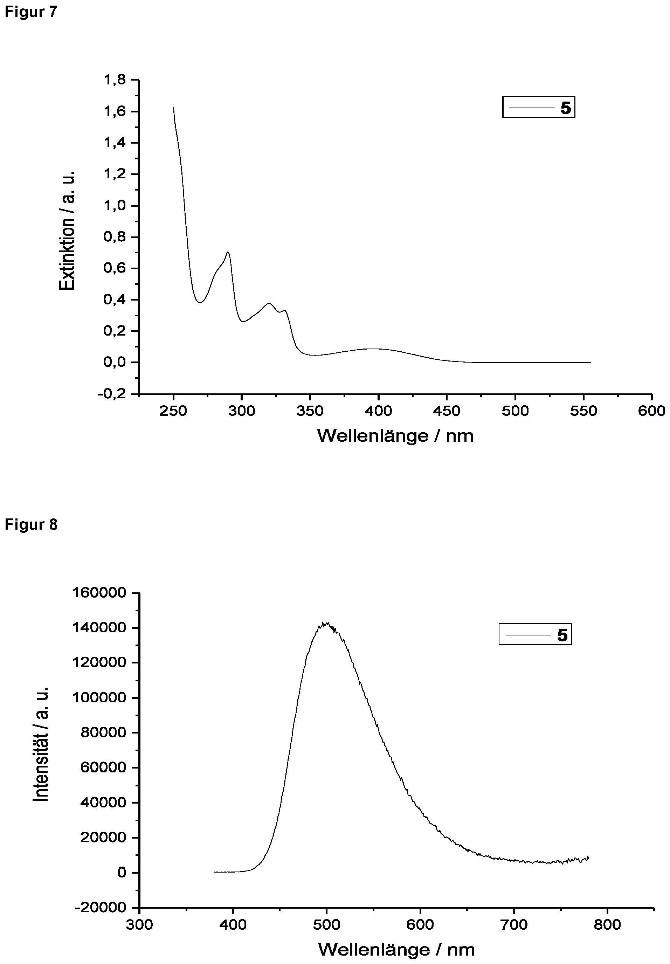

Das Absorptionsspektrum von **5** in Dichlormethan ist in Figur 7 gezeigt.
Die Filmemission von **5** (10 % in PMMA) ist Figur 8 zu entnehmen.

### Beispiel 5

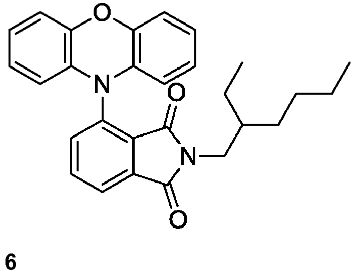

¹H NMR (500 MHz, CDCl₃): δ = 7.96 (dd, J = 7.5, 1.2 Hz, 1H), 7.93 (t, J = 7.5 Hz, 1H), 7.70 (dd, J = 7.6, 1.2 Hz, 1H), 6.74 (dd, J = 8.0, 1.5 Hz, 2H), 6.68 (t, J = 8.0 Hz, 2H), 6.57 (td, J = 7.7, 1.5 Hz, 2H), 5.83 (d, J = 7.9 Hz, 2H), 3.50 (d, J = 7.3 Hz, 2H), 1.76 (hept, J = 6.3 Hz, 1H), 1.33 - 1.09 (m, 8H), 0.87-0.79 (m, 6H).
¹³C NMR (126 MHz, CDCl₃): δ = 167.9, 165.7, 144.1, 138.4, 136.7, 135.7, 133.2, 123.5, 123.2, 122.2, 116.1, 112.9, 42.2, 38.2, 30.6, 28.5, 24.0, 23.1, 14.1, 10.6.

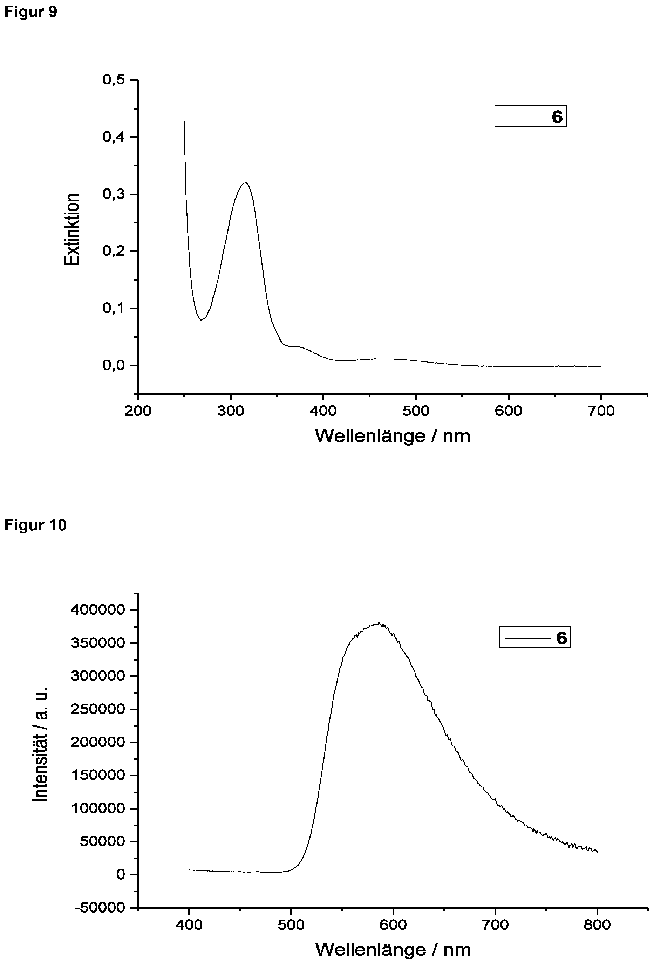

Das Absorptionsspektrum von **6** in Dichlormethan ist in Figur 9 gezeigt.
Die Filmemission von **6** (10 % in PMMA) ist Figur 10 zu entnehmen.

### Beispiel 6

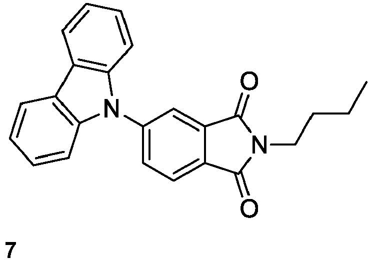

¹H NMR (500 MHz, CDCl₃): δ = 8.15 (d, J = 7.7 Hz, 2H), 8.09 (d, J = 1.8 Hz, 1H), 8.06 (d, J = 7.9 Hz, 1H), 7.93 (dd, J = 7.9, 1.8 Hz, 1H), 7.48 (dt, J = 8.3, 1.1 Hz, 2H), 7.44 (ddd, J = 8.2, 6.7, 1.2 Hz, 2H), 7.34 (ddd, J = 8.0, 6.7, 1.4 Hz, 2H), 3.75 (t, J = 7.3 Hz, 2H), 1.77 - 1.68 (m, 2H), 1.48 - 1.37 (m, 2H), 0.99 (t, J = 7.4 Hz, 3H).
¹³C NMR (126 MHz, CDCl₃): δ = 167.8, 167.7, 143.5, 140.1, 134.5, 131.5, 129.9, 126.6, 125.0, 124.2, 121.2, 121.2, 120.7, 109.7, 38.2, 30.8, 20.2, 13.8.

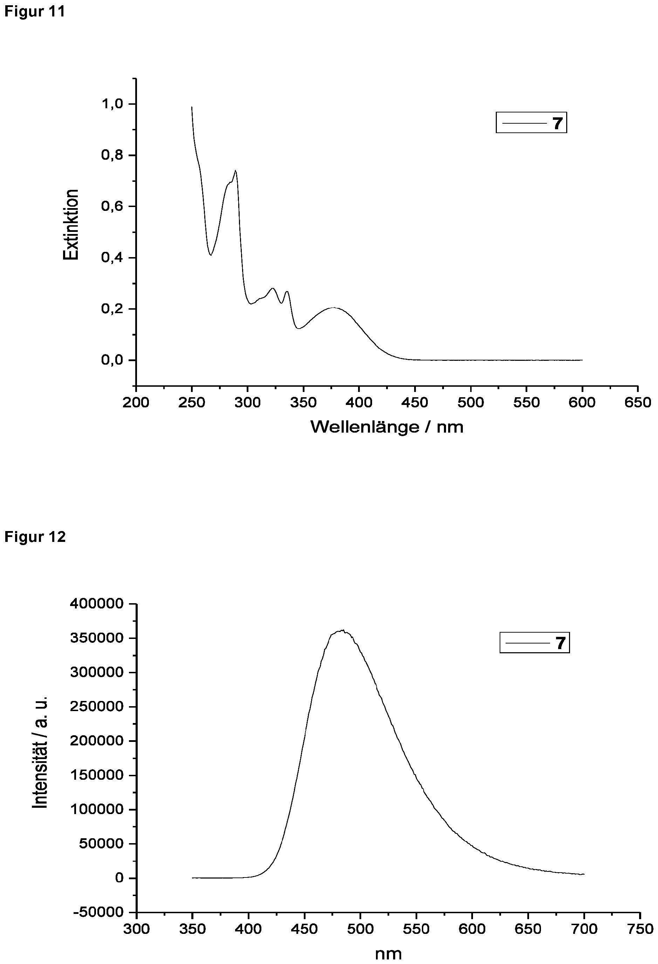

Das Absorptionsspektrum von **7** in Dichlormethan ist in Figur 11 gezeigt.
Die Filmemission von **7** (10 % in PMMA) ist Figur 12 zu entnehmen.

### Beispiel 7

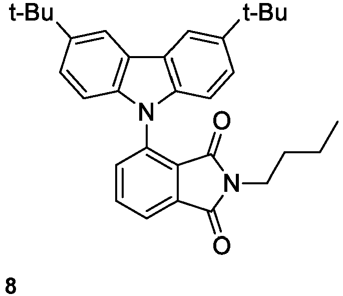

¹H NMR (500 MHz, CDCl₃): δ = 8.15 (d, J = 1.8 Hz, 2H), 7.94 (dd, J = 7.2, 1.0 Hz, 1H), 7.86 (t, J = 7.6 Hz, 1H), 7.80 (dd, J = 8.0, 1.1 Hz, 1H), 7.43 (dd, J = 8.6, 1.9 Hz, 2H), 7.08 (d, J = 8.6 Hz, 2H), 3.65 (t, J = 7.3 Hz, 2H), 1.66 - 1.56 (m, 2H), 1.46 (s, 18H), 1.38 - 1.26 (m, 2H), 0.90 (t, J = 7.4 Hz, 3H).
¹³C NMR (126 MHz, CDCl₃): δ = 167.9, 165.8, 143.7, 139.2, 135.4, 135.1, 134.7, 134.2, 126.6, 124.2, 123.7, 122.2, 116.7, 109.6, 38.1, 34.9, 32.1, 30.6, 20.2, 13.8.

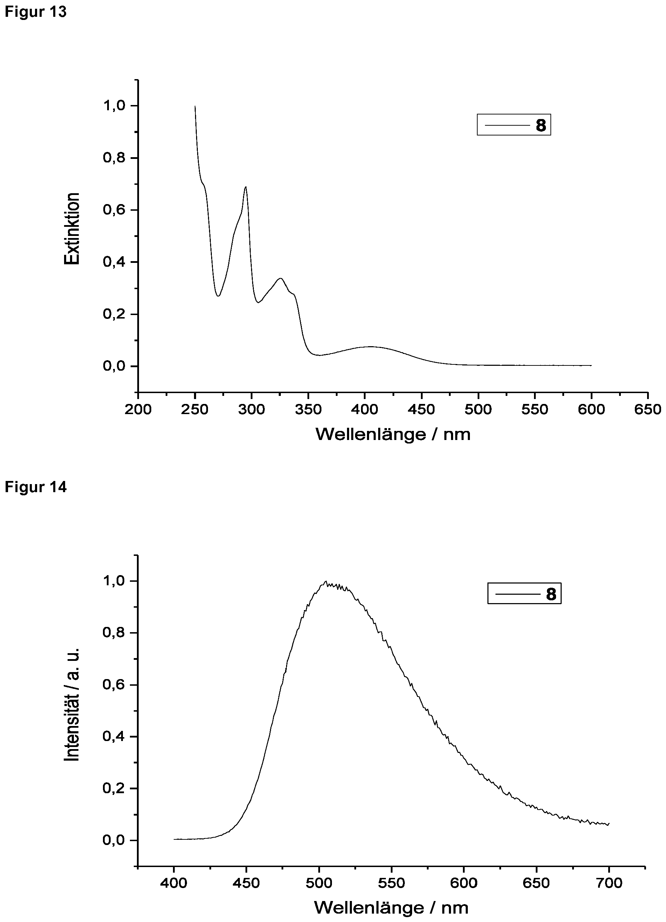

Das Absorptionsspektrum von **8** in Dichlormethan ist in Figur 13 gezeigt.
Die Filmemission von **8** (10 % in PMMA) ist Figur 14 zu entnehmen.
Die Photolumineszenzquantenausbeute von **8** (10% in PMMA) beträgt 37%. Die verzögerte Lebensdauer von **8** (10% in PMMA) beträgt 4,2 µs.

### Beispiel 8

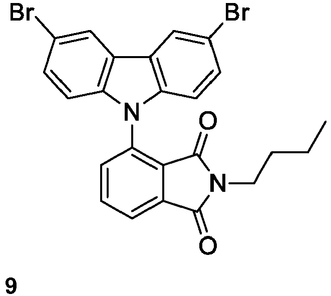

¹H NMR (500 MHz, CDCl₃): δ = 8.21 (d, J = 1.9 Hz, 2H), 8.02 (dd, J = 7.4, 0.9 Hz, 1H), 7.94 (t, J = 7.7 Hz, 1H), 7.80 (dd, J = 8.0, 0.9 Hz, 1H), 7.49 (dd, J = 8.7, 1.9 Hz, 2H), 7.01 (d, J = 8.7 Hz, 2H), 3.60 (t, J = 7.3 Hz, 2H), 1.62 - 1.53 (m, 2H), 1.35 - 1.23 (m, 2H), 0.89 (t, J = 7.3 Hz, 3H).
¹³C NMR (126 MHz, CDCl₃): δ = 167.4, 165.5, 139.8, 135.9, 134.9, 134.2, 133.3, 129.6, 127.2, 124.6, 123.6, 123.4, 114.0, 111.7, 38.2, 30.6, 20.2, 13.7.

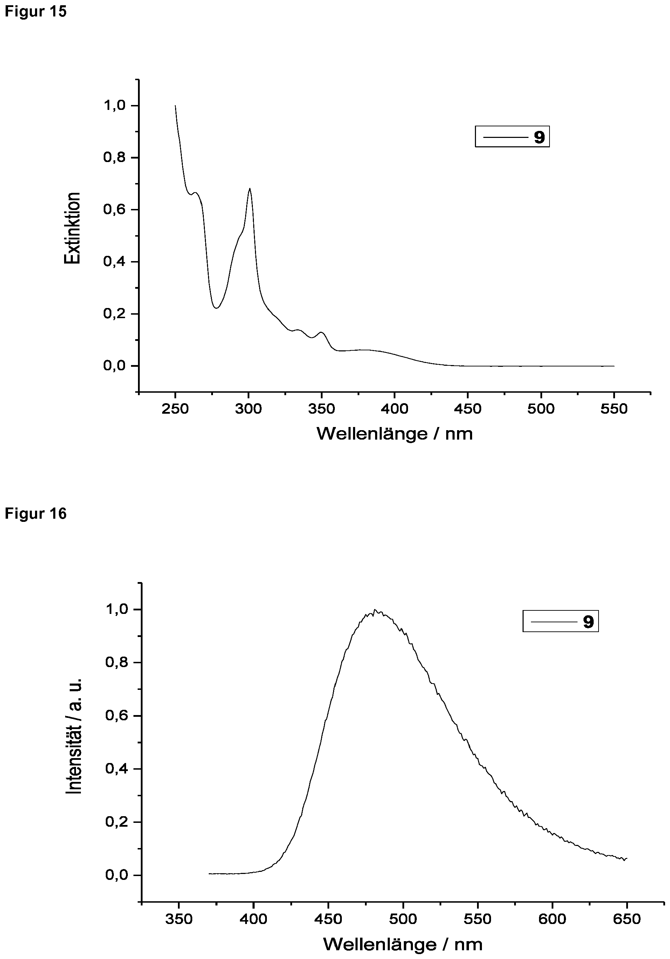

Das Absorptionsspektrum von **9** in Dichlormethan ist in Figur 15 gezeigt.
Die Filmemission von **9** (10 % in PMMA) ist Figur 16 zu entnehmen.

### Beispiel 9

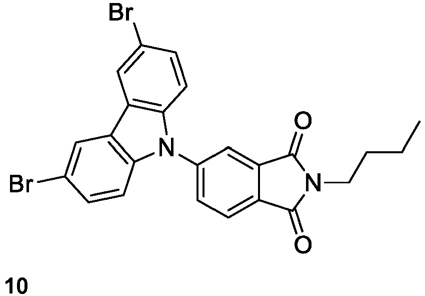

¹H NMR (500 MHz, CDCl₃): δ = 8.20 (d, J = 1.9 Hz, 2H), 8.08 (d, J = 7.9 Hz, 1H), 8.01 (d, J = 1.8 Hz, 1H), 7.87 (dd, J = 7.9, 1.9 Hz, 1H), 7.54 (dd, J = 8.7, 1.9 Hz, 2H), 7.30 (d, J = 8.7 Hz, 2H), 3.75 (t, J = 7.3 Hz, 2H), 1.76 - 1.66 (m, 2H), 1.41 (h, J = 7.4 Hz, 2H), 0.98 (t, J = 7.4 Hz, 3H).
¹³C NMR (126 MHz, CDCl₃): δ = 167.6, 167.5, 142.5, 139.2, 134.7, 131.6, 130.7, 130.1, 125.3, 124.7, 123.7, 121.2, 114.4, 111.4, 38.3, 30.8, 20.3, 13.8.

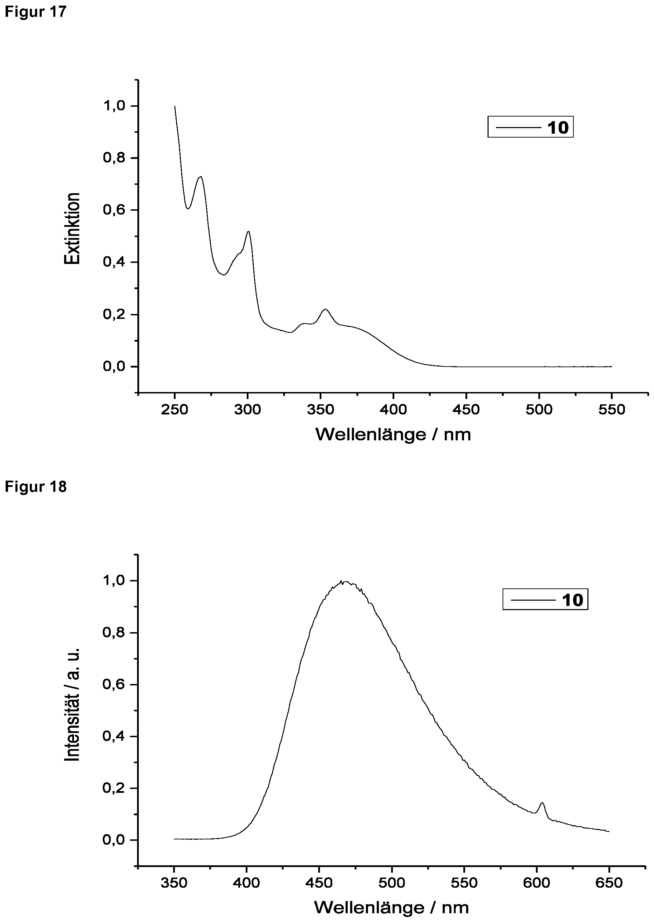

Das Absorptionsspektrum von **10** in Dichlormethan ist in Figur 17 gezeigt.
Die Filmemission von **10** (10 % in PMMA) ist Figur 18 zu entnehmen.

### Beispiel 10

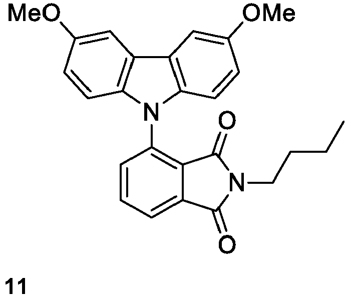

¹H NMR (500 MHz, CDCl₃): δ = 7.93 (dd, J = 7.2, 1.2 Hz, 1H), 7.87 (t, J = 7.5 Hz, 1H), 7.83 (dd, J = 8.0, 1.2 Hz, 1H), 7.56 (d, J = 2.5 Hz, 2H), 7.07 (d, J = 8.9 Hz, 2H), 7.01 (dd, J = 8.9, 2.5 Hz, 2H), 3.95 (s, 6H), 3.62 (t, J = 7.3 Hz, 2H), 1.65 - 1.53 (m, 2H), 1.31 (dt, J = 15.1, 7.4 Hz, 2H), 0.89 (t, J = 7.3 Hz, 3H).
¹³C NMR (126 MHz, CDCl₃): δ = 167.8, 165.8, 154.7, 136.1, 135.5, 134.9, 134.8, 134.0, 126.4, 124.5, 122.1, 115.2, 111.1, 103.3, 56.2, 38.1, 30.6, 20.2, 13.7.

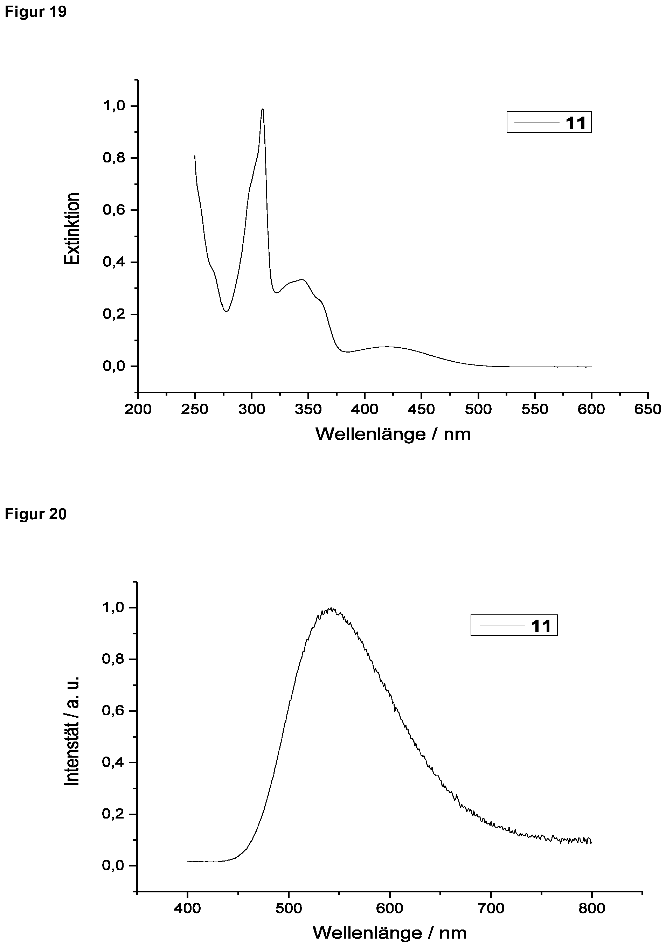

Das Absorptionsspektrum von **11** in Dichlormethan ist in Figur 19 gezeigt.
Die Filmemission von **11** (10% in PMMA) ist Figur 20 zu entnehmen.

### Beispiel 11

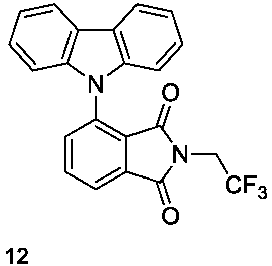

¹H NMR (500 MHz, CDCl₃): δ = 8.16 (d, J = 7.7 Hz, 2H), 8.06 (dd, J = 7.2, 1.2 Hz, 1H), 7.99 (t, J = 7.6 Hz, 1H), 7.95 (dd, J = 7.9, 1.2 Hz, 1H), 7.40 (ddd, J = 8.3, 7.2, 1.3 Hz, 2H), 7.33 (td, J = 7.4, 1.0 Hz, 2H), 7.16 (d, J = 8.3 Hz, 2H), 4.24 (q, J = 8.5 Hz, 2H).
¹⁹F NMR (471 MHz, CDCl₃): δ = -70.48.

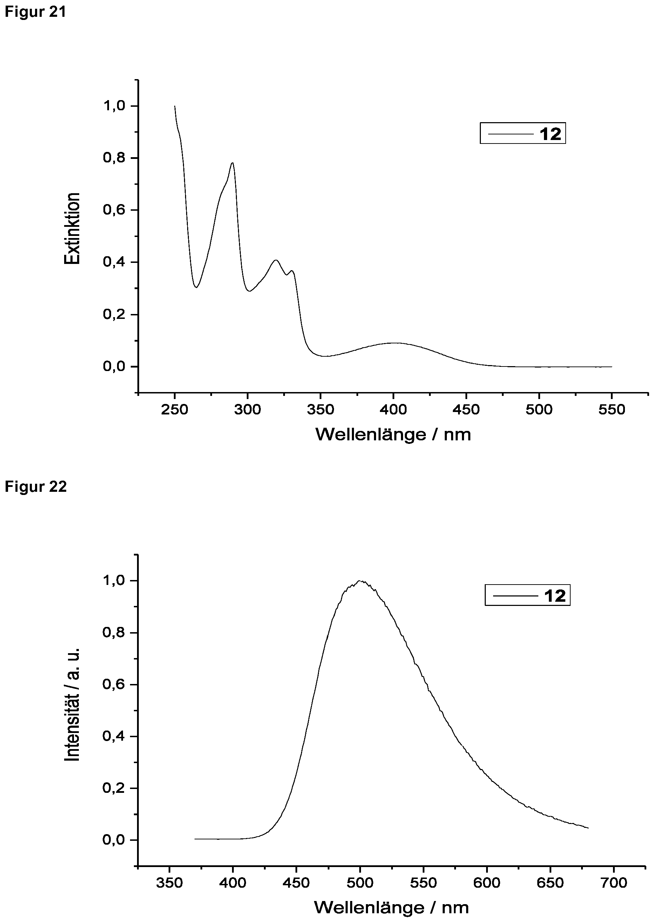

Das Absorptionsspektrum von **12** in Dichlormethan ist in Figur 21 gezeigt.
Die Filmemission von **12** (10 % in PMMA) ist Figur 22 zu entnehmen.

### Beispiel 12

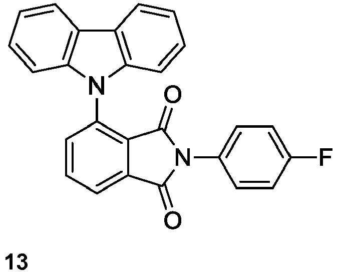

¹H NMR (500 MHz, CDCl₃): δ = 8.16 (d, J = 7.9 Hz, 2H), 8.11 (d, J = 7.3 Hz, 1H), 8.01 (t, J = 7.6 Hz, 1H), 7.95 (d, J = 8.1 Hz, 1H), 7.43 - 7.34 (m, 4H), 7.32 (t, J = 7.5 Hz, 2H), 7.20 (d, J = 8.1 Hz, 2H), 7.15-7.07 (m, 2H).
¹⁹F NMR (471 MHz, CDCl₃): δ = -113.0.

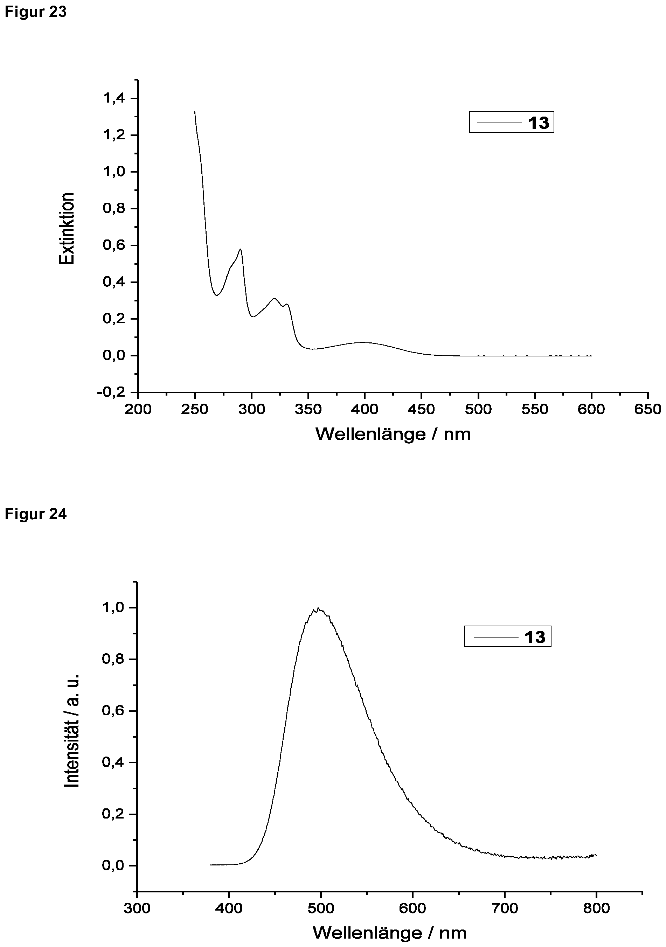

Das Absorptionsspektrum von **13** in Dichlormethan ist in Figur 23 gezeigt.
Die Filmemission von **13** (10 % in PMMA) ist Figur 24 zu entnehmen.

### Beispiel 13

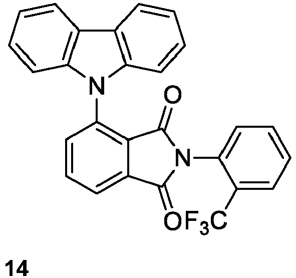

¹H NMR (500 MHz, CDCl₃): δ = 8.13 (t, J = 7.5 Hz, 2H), 8.10 (dd, J = 7.0, 1.4 Hz, 1H), 8.01 (t, J = 7.5 Hz, 1H), 7.98 (dd, J = 8.0, 1.4 Hz, 1H), 7.79 (t, J = 7.9 Hz, 1H), 7.63 (t, J = 7.7 Hz, 1H), 7.56 (t, J = 7.7 Hz, 1H), 7.43-7.37 (m, 2H), 7.35 - 7.27 (m, 4H), 7.16 (d, J = 8.2 Hz, 1H).
¹⁹F NMR (471 MHz, CDCl₃): δ = -61.2.

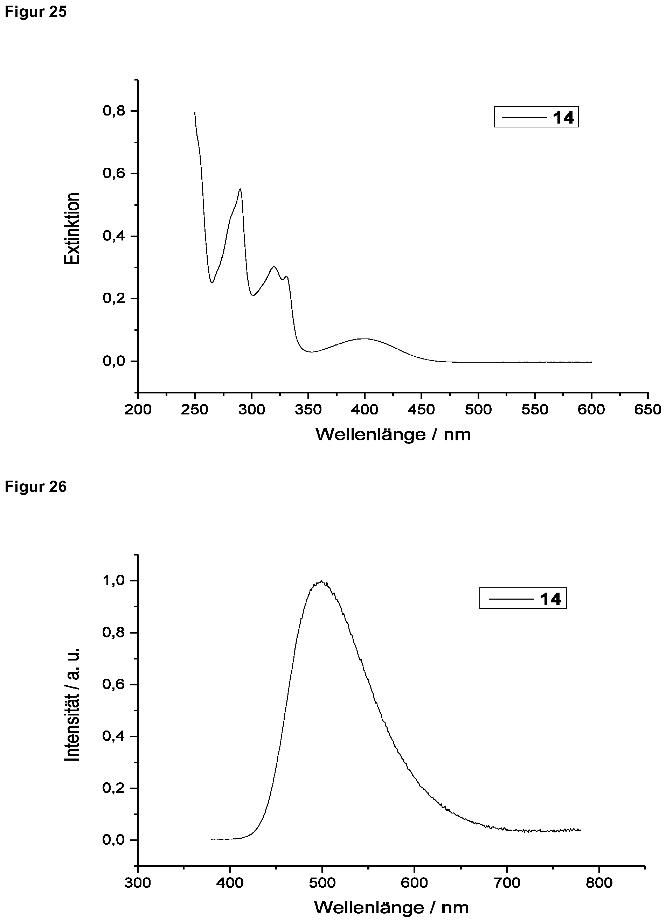

Das Absorptionsspektrum von **14** in Dichlormethan ist in Figur 25 gezeigt.
Die Filmemission von **14** (10 % in PMMA) ist Figur 26 zu entnehmen.

### Beispiel 14

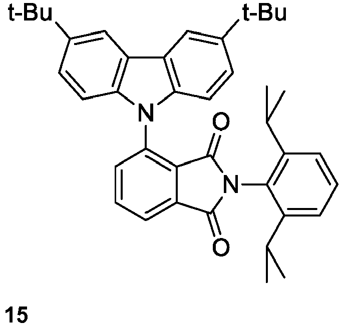

¹H NMR (500 MHz, CDCl₃): δ = 8.12 (d, J = 1.9 Hz, 2H), 8.05 (dd, J = 6.2, 2.1 Hz, 1H), 8.00 - 7.95 (m, 2H), 7.44 - 7.38 (m, 3H), 7.25 (d, J = 7.8 Hz, 2H), 7.19 (d, J = 8.6 Hz, 2H), 2.79 (hept, J = 6.8 Hz, 2H), 1.44 (s, 18H), 1.22 (d, J = 6.8 Hz, 6H), 1.15 (d, J = 6.8 Hz, 6H).
¹³C NMR (126 MHz, CDCl₃): δ = 167.7, 165.5, 147.3, 143.9, 138.7, 135.8, 135.5, 134.4, 134.0, 130.3, 126.8, 125.5, 124.3, 124.0, 123.6, 122.5, 116.7, 109.9, 34.9, 32.1, 29.6, 24.2.

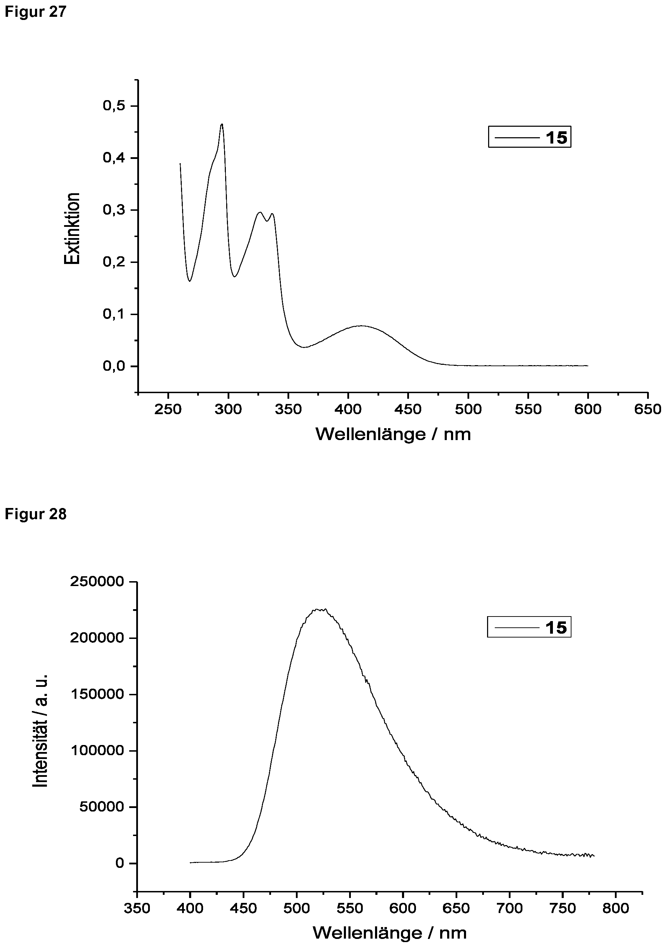

Das Absorptionsspektrum von **15** in Dichlormethan ist in Figur 27 gezeigt.
Die Filmemission von **15** (10 % in PMMA) ist Figur 28 zu entnehmen.

### Beispiel 15

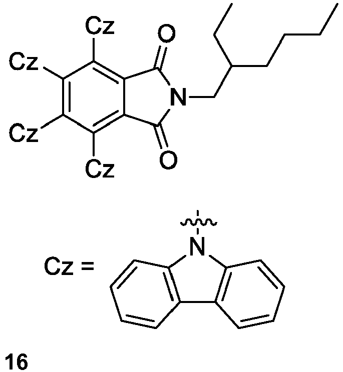

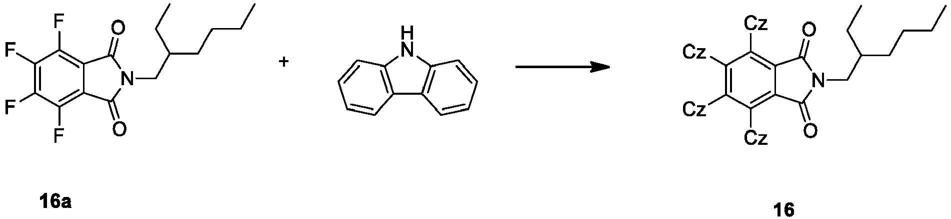

Molekül **16** wurde nicht nach obiger Synthesevorschrift dargestellt, sondern nach nachfolgender Synthesevorschrift. In einem 250 mL Stickstoffkolben werden unter N₂-Atmosphäre 4.18 g (25 mmol) Carbazol in 100 mL absolutem THF gelöst. Es werden 1.2 g Natriumhydrid (60% in Mineralöl, 30 mmol) zugegeben und anschließend 15 min bei RT gerührt. Imid **16a** wird, gelöst in 20 mL absolutem THF, zugegeben. Nach 2 h rühren bei Raumtemperatur wird das Lösungsmittel am Roationsverdampfer entfernt. Der Rückstand wird in 150 mL EtOAc aufgenommen und mit 100 mL Wasser gewaschen. Die wässrige Phase wird noch 2x mit je 50 mL EtOAc extrahiert. Die vereinigten organischen Phasen werden mit gesättigter NaCI-Lösung gewaschen und über MgSO₄ getrocknet. Nachdem das Lösungsmittel am Rotationsverdampfer entfernt wurde, wird der Rückstand über wenig Kieselgel filtriert (Eluent: Pentan/EtOAc 1:1). Das Lösungsmittel wird am Rotationsverdampfer entfernt und der Rückstand in 50 mL CHCl₃ gelöst und mittels Zugabe von 200 mL EtOH ausgefällt. Der so erhaltene Feststoff wird säulenchromatographisch an Kieselgel (Eluent: Pentan/DCM) aufgereinigt. Es werden 1.45 g (1.58 mmol, 32%) des Produktes **16** als oranger Feststoff erhalten.
¹H NMR (500 MHz, CDCl₃): δ = 7.75 (d, J = 8.2 Hz, 4H), 7.29 (d, J = 7.9 Hz, 4H), 7.11 - 7.02 (m, 8H), 7.02 - 6.92 (m, 8H), 6.74 (t, J = 7.4 Hz, 4H), 6.59-6.40 (m, 4H), 3.53 (d, J = 7.4 Hz, 2H), 1.77 (hept, J = 6.5 Hz, 1H), 1.39 - 1.14 (m, 8H), 0.90-0.81 (m, 6H).
¹³C NMR (126 MHz, CDCl₃): δ = 164.3, 141.2, 139.4, 137.8, 133.3, 129.2, 125.2, 125.2, 124.5, 124.1, 123.8, 120.8, 120.6, 120.2, 119.5, 110.4, 110.3, 42.6, 38.0, 30.5, 28.6, 23.8, 23.2, 14.3, 10.5.

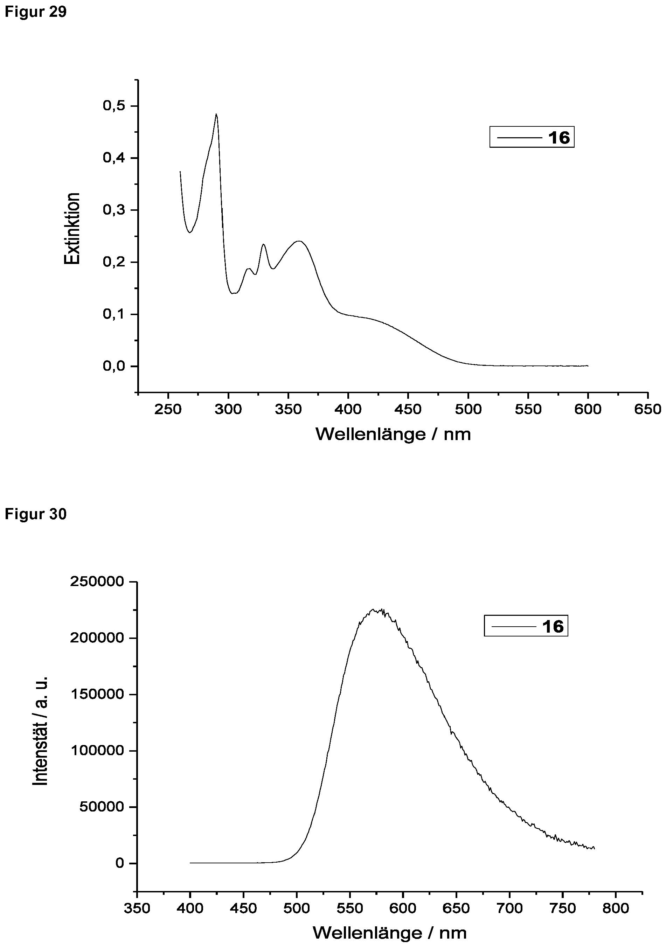

Das Absorptionsspektrum von **16** in Dichlormethan ist in Figur 29 gezeigt.

Die Filmemission von 16 (10 % in PMMA) ist Figur 30 zu entnehmen.
Die Photolumineszenzquantenausbeute von **16** (10% in PMMA) beträgt 28%. Die verzögerte Lebensdauer von **16** (10% in PMMA) beträgt 3,0 µs.

### Beispiel 16

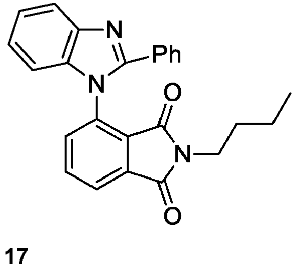

¹H NMR (500 MHz, CDCl₃): δ = 7.96 (dd, J = 7.4, 1.1 Hz, 1H), 7.93 (dt, J = 8.0, 0.9 Hz, 1H) 7.91 (t, J = 7.6 Hz, 1H), 7.80 (dd, J = 7.7, 1.1 Hz, 1H), 7.52 - 7.47 (m, 2H), 7.36 (ddd, J = 8.2, 7.2, 1.1 Hz, 1H), 7.34 - 7.24 (m, 4H), 7.13 (dt, J = 8.2, 0.9 Hz, 1H), 3.54 - 3.36 (m, 2H), 1.50 - 1.30 (m, 2H), 1.07 (hept, J = 6.8 Hz, 2H), 0.82 (t, J = 7.3 Hz, 3H).

### Beispiel 17

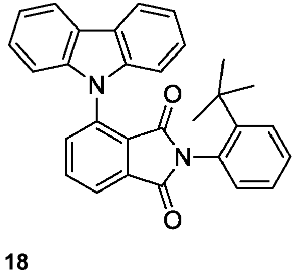

### Beispiel 18

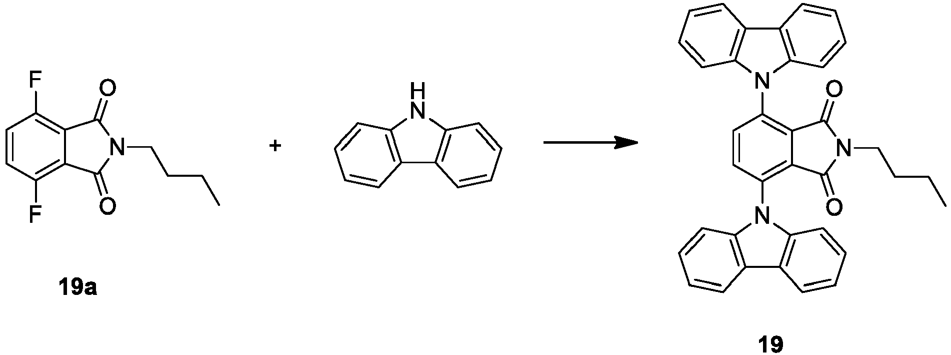

In einem 50 mL Rundkolben werden Imid **19a** (598 mg, 2.5 mmol), Carbazol (1.05 g, 6.25 mmol) und K₃PO₄ (2.65 g, 12.5 mmol) vorgelegt und für 5 min evakuiert. Nach besticken werden 10 mL DMSO (trocken) zugegeben und für 16 h bei 100 °C erhitzt. Die Reaktionslösung wird auf 100 mL Wasser geschüttet und anschließend filtriert. Der Feststoff wird in 100 mL CH₂Cl₂ aufgenommen und mit 20 mL Wasser gewaschen. Die wässrige Phase wird mit 50 mL CH₂Cl₂ extrahiert. Die vereinigten organischen Phasen werden mit ges. NaCI-Lösung gewaschen und über MgSO₄ getrocknet. Anschließend wird das Lösemittel am Rotationsverdampfer entfernt. Anschließend wird über MgSO₄ getrocknet und das Lösemittel am Rotationsverdampfer entfernt. Rekristallisation aus einer Mischung EtOH und CHCl₃ liefert das Produkt **19** (365 mg, 27%%) als gelben Feststoff.
¹H NMR (500 MHz, CDCl₃): δ = 8.20 (d, *J* = 7.9, 4H), 8.06 (s, 2H), 7.47 (ddd, *J* = 8.3, 7.2, 1.2 Hz, 4H), 7.43 - 7.35 (m, 4H), 7.33 (d, *J* = 8.1 Hz, 4H), 3.54 (t, *J* = 7.4 Hz, 2H), 1.58 - 1.46 (m, 2H), 1.32 - 1.17 (m, 2H), 0.83 (t, *J* = 7.4 Hz, 3H).
¹³C NMR (126 MHz, CDCl₃): δ = δ 164.9, 140.7, 136.0, 133.6, 128.9, 126.2, 124.2, 121.2, 120.8, 110.1, 38.3, 30.4, 20.1, 13.7.

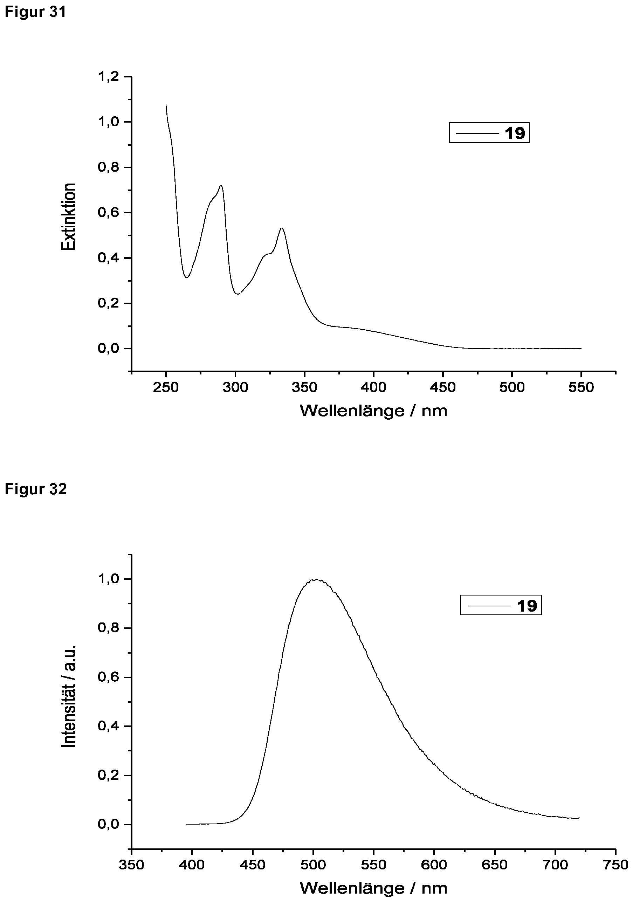

Das Absorptionsspektrum von **19** in 2-Methyltetrahydrofuran ist in Figur 31 gezeigt.
Die Filmemission von **19** (10 % in PMMA) ist Figur 32 zu entnehmen.

### Beispiel 19

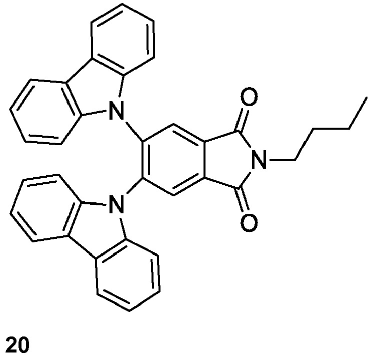

### Beispiel 20

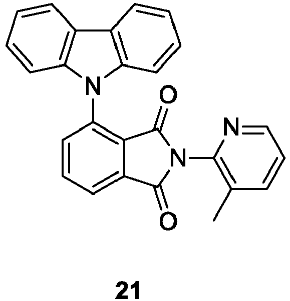

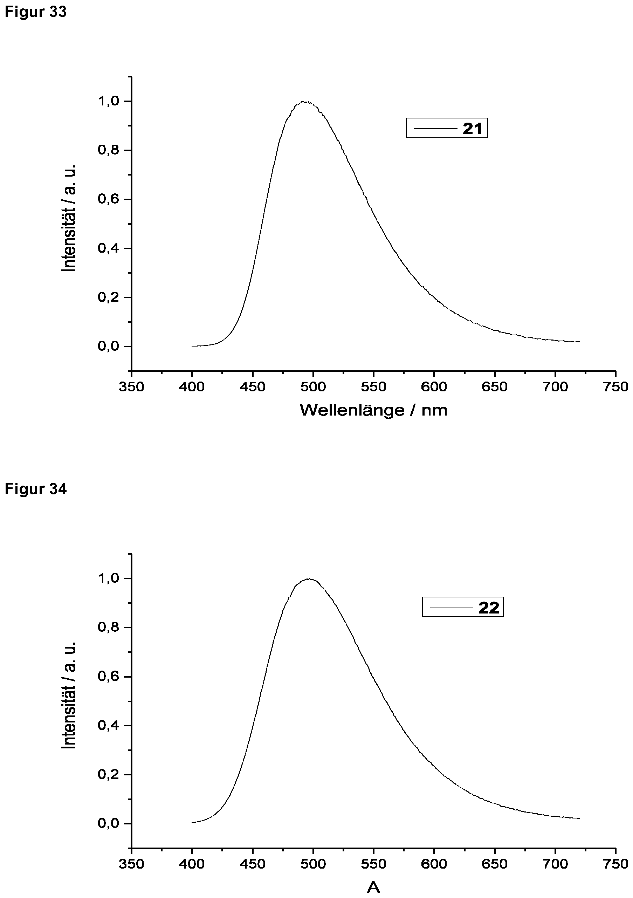

Die Synthese erfolgte analog zu **2.**
¹H NMR (500 MHz, CDCl₃): δ = 8.44 (dd, *J* = 4.7, 1.7 Hz, 1H), 8.17 - 8.09 (m, 3H), 8.01 (t, *J* = 7.6 Hz, 1H), 7.96 (dd, *J* = 7.9, 1.1 Hz, 1H), 7.64 (ddd, *J* = 7.8, 1.7, 0.8 Hz, 1H), 7.40 (dddd, *J* = 8.3, 7.3, 2.7, 1.2 Hz, 2H), 7.34 - 7.26 (m, 3H), 7.23 (dd, *J* = 16.2, 8.2 Hz, 2H), 2.23 (s, 3H).
Die Filmemission von **21** (10 % in PMMA) ist Figur 33 zu entnehmen. Die Photolumineszenzquantenausbeute von **21** (10% in PMMA) beträgt 54%. Die verzögerte Lebensdauer von **21** (10% in PMMA) beträgt 6,4 µs.

### Beispiel 21

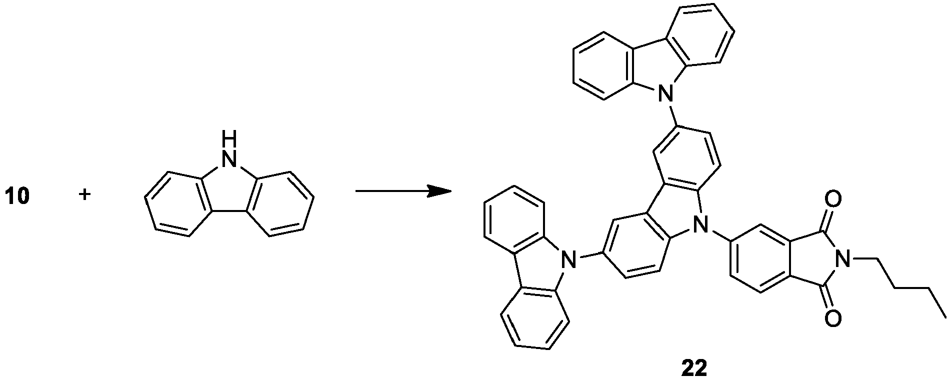

In einem 50 mL Rundkolben werden **10** (1.58 g, 3 mmol), Carbazol (1.25 g, 7.5 mmol), K₃PO₄ (2.55 g, 12 mmol) und Kupfer(I)-iodid (286 mg, 1.5 mmol) vorgelegt und für 5 min evakuiert. Nach besticken werden 10 mL Dioxan (trocken) und (±)-trans-1,2-Diaminocyclohexan (0.54 mL, 4.5 mmol) zugegeben und für 2d bei 100 °C gerührt. Nach abkühlen auf Raumtemperatur werden 50 mL CH₂Cl₂ zugegeben und über wenig Kieselgel filtriert (Eluent: CH₂Cl₂) Anschließend wird das Lösemittel am Rotationsverdampfer entfernt. Der Rückstand wird säulenchromatographisch (Eluent: Cyclohexan/CH₂Cl₂) aufgereinigt. Anschließend wird das Produkt durch zusätzliche Umkristallisation (EtOH/CHCl₃) weiter aufgereingt. Das Produkt **22** wird als gelber Feststoff (220 mg, 11%) erhalten.
¹H NMR (500 MHz, CDCl₃): δ = 8.31 (d, *J* = 1.9 Hz, 2H), 8.26 (d, *J =* 1.8 Hz, 1H), 8.19 (d, *J* = 7.9 Hz, 1H), 8.17 (d, *J* = 7.9 Hz, 4H), 8.12 (dd, *J* = 7.9, 1.8 Hz, 1H), 7.72 (d, *J =* 8.7 Hz, 2H), 7.67 (dd, *J* = 8.7, 2.0 Hz, 2H), 7.44-7.38 (m, 8H), 7.30 (ddd, *J* = 8.0, 6.0, 2.1 Hz, 4H), 3.80 (t, *J* = 7.3 Hz, 2H), 1.81 - 1.70 (m, 2H), 1.49 - 1.39 (m, 2H), 1.01 (t, *J* = 7.3 Hz, 3H).

Die Filmemission von **22** (10 % in PMMA) ist Figur 34 zu entnehmen.

### Weitere Beispiele:

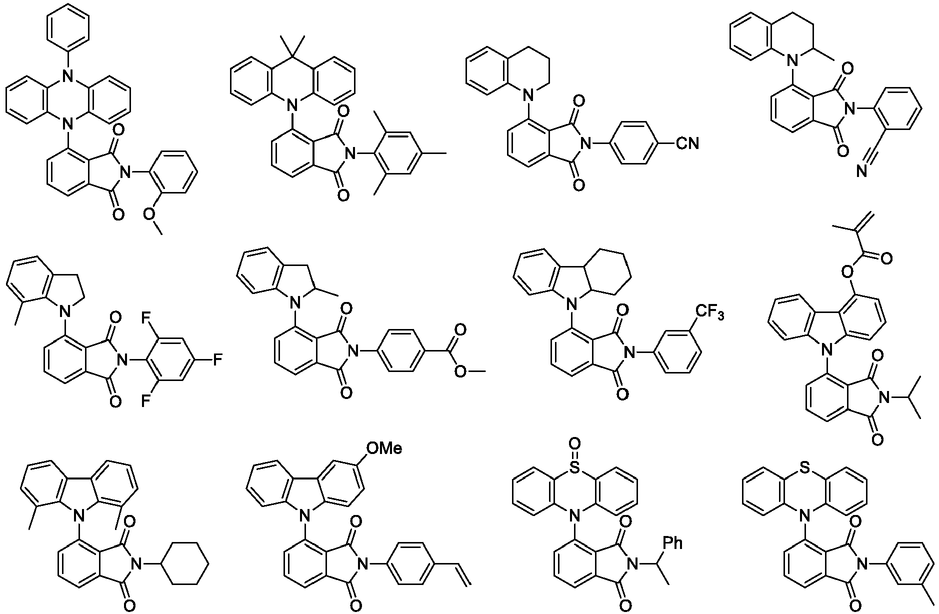

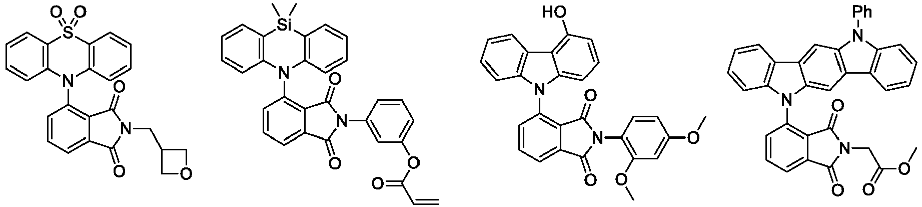

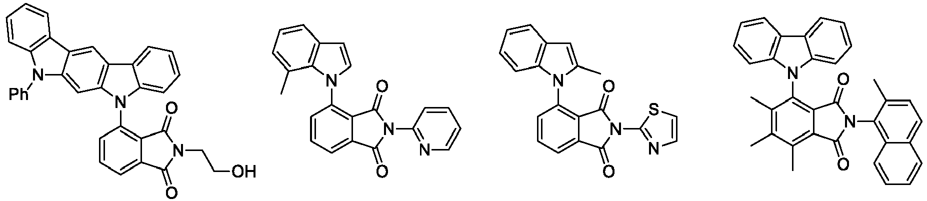

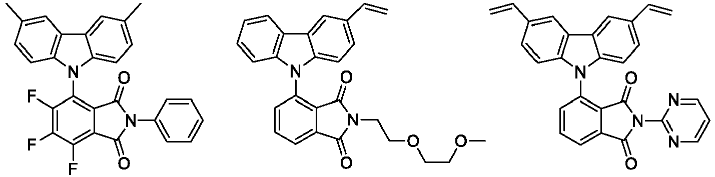

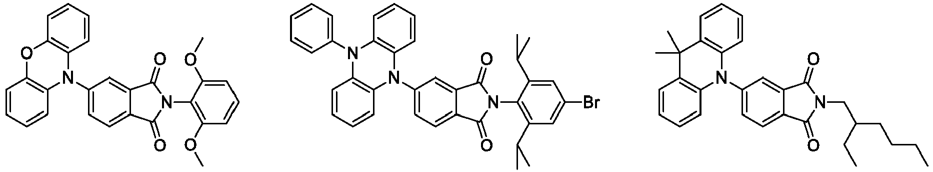

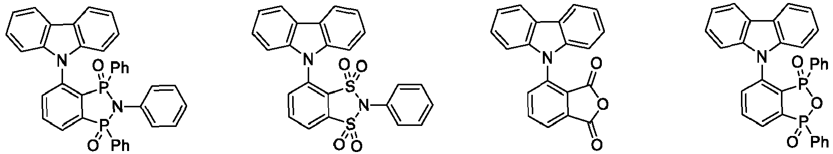

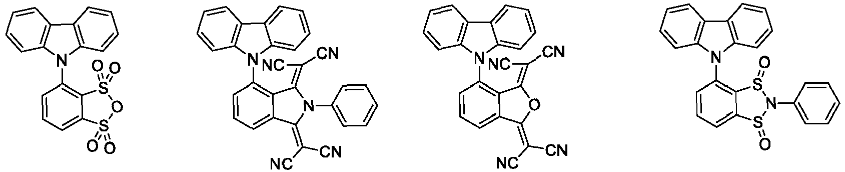

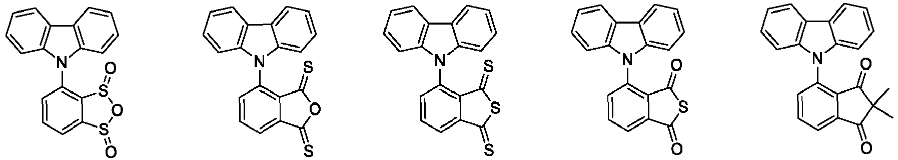

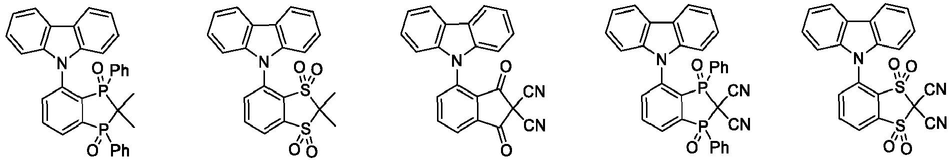

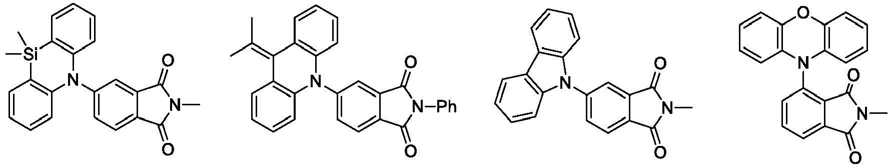

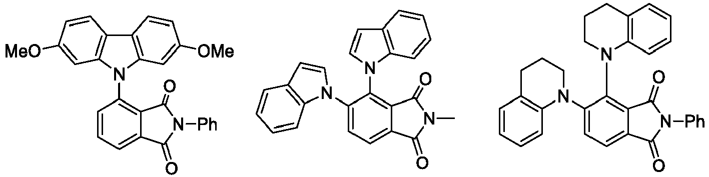

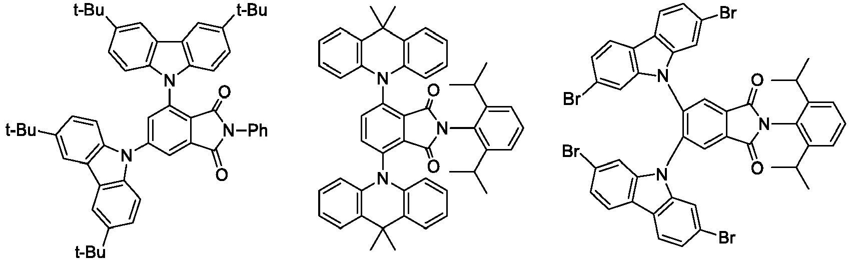

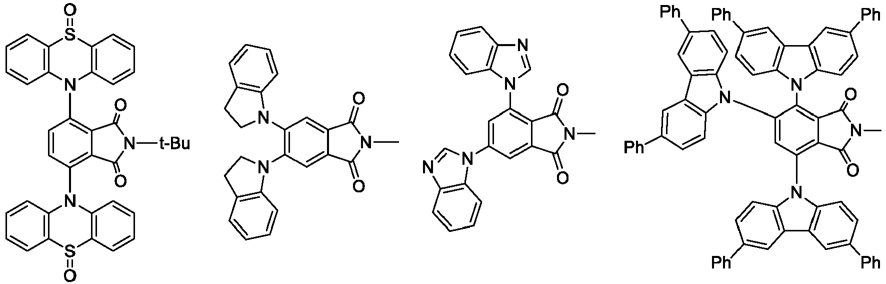

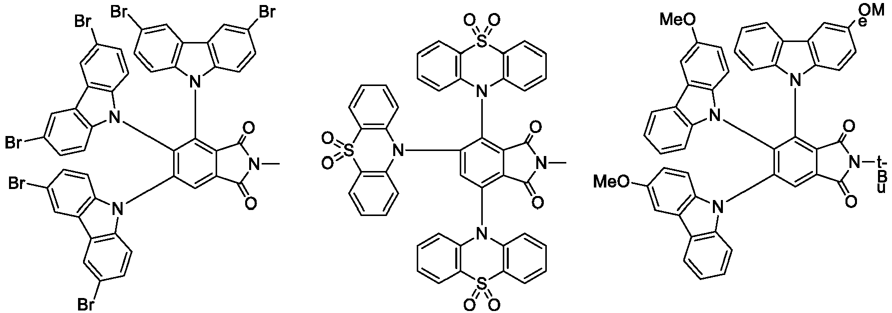

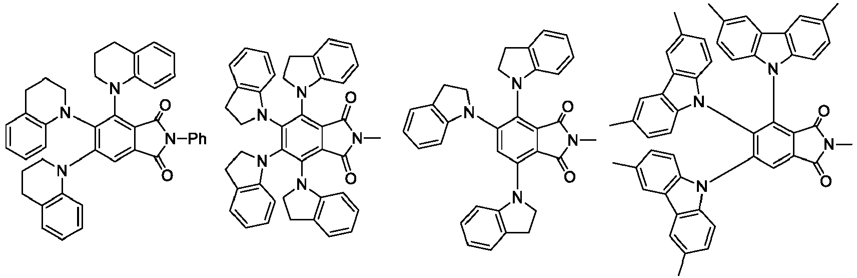

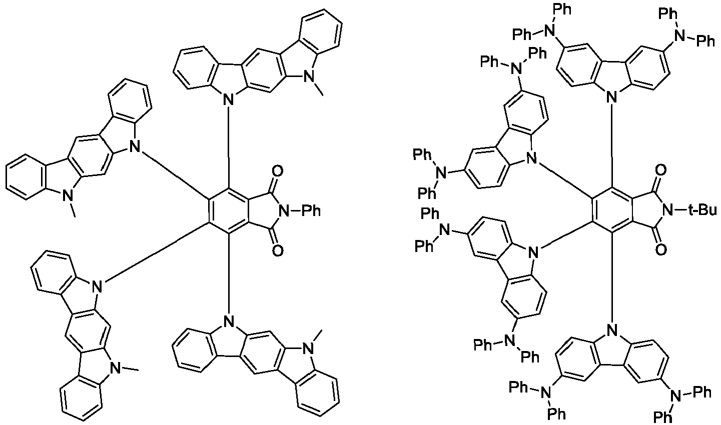

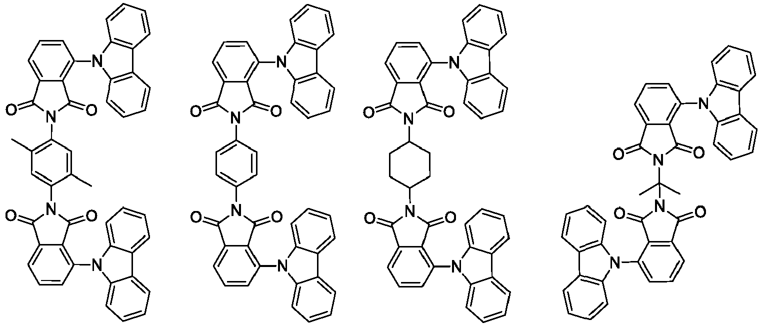

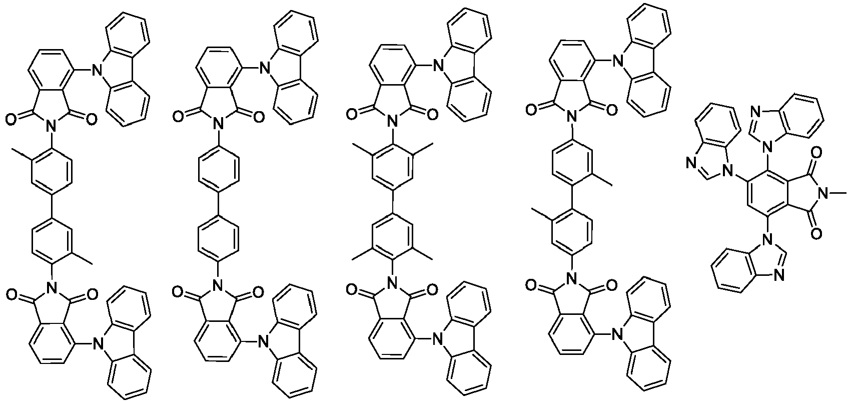

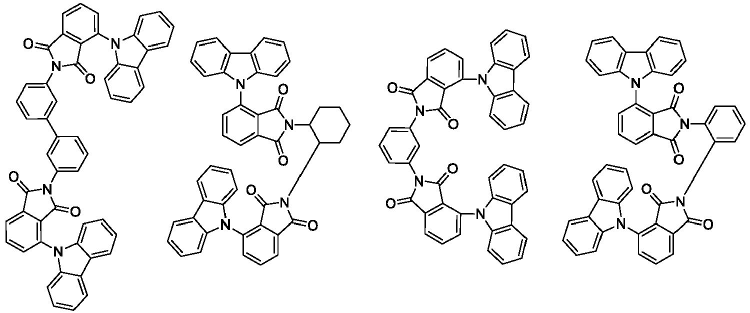

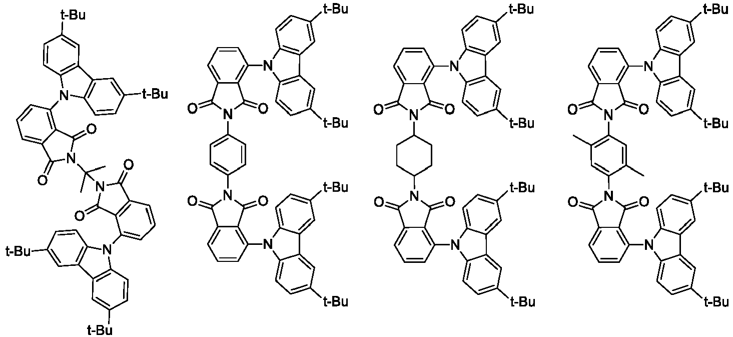

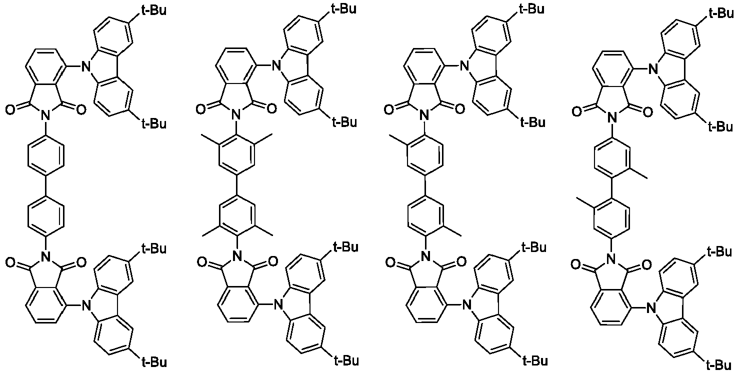

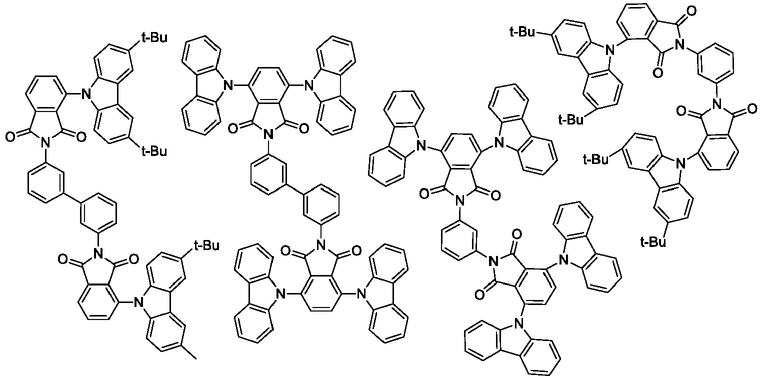

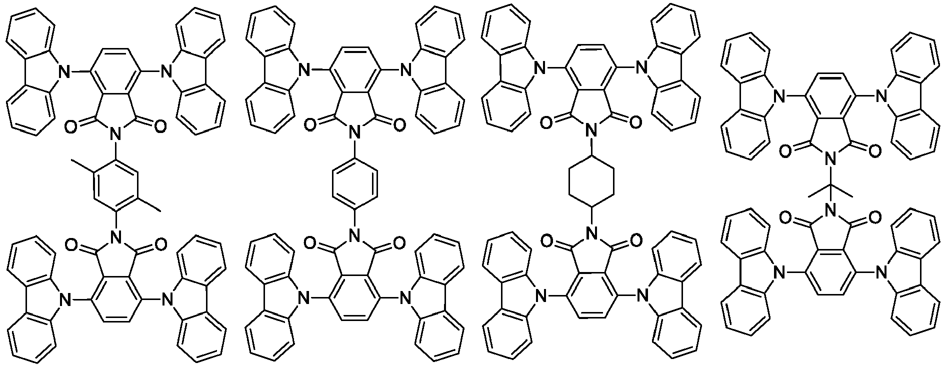

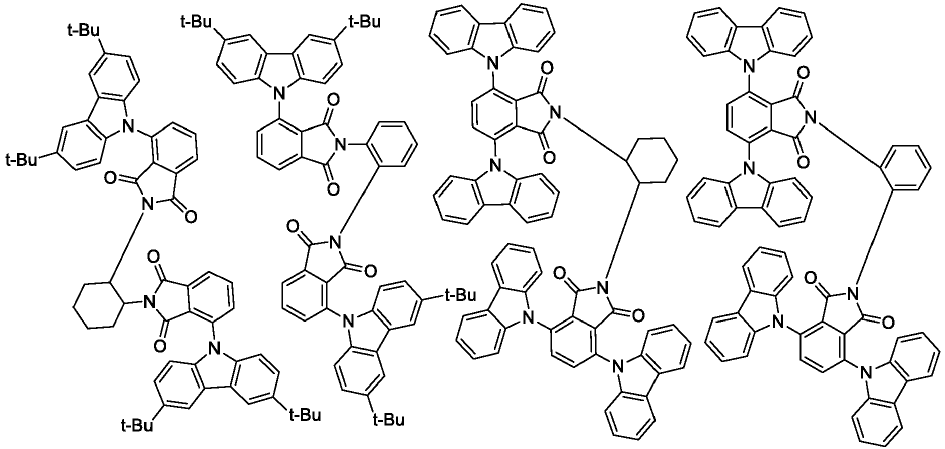

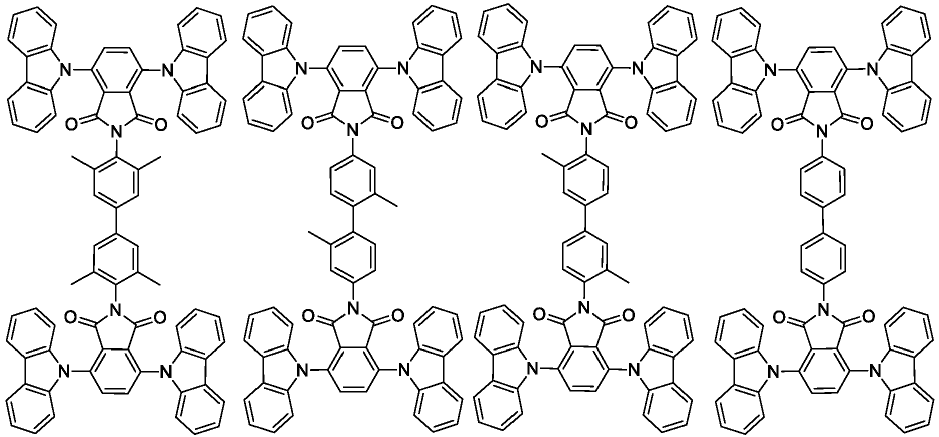

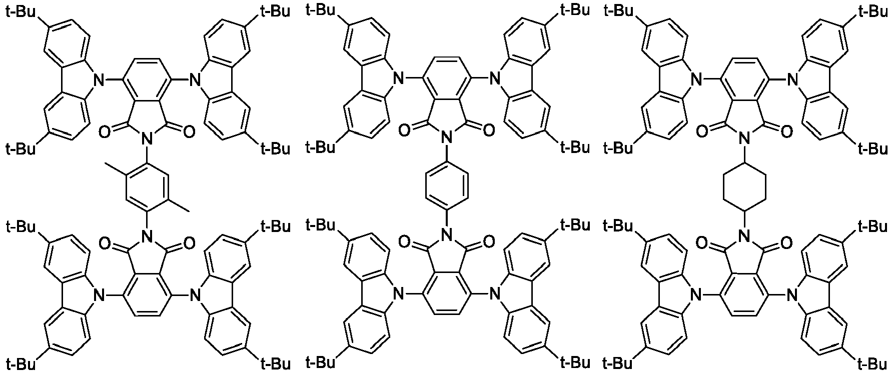

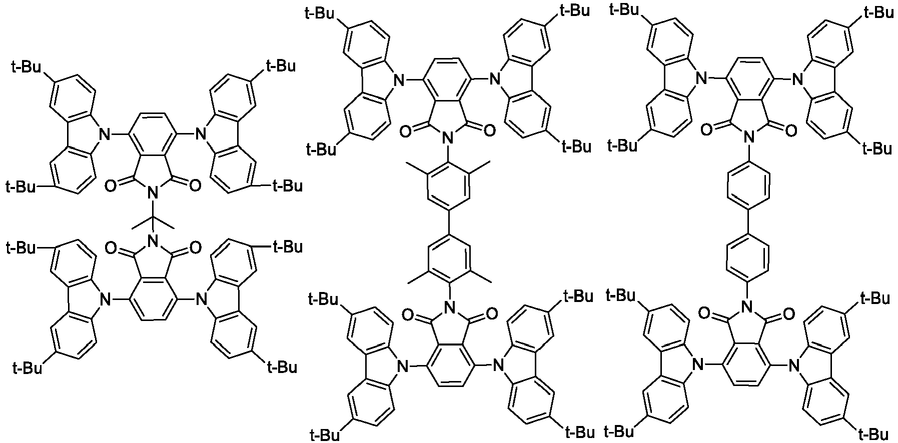

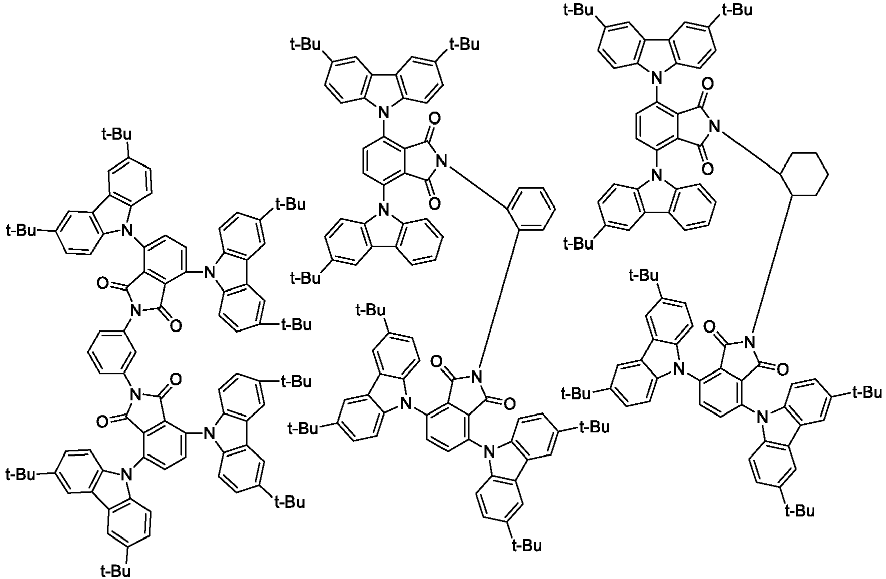

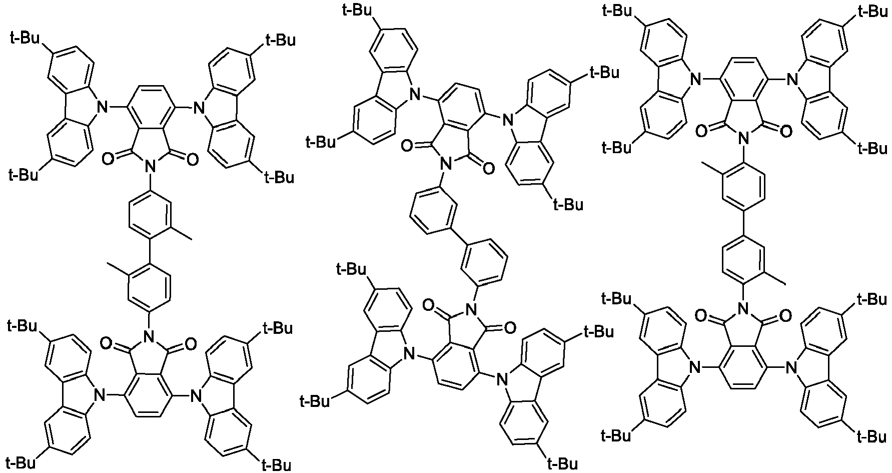

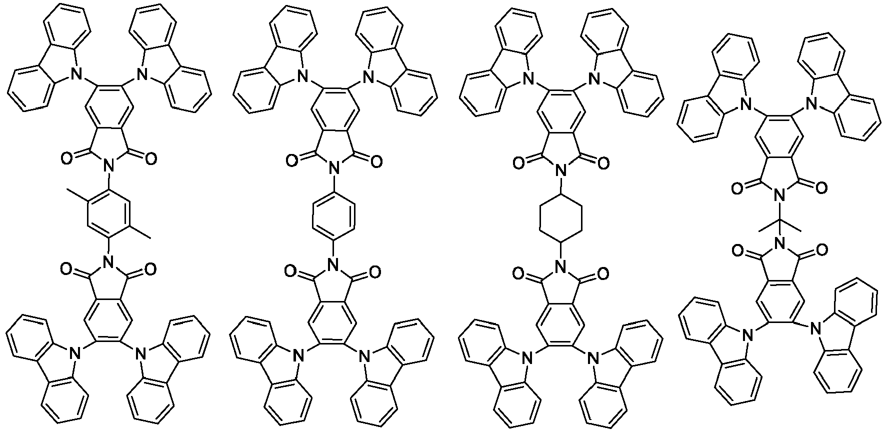

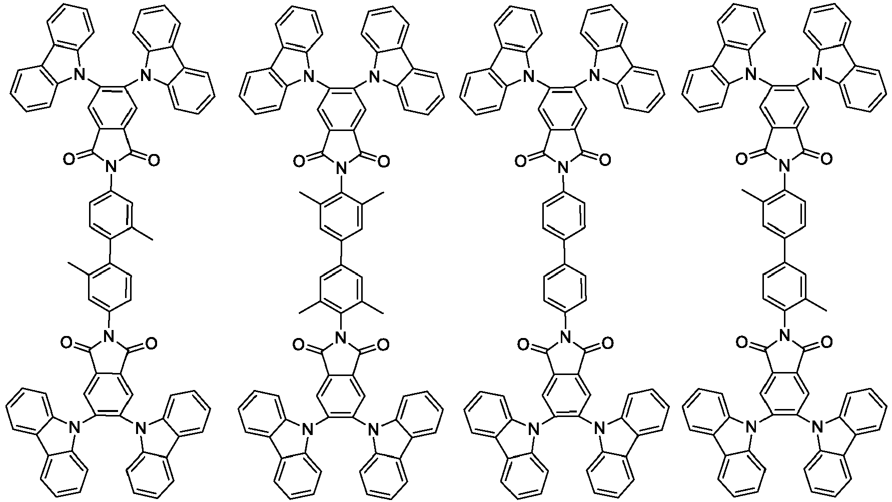

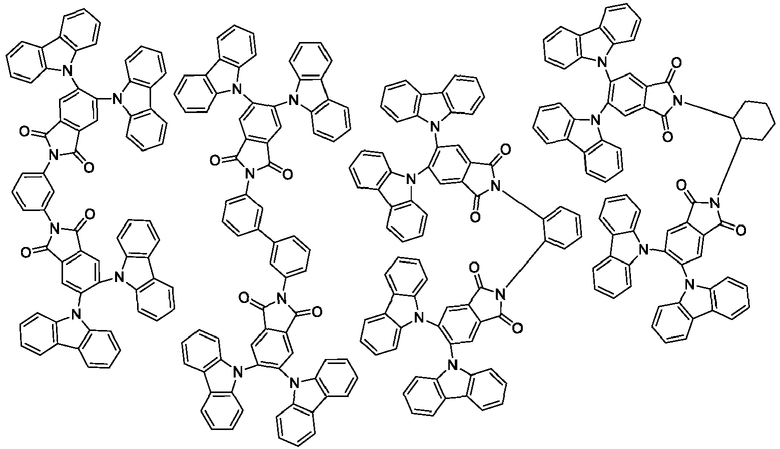

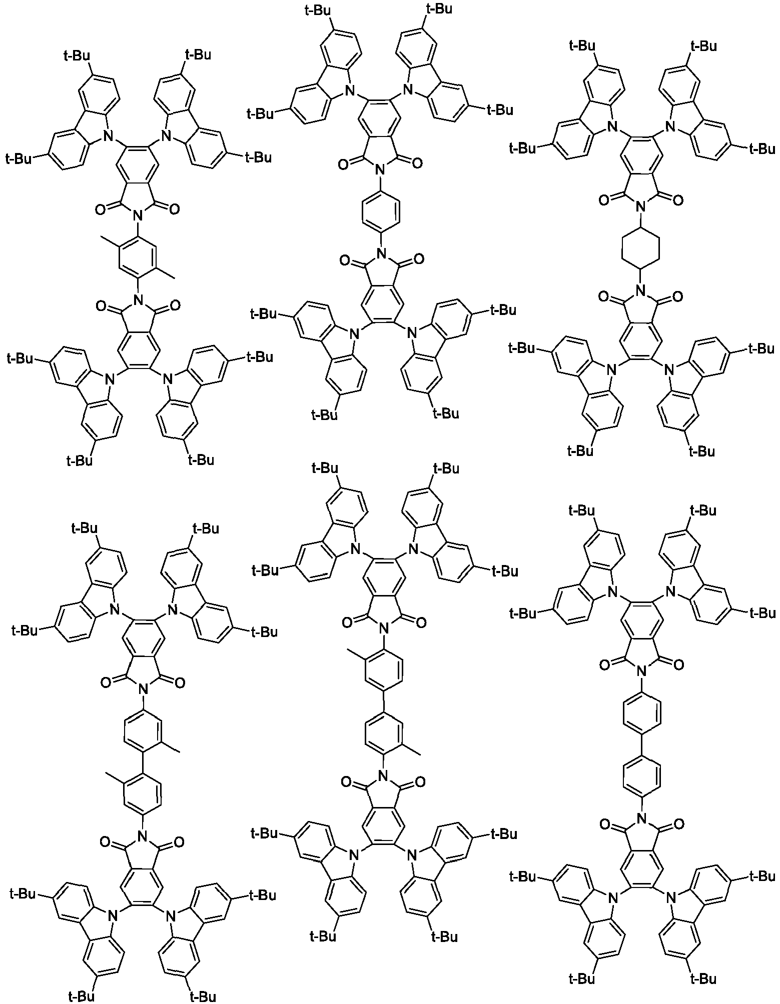

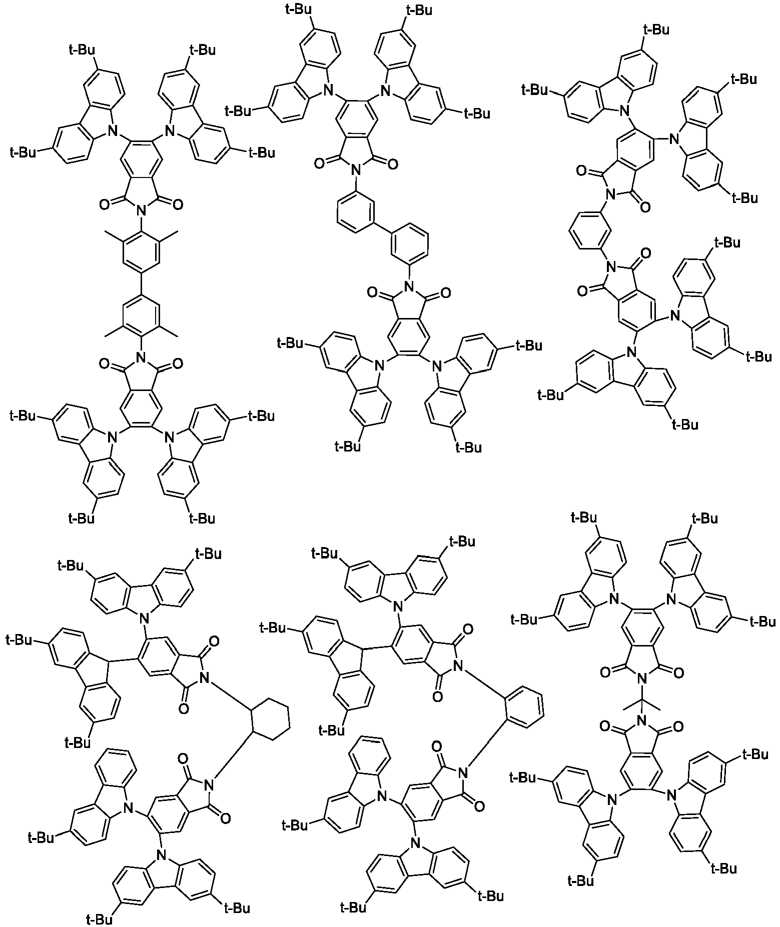

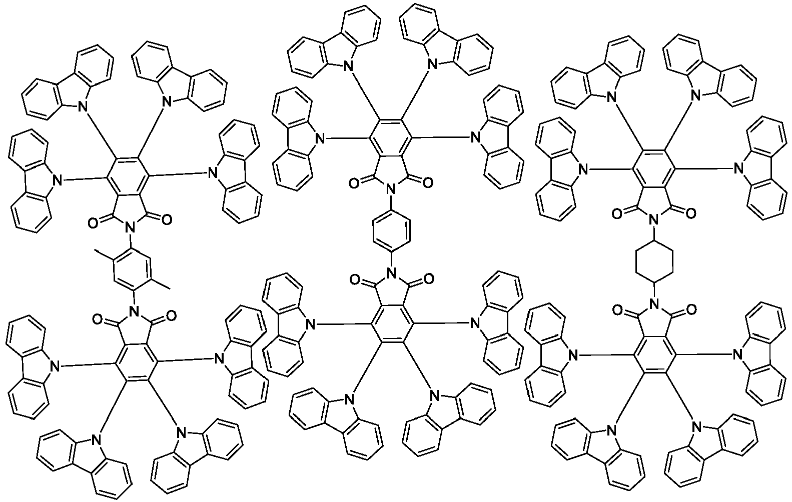

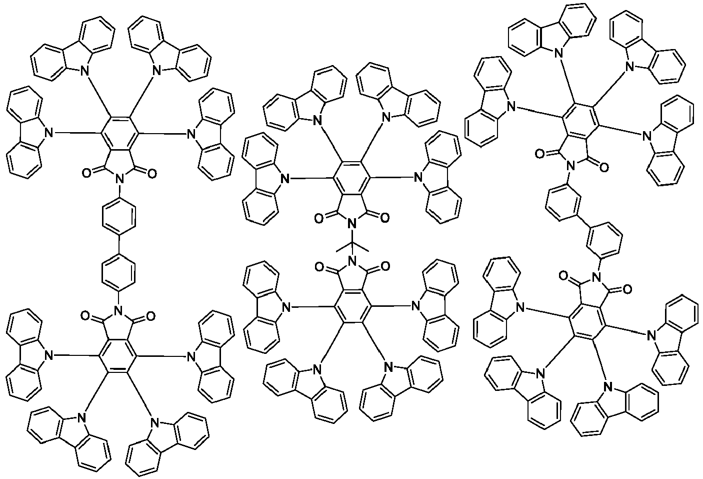

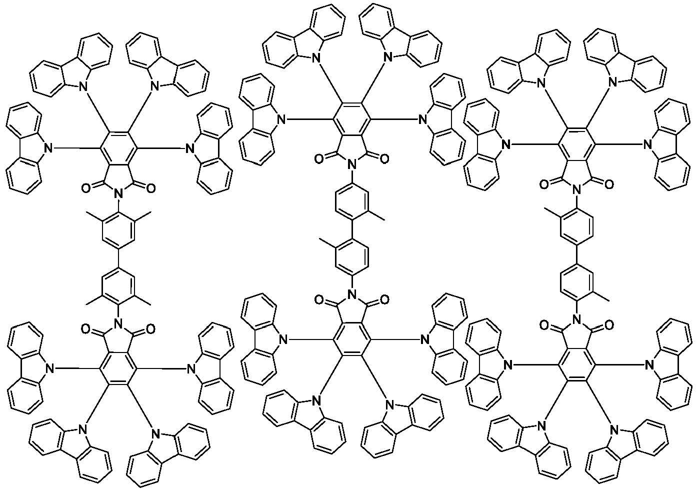

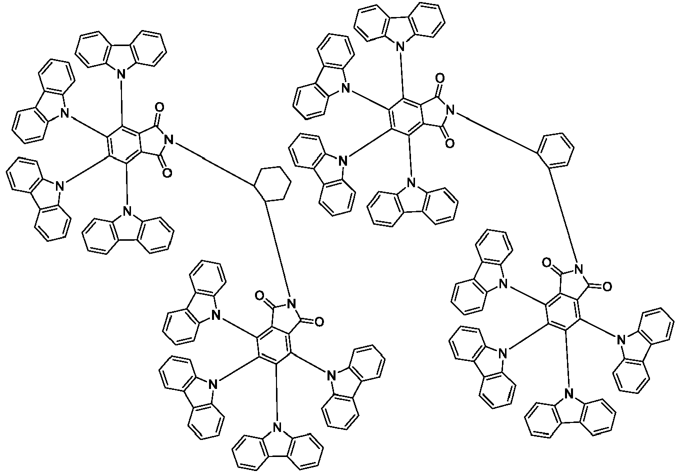

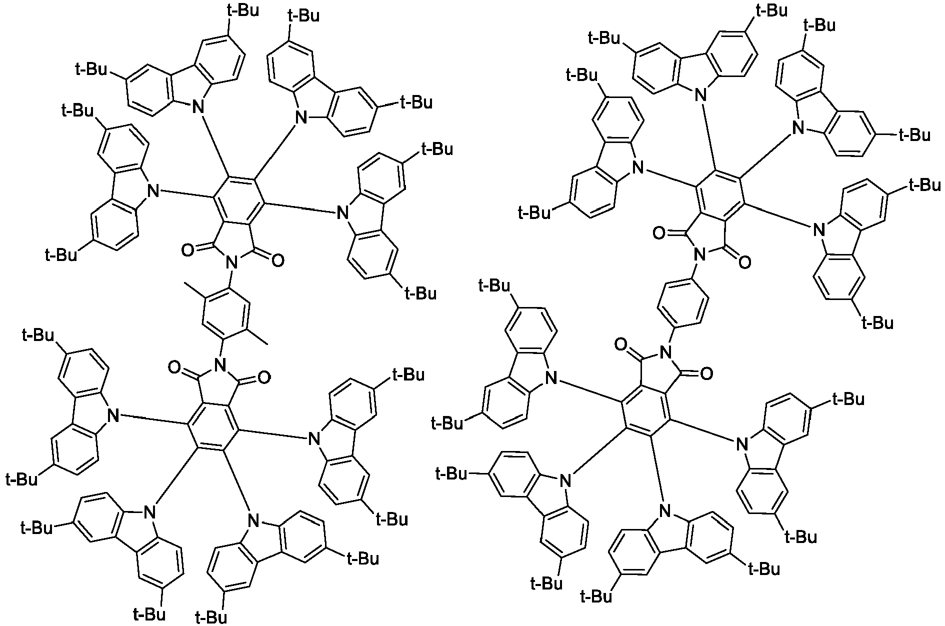

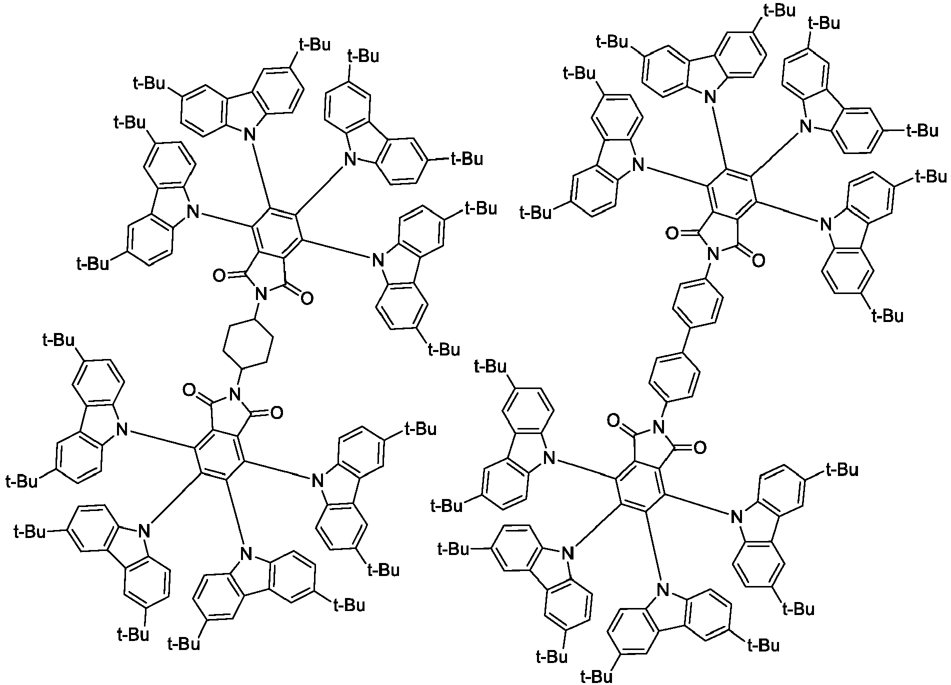

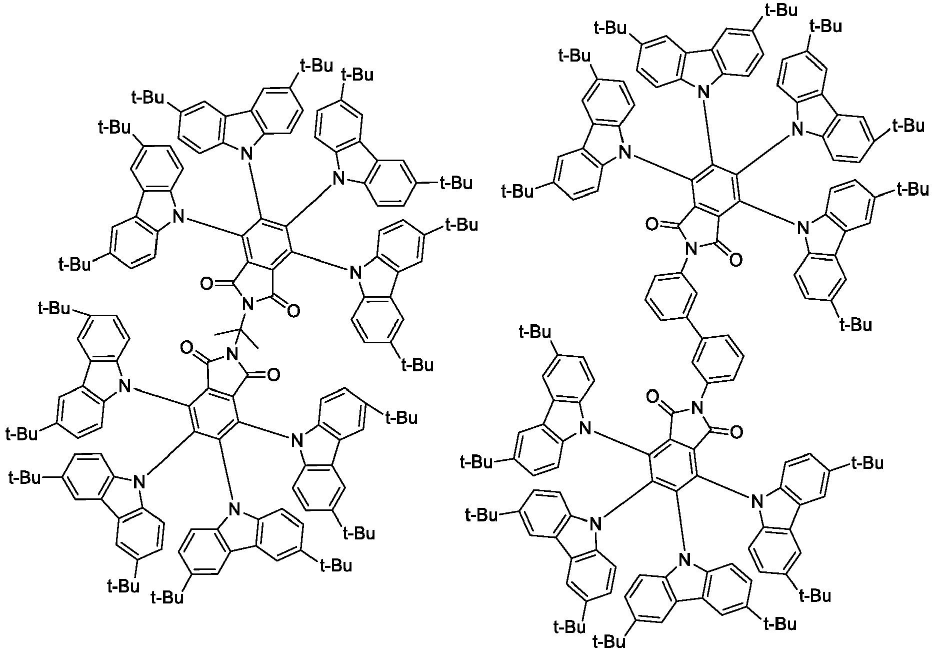

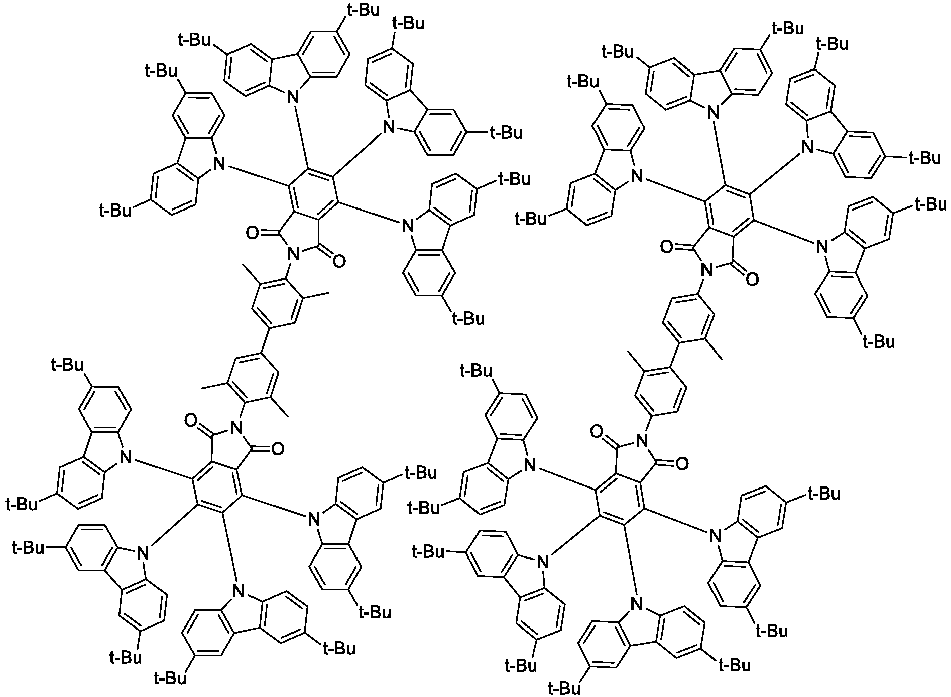

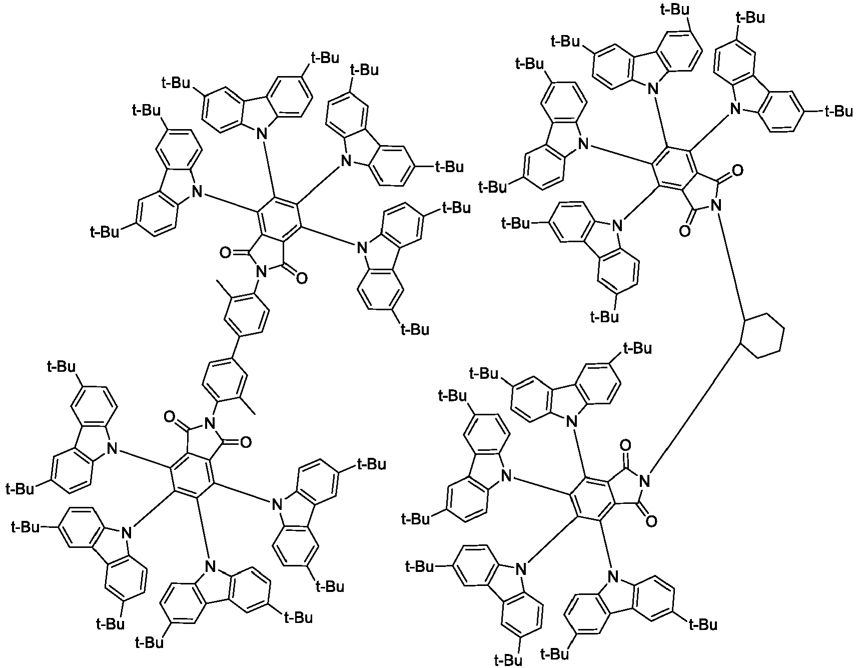

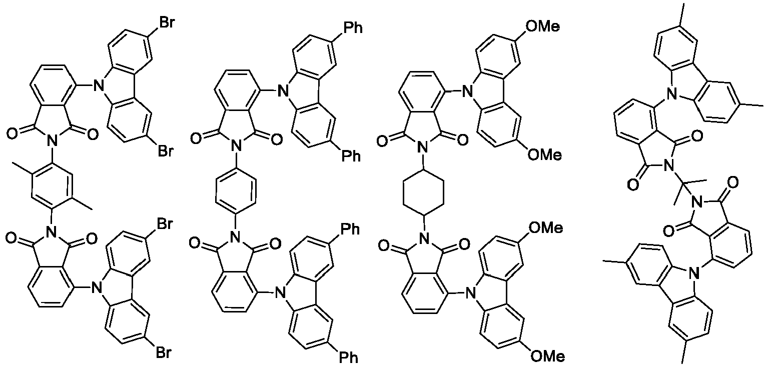

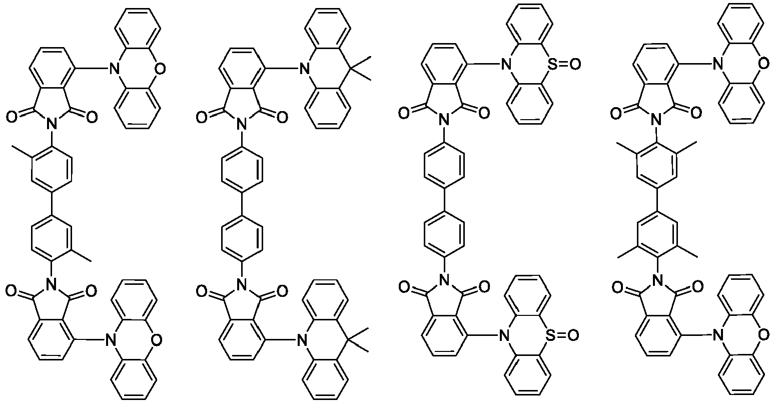

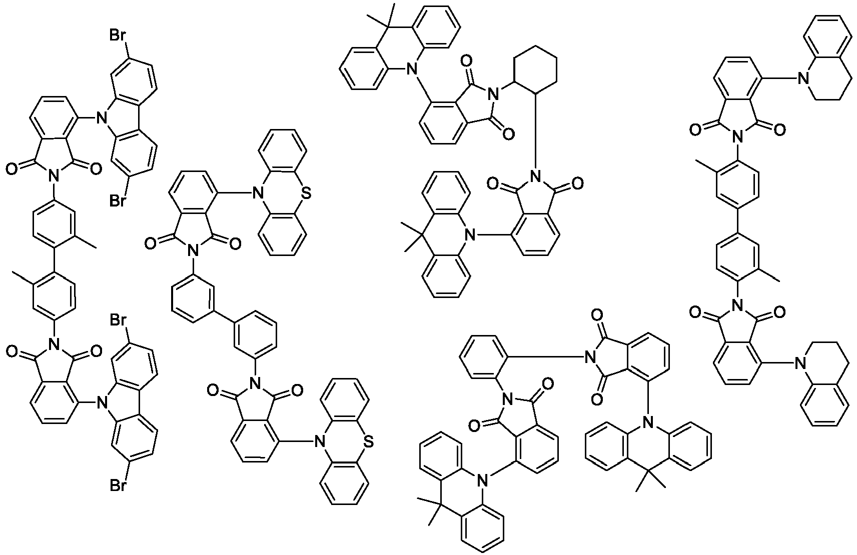

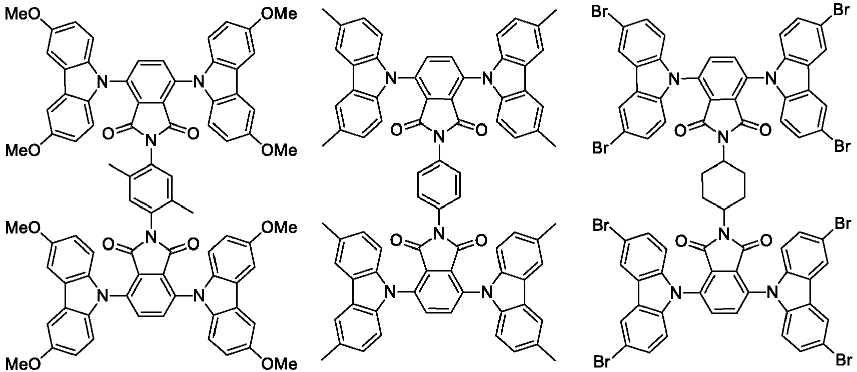

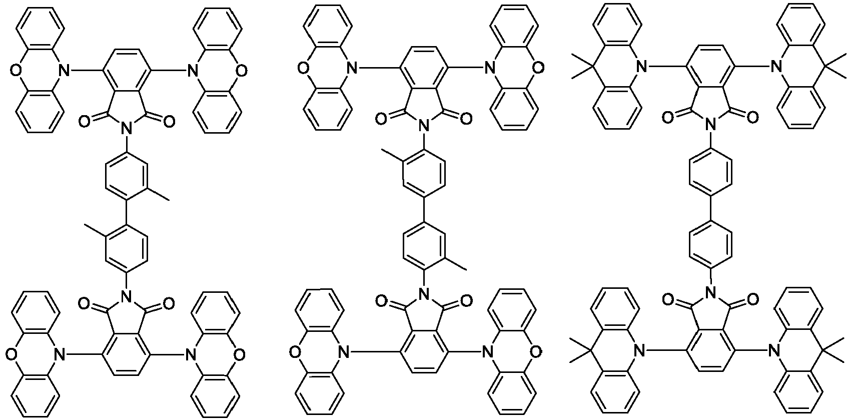

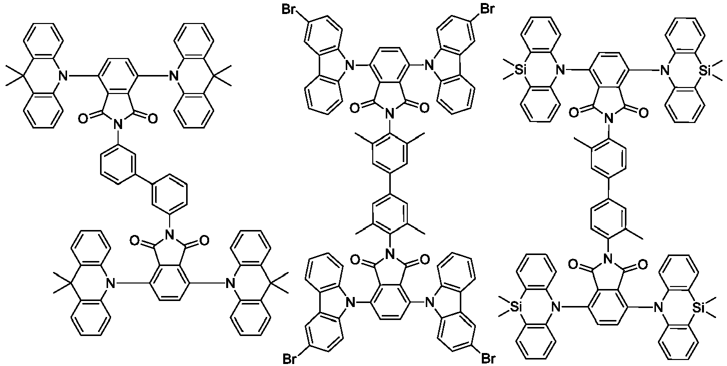

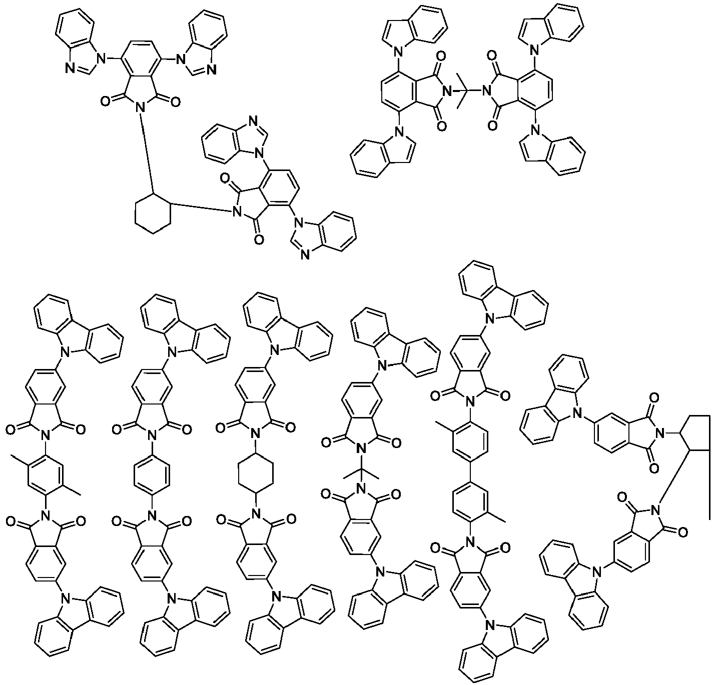

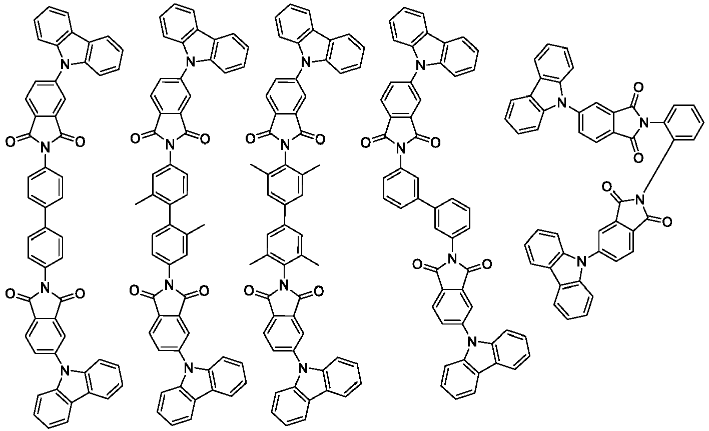

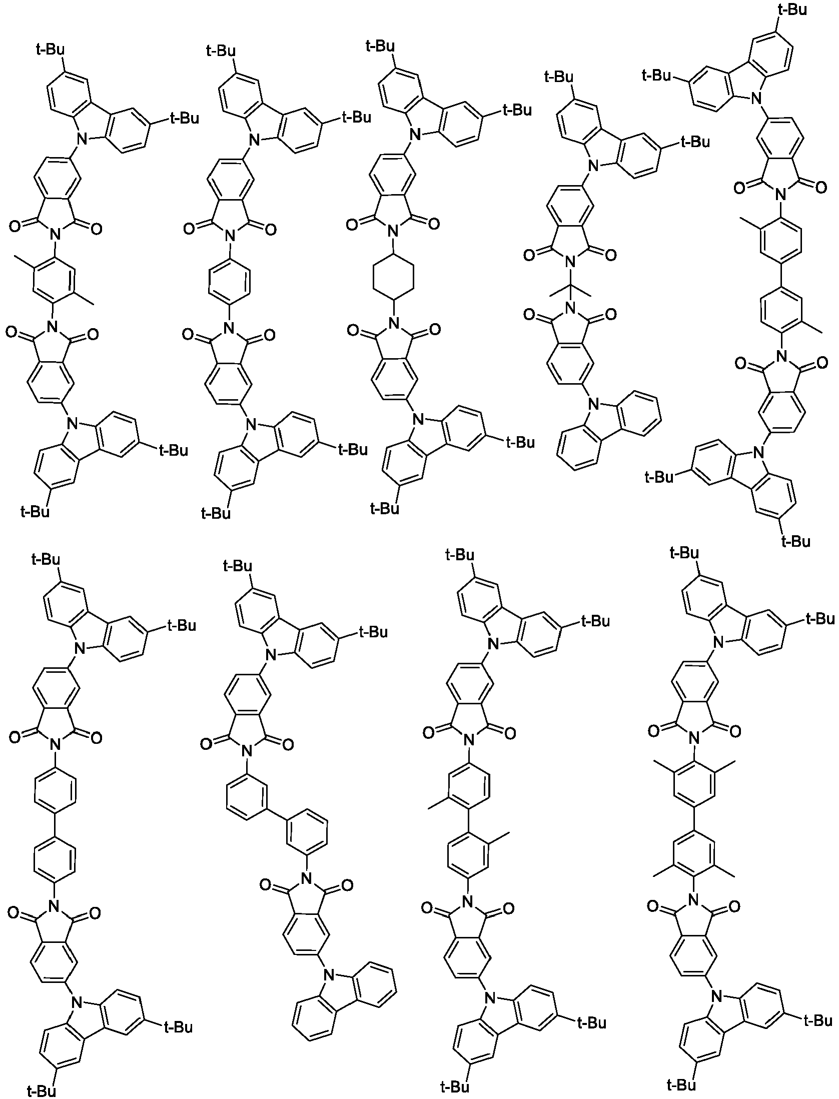

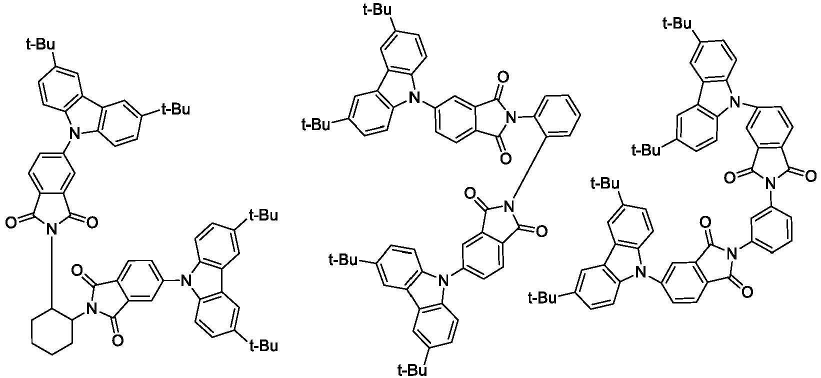

### Herstellung und Charakterisierung von organischen Elektrolumineszenzvorrichtungen aus der Gasphase

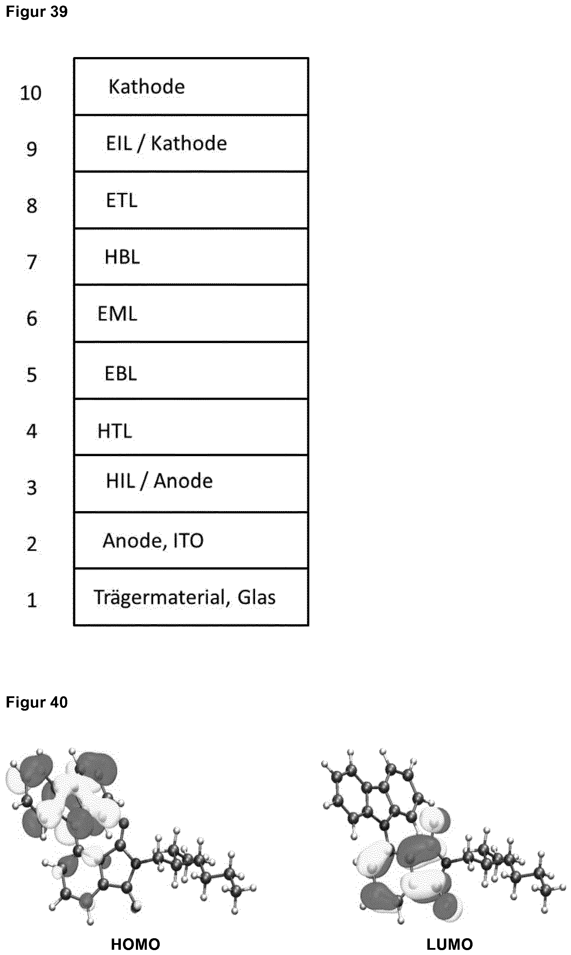

Mit den erfindungsgemäßen organischen Molekülen 4 und 8 als Emittersubstanzen wurden OLED-Devices mittels Vakuum-Sublimationstechnik erstellt.
Diese noch nicht optimierten OLEDs wurden standardmäßig charakterisiert; hierfür wurden die Elektrolumineszenzspektren, die externe Quanteneffizienz (gemessen in %) in Abhängigkeit von der Helligkeit, berechnet aus dem von der Fotodiode detektiertem Licht, den Elektrolumineszenzspektren und dem Strom aufgenommen.
Die Bedeutung der in Figur 39 gezeigten Schichten ist wie folgt:
1. Als Trägermaterial kann Glas oder jedes andere geeignete feste oder flexible durchsichtige Material verwendet werden.
2. Anode = ITO = Indium-Zinn-Oxid
3. HIL = hole injection layer = Lochinjektionschicht. Hierfür kann beispielsweise das kommerziell erhältliche PEDOT:PSS verwendet werden. Typische Schichtdicke: 20-80 nm. Kleine Moleküle können auch verwendet werden (z. B. Kupfer-Phthalocyanin (CuPc z. B. 10 nm dick)) oder Metalloxide z.B. MoO₃, V₂O₅, etc. HIL kann auch als Anode angesehen werden.
4. HTL = hole transport layer = Lochtransportschicht. Diese Schicht ist wie hinten ausgeführt, optional, kann jedoch zur Verbesserung der Bauteileigenschaften verwendet werden. Hierfür kann z. B. [alpha]-NPD (N,N'-Di(1-naphthyl)-N,N'-diphenyl-(1,1'-biphenyl)-4,4'-diamin), TAPC (4,4'-Cyclohexyliden-bis[N,N-bis(4-methylphenyl)benzenamine]), TCTA (Tris(4-carbazoyl-9-ylphenyl)amin), mCP (1,3-Bis(N-carbazolyl)benzen) oder TrisPCz (9,9'-Diphenyl-6-(9-phenyl-9H-carbazol-3-yl)-9H,9'H-3,3'-bicarbazol) in einer Dicke von z. B. 20 nm eingesetzt werden.
5. EBL = Die Elektronenblockierschicht (optional) soll dafür sorgen, dass der Elektronentransport zur Anode unterbunden wird, da die Ladungsträger in die Emitter-Schicht gehalten werden und die Lochtransportschicht nicht durch Elektronen degradiert wird (Dicke z. B. 30 nm). Schichte 4 und 5 können ein einziges Material sein wenn die HTL sowohl gute Eigenschaften als Lochtransport- und Elektronenblockierschicht aufweist.
6. EML = Die Emitter-Schicht enthält oder besteht aus dem erfindungsgemässen Emittermaterial. Dieses kann für die sublimierbaren erfindungsgemässen Materialien durch Sublimation aufgetragen werden. Die Schichtdicke kann z. B. zwischen 10 nm und 200 nm liegen. Für im Grünen oder im Roten emittierende erfindungsgemässe Emittermaterialien eignen sich die gängigen Matrixmaterialien wie CBP (4,4'-Bis-(N-carbazolyl)- biphenyl). Für im Blauen emittierende erfindungsgemässe Emitter-materialien können UGH-Matrixmaterialien (siehe z. B. M.E. Thompson et al., Chem. Mater. 2004, 16, 4743) oder andere sogenannten Wide-Gap-Matrixmaterialien eingesetzt werden.
7. HBL= Hole Blocking Layer =Die Lochblockierschicht soll die Ladungsträger in die Emitterschicht halten (optional). Diese Schicht kann z. B. 10 nm dick sein. Als Material eignet sich z. B. BCP (4,7-Diphenyl-2,9- dimethyl-phenanthrolin = Bathocuproin) oder TSPO1 (Diphenyl-4-triphenylsilylphenyl-phosphinoxid).
8. ETL = Electron Transport Layer = Elektronentransportschicht. Zum Beispiel kann das aufdampfbare Alq3 (Aluminium-tris(8-hydroxychinolin)) oder TPBi (1,3,5-Tris(1-phenyl-1H-benzimidazol-2-yl)benzen) verwendet werden. Dicke ist z. B. 25 nm. Schichte 7 und 8 können ein einziges Material sein wenn wenn die ETL sowohl gute Eigenschaften als Elektronentransport- und Lochblockierschicht aufweist.
9. Kathode. Diese Schicht wird in der Regel aufgedampft und ist z.B LiF, Ca, Mg, Ba. Gegebenenfalls können die ETL- und die CsF-Schicht entfallen. Die Schichtdicke beträgt zwischen 0.5 und 30 nm.
10. Al oder anderen stabile Metalle (Cu, Ag,...) werden aufgedampft um die reaktive Kathode zu beschützen. Al kann auch mit der unteren Schicht reagieren (z.b LiF/Al) (Xie, Z. T., Zhang, W. H., Ding, B. F., Gao, X. D., You, Y. T., Sun, Z. Y., ... Hou, X. Y. (2009). Interfacial reactions at Al/LiF and LiF/Al. Applied Physics Letters, 94(6), 063302. doi:10.1063/1.3077167). Typische Schichtdicken betragen 100 nm.

Die am Device anliegende Spannung beträgt z. B. 2.5 V bis 15 V.

### Prototypen von aufgedampften organischen Emittern

Verwendet wurde die oben genannten Emitter **4** und **8**

**Tabelle 1: Device-Ergebnisse. Dicke des TCTA zwischen 15-35nm, mCP zwischen 15-35nm, EML zwischen 15-45nm, TSPO1 zwischen 15-35nm, TPB zwischen: 15-35nm.**

| OLED No. | Schicht 1 | Schicht 2 | Schicht 3 | Schicht 4 | Schicht 5 | Schicht 6 | Schicht 7 | Schicht 8 | Schicht 9 |
|---|---|---|---|---|---|---|---|---|---|
| 1 | ITO | PEDOT :PSS | TCTA | mCP | Emitter **4** | TSPO1 | TPBi | LiF | Al |
| 2 | ITO | PEDOT :PSS | TCTA | mCP | Emitter **4**:SiMC P2 20 wt.% | TSPO1 | TPBi | LiF | Al |
| 3 | ITO | PEDOT :PSS | TCTA | mCP | Emitter **8** | TSPO1 | TPBi | LiF | Al |
| 4 | ITO | PEDOT :PSS | TCTA | mCP | Emitter **8**:SiMC P2 20 wt. % | TSPO1 | TPBi | LiF | Al |
| 5 | ITO | V2O5 | TCTA | mCP | Emitter **4** | TSPO1 | TPBi | LiF | Al |

**Tabelle 2: Fortsetzung der Tabelle 1**

| OLED No. | Wellenlänge (nm) | (CIE_{X}, CIE_{y}) | Leuchtdichte (cd/m²) | Leistungseffizienz (lm/W) | Stromeffizienz (cd/A) | EQE (%) |
|---|---|---|---|---|---|---|
| 1 | 515 | (0.32, 0.51) | 8570 | 7.9 | 25.2 | 8.5 |
| 2 | 498 | (0.26, 0.45) | 3200 | 4.7 | 12 | 4.3 |
| 3 | 530 | (0.35, 0.52) | 8900 | 3.8 | 10.7 | 3.4 |
| 4 | 510/515 | (0.30, 0.49) | 3440 | 5.0 | 14.2 | 4.8 |
| 5 | 507 | (0.28, 0,48) | 3750 | 8.2 | 26.3 | 9.3 |

**Tabelle 3: Device-Ergebnisse.**

| OLED No. | Schicht 1 | Schicht 2 | Schicht 3 | Schicht 4 | Schicht 5 | Schicht 6 | Schicht 7 | Schicht 8 |
|---|---|---|---|---|---|---|---|---|
| 6 | ITO | HAT-CN | Tris-Pcz | Emitter **4**:mCBP | T2T | BpyTP2 | Liq | Al |
| 7 | ITO | HAT-CN | Tris-Pcz | **4**:mCBP | T2T | BPyTP2 | LiF | Al |
| 8 | ITO | HAT-CN | Tris-Pcz | Emitter **8**:mCBP | T2T | BpyTP2 | Liq | Al |

**Tabelle 4: Fortsetzung der Tabelle 3**

| OLED No. | Wellenlänge (nm) | (CIEₓ, CIE_{y}) | Leuchtdichte (cd/m²) | Leistungseffizienz (lm/W) | Stromeffizienz (cd/A) | EQE (%) |
|---|---|---|---|---|---|---|
| 6 | 512 | (0.29, 0.49) | 24066 | 10.8 | 29.7 | 9.9 |
| 7 | 502 | (0.26, 0.47) | 21951 | 21.7 | 28.8 | 10 |
| 8 | 524 | (0.33, 0.52) | 23962 | 11.6 | 22.5 | 7.5 |

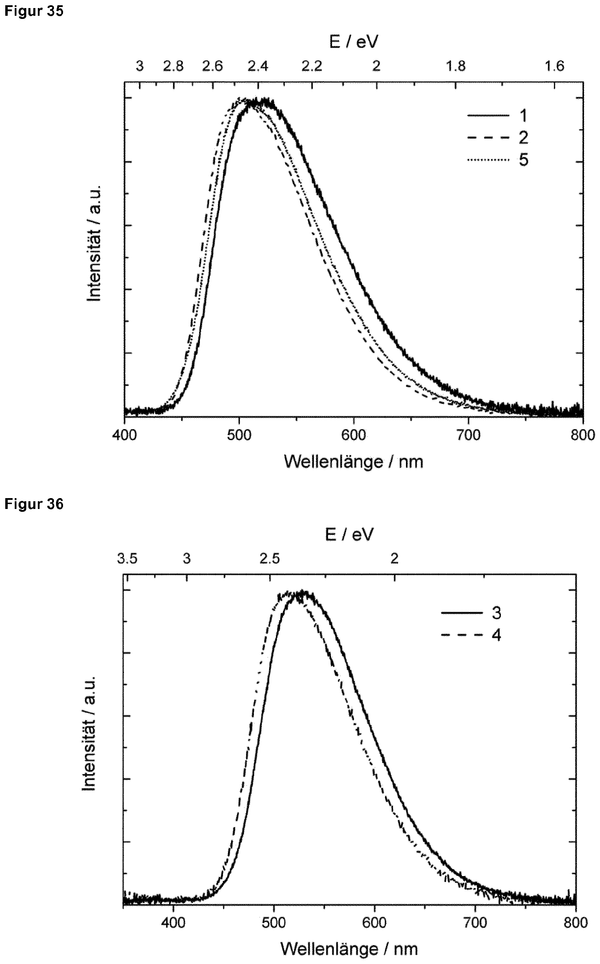

Die Elektrolumineszenzspektren der oben gezeigten Bauteile sind in den Figuren 35 und 36 gezeigt.

### Figuren

**Figur 1****:** Absorptionsspektrum von **2** in Dichlormethan.
**Figur 2****:** Filmemission von **2** (10 % in PMMA).
**Figur** 3: Absorptionsspektrum von **3** in Dichlormethan.
**Figur 4****:** Filmemission von **3** (10 % in PMMA).
**Figur 5****:** Absorptionsspektrum von **4** in Dichlormethan.
**Figur 6****:** Filmemission von **4** (10 % in PMMA).
**Figur** 7: Absorptionsspektrum von **5** in Dichlormethan.
**Figur 8****:** Filmemission von **5** (10 % in PMMA).
**Figur 9****:** Absorptionsspektrum von **6** in Dichlormethan.
**Figur 10****:** Filmemission von **6** (10 % in PMMA).
**Figur 11****:** Absorptionsspektrum von **7** in Dichlormethan.
**Figur 12****:** Filmemission von **7** (10 % in PMMA).
**Figur 13****:** Absorptionsspektrum von **8** in Dichlormethan.
**Figur 14****:** Filmemission von **8** (10 % in PMMA).
**Figur 15****:** Absorptionsspektrum von **9** in Dichlormethan.
**Figur 16****:** Filmemission von **9** (10 % in PMMA).
**Figur 17****:** Absorptionsspektrum von **10** in Dichlormethan.
**Figur 18****:** Filmemission von **10** (10 % in PMMA).
**Figur 19****:** Absorptionsspektrum von **11** in Dichlormethan.
**Figur 20****:** Filmemission von **11** (10 % in PMMA).
**Figur 21****:** Absorptionsspektrum von **12** in Dichlormethan.
**Figur 22****:** Filmemission von **12** (10 % in PMMA).
**Figur 23****:** Absorptionsspektrum von **13** in Dichlormethan.
**Figur 24****:** Filmemission von **13** (10 % in PMMA).
**Figur 25****:** Absorptionsspektrum von **14** in Dichlormethan.
**Figur 26****:** Filmemission von **14** (10 % in PMMA).
**Figur 27****:** Absorptionsspektrum von **15** in Dichlormethan.
**Figur 28****:** Filmemission von **15** (10 % in PMMA).
**Figur 29****:** Absorptionsspektrum von **16** in Dichlormethan.
**Figur 30****:** Filmemission von **16** (10 % in PMMA).
**Figur 31****:** Absorptionsspektrum von **19** in 2-Methyltetrahydrofuran.
**Figur 32****:** Filmemission von **19** (10 % in PMMA).
**Figur 33****:** Filmemission von **21** (10 % in PMMA).
**Figur 34****:** Filmemission von **22** (10 % in PMMA).
**Figur 35****:** Elektrolumineszenzspektrum für **4,** wobei sich die Nummerierung auf die OLED-Bauteile der Tabellen 1 und 2 bezieht.
**Figur 36****:** Elektrolumineszenzspektrum für **8,** wobei sich die Nummerierung auf die OLED-Bauteile der Tabellen 1 und 2 bezieht.

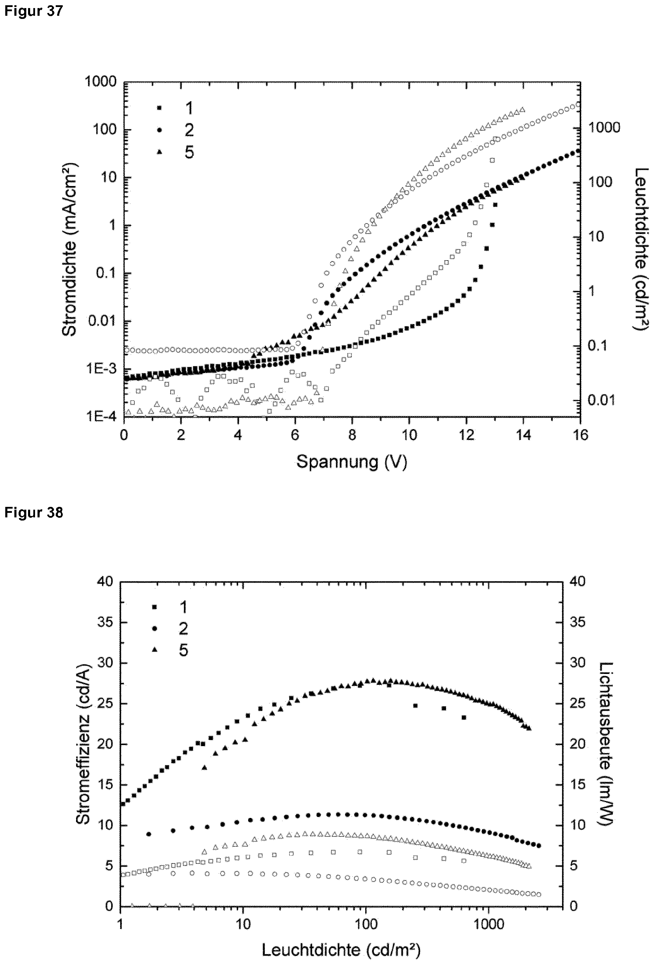

**Figur** 37: U-I-Kennlinie (ausgefüllte Symbole) und Helligkeiten in Abhängigkeit der Spannung (leere Symbole) für **4** und **8,** wobei sich die Nummerierung auf die OLED-Bauteile der Tabellen 1 und 2 bezieht.
**Figur 38****:** Stromeffizienz (ausgefüllte Symbole) und Leistungseffizienz (leere Symbole) für **4** und **8,** aufgetragen gegen die Leuchtdichte, wobei sich die Nummerierung auf die OLED-Bauteile der Tabellen 1 und 2 bezieht.
**Figur 39****:** Schematischer Aufbau eines OLED-Devices.
**Figur 40****:** HOMO und LUMO von **3**, Rechnungsmethode: DFT, Funktional: BP86, Basissatz: def2-SV(P), Rechnungssoftware: Turbomole 6.5. Es erfolgte eine Strukturoptimierung für den elektronischen Grundzustand.

## Patentansprüche

1. Organisches Molekül, aufweisend eine Struktur der Formel A 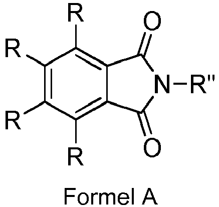 wobei mindestens ein R am Arylring einen Donor D darstellt der eine Struktur der Formel I aufweist: 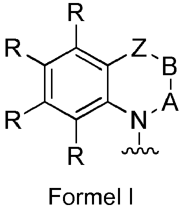 wobei
A und B = unabhängig voneinander ausgewählt aus der Gruppe bestehend aus CRR', CR, NR, N, wobei zwischen A und B eine Einfach- oder Doppelbindung vorliegt und zwischen B und Z eine Einfach- oder Doppelbindung vorliegt;
Z = eine direkte Bindung oder eine divalente organische Brücke, die eine substituierte oder unsubstituierte C1-C9-Alkylen-, C2-C8-Alkenylen-, C2-C8-Alkinylen- oder Arylen-Gruppe oder eine Kombination dieser, -CRR', -C=CRR', -C=NR, -NR-, -O-, -SiRR'-, -S-, -S(O)-, -S(O)₂-, durch O unterbrochene substituierte oder unsubstituierte C1-C9-Alkylen-, C2-C8-Alkenylen-, C2-C8-Alkinylen-oder Arylen-Gruppe, Phenyl- oder substituierte Phenyleinheiten ist; wobei die gewellte Linie die Position kennzeichnet, über die der Donor D an den Phenylring in Formel A gebunden ist;
wobei jedes R und R' bei jedem Auftreten gleich oder verschieden ist H, Deuterium, Azid (N₃⁻), F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme, oder eine quervernetzbare Einheit ist, die durch säurekatalytische, thermische oder UV-Quervernetzungsverfahren quervernetzt werden kann; dabei können zwei oder mehrere dieser Substituenten R und R' auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
und wobei R" die gleiche Bedeutung wie R hat oder eine organische Brücke ist, worüber eine zweite gleiche oder verschiedene Einheit der Formel A verbunden ist und somit ein dimeres System ausgebildet wird.

2. Organisches Molekül nach Anspruch 1, aufweisend eine Struktur der Formel D* 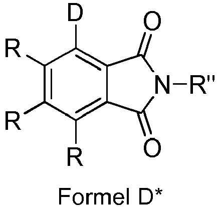 mit R, R" und D wie in Anspruch 1 definiert, wobei R kein Donor ist und insbesondere gleich H ist.

3. Organisches Molekül nach Anspruch 2, aufweisend eine Struktur der Formel E 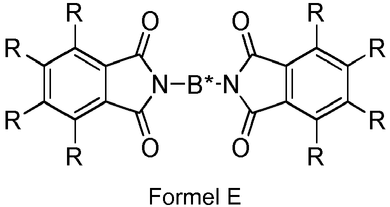 wobei
mindestens ein R am Arylring einen Donor darstellt;
B* = eine organische Brücke, die eine substituierte oder unsubstituierte Alkylen-, Alkenylen-, Alkinylen- oder Arylen-Gruppe oder eine Kombination dieser, oder -O-, -NR-, -C=CR₂, -C=NR, -SiR₂- - S-, -S(O)-, -S(O)₂-, durch O unterbrochene Alkyl- (auch verzweigt oder zyklisch), Heteroalkyl-, Aryl-, Heteroaryl-, Alkenyl-Gruppen, Phenyl- und substituierte Phenyleinheiten ist;
und im Übrigen die in Anspruch 1 angegeben Definitionen gelten.

4. Organisches Molekül nach Anspruch 1 bis 3, wobei
der Donor D ausgewählt ist aus der Gruppe bestehend aus substituierten und unsubstituierten Carbazol, substituierten und unsubstituierten Indol, substituierten und unsubstituierten Indolin, substituierten und unsubstituierten Dihydroacridin, substituierten und unsubstituierten Benzimidazol, substituierten und unsubstituierten 2,3,4,9-Tetrahydrocarbazol, substituierten und unsubstituierten 1,2,3,4-Tetrahydrochinolin, substituierten und unsubstituierten Phenothiazin, substituierten und unsubstituierten Phenoxazin, substituierten und unsubstituierten Dihydrophenazin, substituierten und unsubstituierten Spiroverbindungen.

5. Organisches Molekül nach Anspruch 1 bis 4, wobei die Donorgruppe mit elektronenschiebenden Eigenschaften der Formel I eine Struktur der Formel II aufweist: 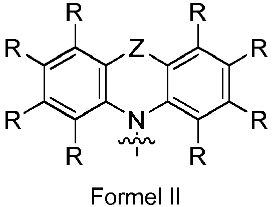 wobei
Z = eine direkte Bindung oder eine divalente organische Brücke, die eine substituierte oder unsubstituierte C1-C9-Alkylen-, C2-C8-Alkenylen-, C2-C8-Alkinylen- oder Arylen-Gruppe oder eine Kombination dieser, -CRR', -C=CRR', -C=NR, -NR-, -O-, SiRR'-, -S-, -S(O)-, -S(O)₂-, durch O unterbrochene substituierte oder unsubstituierte C1-C9-Alkylen-, C2-C8-Alkenylen-, C2-C8-Alkinylen- oder Arylen-Gruppe, Phenyl- oder substituierte Phenyleinheiten ist, wobei die gewellte Linie die Anbindungsposition von D kennzeichnet;
jedes R und R' bei jedem Auftreten gleich oder verschieden ist H, Deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann, oder eine Kombination dieser Systeme, oder eine quervernetzbare Einheit ist, die durch säurekatalytische, thermische oder UV-Quervernetzungsverfahren quervernetzt werden kann; dabei können zwei oder mehrere dieser Substituenten R und R' auch miteinander ein mono- oder polycyclisches, aliphatisches, aromatisches und/oder benzoannelliertes Ringsystem bilden;
R² bei jedem Auftreten gleich oder verschieden ist H, Deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch R³C=CR³, C≡C, Si(R³)₂, Ge(R³)₂, Sn(R³)₂, C=O, C=S, C=Se, C=NR³, P(=O)(R³), SO, SO₂, NR³, O, S oder CONR³ ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R³ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R² auch miteinander ein mono- oder polycyclisches, aromatisches und/oder benzoannelliertes Ringsystem bilden;
R³ bei jedem Auftreten gleich oder verschieden ist H, Deuterium, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.

6. Organisches Molekül nach Anspruch 5, wobei Z gleich einer direkten Bindung ist.

## Claims

1. Organic molecule comprising a structure of formula A 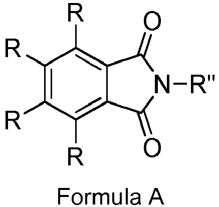 wherein at least one R at the aryl ring is a donor D which comprises a structure of formula I: 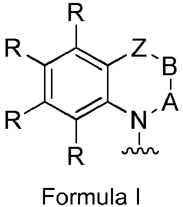 wherein
A and B = independently from each other selected from the group consisting of CRR', CR, NR, N, wherein there is a single or a double bond between A and B and a single or a double bond between B and Z;
Z = direct bond or a divalent organic bridge, which is a substituted or unsubstituted C1-C9-alkylene, C2-C8-alkenylene, C2-C8-alkynylene or arylene group or a combination of these, -CRR', -C=CRR', - C=NR, -NR-, -O-, -SiRR'-, -S-, -S(O)-, -S(O)₂-, O-interrupted substituted or unsubstituted C1-C9-alkylene, C2-C8-alkenylene, C2-C8-alkynylene or arylene groups, phenyl or substituted phenyl units; wherein the waved line indicates the position over which the donor D is bound to the phenyl ring in formula A;
wherein each R and R' at each occurence is the same or different H, deuterium, azide (N₃⁻), F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², a linear alkyl, alkoxy or thioalkoxy group with 1 to 40 C-atoms or a linear alkenyl or alkynyl group with 2 to 40 C-atoms or a branched or cyclic alkyl, alkenyl, alkynyl, alkoxy or thioalkoxy group with 3 to 40 C-atoms, which each can be substituted by one or more radicals R², wherein one or more not adjacent CH₂-groups can be replaced by R²C=CR², C≡C, Si(R²)₂, Ge(R²)₂, Sn(R²)₂, C=O, C=S, C=Se, C=NR², P(=O)(R²), SO, SO₂, NR², O, S or CONR² and wherein one or more H-atoms can be replaced by deuterium, F, Cl, Br, I, CN, CF₃ or NO₂, or an aromatic or heteroaromatic ring system with 5 to 60 aromatic ring atoms, which each can be substituted by one or more radicals R², or an aryloxy or heteroaryloxy group with 5 to 60 aromatic ring atoms, which can be substituted by one or more radicals R², or a diarylamino group, diheteroarylamino group or arylheteroarylamino group with 10 to 40 aromatic ring atoms, which can be substituted by one or more radicals R², or a combination of these systems, or a cross-linkable unit QE, which can be cross-linked by acid-catalyzed, base-catalyzed, thermal or UV cross-linking processes; thereby two or more of the substituents R and R' can also form with each other a mono- or polycyclic, aliphatic, aromatic and/or benzoannulated ring system;
R² is at each occurence same or different H, deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, a linear alkyl, alkoxy or thioalkoxy group with 1 to 40 C-atoms or a linear alkenyl or alkynyl group with 2 to 40 C-atoms or a branched or cyclic alkyl, alkenyl, alkynyl, alkoxy or thioalkoxy group with 3 to 40 C-atoms, which each can be substituted by one or more radicals R³, wherein one or more not adjacent CH₂-groups can be replaced by R³C=CR³, C≡C, Si(R³)₂, Ge(R³)₂, Sn(R³)₂, C=O, C=S, C=Se, C=NR³, P(=O)(R³), SO, SO₂, NR³, O, S or CONR³ and wherein one or more H-atoms can be replaced by deuterium, F, Cl, Br, I, CN, CF₃ or NO₂, or an aromatic or heteroaromatic ring system with 5 to 60 aromatic ring atoms, which each can be substituted by one or more radicals R³, or an aryloxy or heteroaryloxy group with 5 to 60 aromatic ring atoms, which can be substituted by one or more radicals R³, or a diarylamino group, diheteroarylamino group or arylheteroarylamino group with 10 to 40 aromatic ring atoms, which can be substituted by one or more radicals R³, or a combination of these systems; thereby two or more of these substituents R² can also form with each other a mono- or polycyclic, aromatic and/or benzoannulated ring system;
R³ is at each occurrence same or different H, deuterium, F, CF₃ or an aliphatic, aromatic and/or heteroaromatic hydrocarbon radical with 1 to 20 C-atoms, in which one or more H-atoms can also be replaced by F oder CF₃; thereby two or more substituents R³ can also form with each other a mono-or polycyclic aliphatic ring system;
and wherein R" has the same meaning as R or is an organic bridge via which a second identical or different unit of formula A is bound, thereby forming a dimeric system.

2. Organic molecule according to claim 1, comprising a structure of formula D* 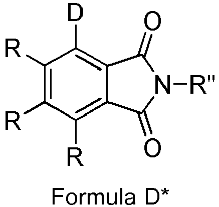 with R, R" and D defined as in claim 1, wherein R is not a donor and is in particular H.

3. Organic molecule according to claim 2, comprising a structure of formula E 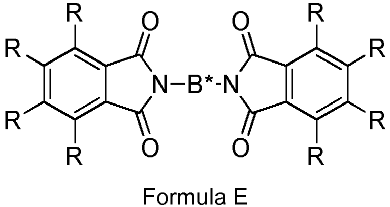 wherein
at least one R at the aryl ring is a donor D;
B* = an organic bridge, which is a substituted or unsubstituted alkylene, alkenylene, alkynylene or arylene group or a combination of these, or -O-, -NR-, -C=CR₂, -C=NR, -SiR₂- -S-, -S(O)-, -S(O)₂-, O-interrupted alkyl (also branched or cyclic), heteroalkyl, aryl, heteroaryl, alkenyl, phenyl and substituted phenyl units;
and apart from that the definitions given in claim 1 apply.

4. Organic molecule according to claim 1 to 3, wherein
the donor D is selected from the group consisting of substituted and unsubstituted carbazole, substituted and unsubstituted indole, substituted and unsubstituted indoline, substituted and unsubstituted dihydroacridine, substituted and unsubstituted benzimidazole, substituted and unsubstituted 2,3,4,9-tetrahydrocarbazole, substituted and unsubstituted 1,2,3,4-tetrahydroquinoline, substituted and unsubstituted phenothiazine, substituted and unsubstituted phenoxazine, substituted and unsubstituted dihydrophenazine, substituted and unsubstituted spiro compounds.

5. Organic molecule according to claim 1 to 4, wherein the donor group with electron-donating properties of formula I comprises a structure of formula II: 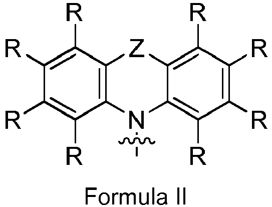 wherein
Z = direct bond or a divalent organic bridge, which is a substituted or unsubstituted C1-C9-alkylene, C2-C8-alkenylene, C2-C8-alkynylene or arylene group or a combination of these, -CRR', -C=CRR', - C=NR, -NR-, -O-, -SiRR'-, -S-, -S(O)-, -S(O)₂-, O-interrupted substituted or unsubstituted C1-C9-alkylene, C2-C8-alkenylene, C2-C8-alkynylene or arylene groups, phenyl or substituted phenyl units; wherein the waved line indicates the linkage position of D;
each R and R' at each occurence is same or different H, deuterium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R², OSO₂R², a linear alkyl, alkoxy or thioalkoxy group with 1 to 40 C-atoms or a linear alkenyl or alkynyl group with 2 to 40 C-atoms or a branched or cyclic alkyl, alkenyl, alkynyl, alkoxy or thioalkoxy group with 3 to 40 C-atoms, which each can be substituted by one or more radicals R², wherein one or more not adjacent CH₂-groups can be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and wherein one or more H-atoms can be replaced by deuterium, F, Cl, Br, I, CN, CF₃ or NO₂, or an aromatic or heteroaromatic ring system with 5 to 60 aromatic ring atoms, which each can be substituted by one or more radicals R², or an aryloxy or heteroaryloxy group with 5 to 60 aromatic ring atoms, which can be substituted by one or more radicals R², or a diarylamino group, diheteroarylamino group or arylheteroarylamino group with 10 to 40 aromatic ring atoms, which can be substituted by one or more radicals R², or a combination of these systems, or a cross-linkable unit, which can be cross-linked by acid-catalyzed, thermal or UV cross-linking processes; thereby two or more of the substituents R and R' can form with each other a mono- or polycyclic, aliphatic, aromatic and/or benzoannulated ring system;
R² is at each occurence same or different H, deuterium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³, S(=O)₂R³, OSO₂R³, a linear alkyl, alkoxy or thioalkoxy group with 1 to 40 C-atoms or a linear alkenyl or alkynyl group with 2 to 40 C-atoms or a branched or cyclic alkyl, alkenyl, alkynyl, alkoxy or thioalkoxy group with 3 to 40 C-atoms, which each can be substituted by one or more radicals R³, wherein one or more not adjacent CH₂-groups can be replaced by R³C=CR³, C=C, Si(R³)₂, Ge(R³)₂, Sn(R³)₂, C=O, C=S, C=Se, C=NR³, P(=O)(R³), SO, SO₂, NR³, O, S or CONR³ and wherein one or more H-atoms can be replaced by deuterium, F, Cl, Br, I, CN, CF₃ or NO₂, or an aromatic or heteroaromatic ring system with 5 to 60 aromatic ring atoms, which each can be substituted by one or more radicals R³, or an aryloxy or heteroaryloxy group with 5 to 60 aromatic ring atoms, which can be substituted by one or more radicals R³, or a diarylamino group, diheteroarylamino group or arylheteroarylamino group with 10 to 40 aromatic ring atoms, which can be substituted by one or more radicals R³, or a combination of these systems; thereby two or more of these substituents R² can also form with each other a mono- or polycyclic, aromatic and/or benzoannulated ring system;
R³ is at each occurrence same or different H, deuterium, F, CF₃ or an aliphatic, aromatic and/or heteroaromatic hydrocarbon radical with 1 to 20 C-atoms, in which one or more H-atoms can also be replaced by F oder CF₃; thereby two or more substituents R³ can also form with each other a mono-or polycyclic aliphatic ring system.

6. Organic molecule according to claim 5, wherein Z is a direct bond.

## Revendications

1. Molécule organique, présentant une structure de formule A 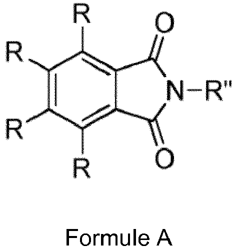 dans laquelle au moins un R sur le cycle aryle représente un donneur D qui présente une structure de formule I : 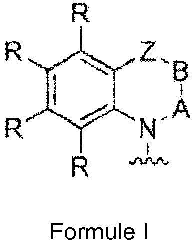 dans laquelle
A et B = choisis indépendamment l'un de l'autre dans le groupe constitué par CRR', CR, NR, N, une simple ou double liaison étant présente entre A et B et une simple ou double liaison étant présente entre B et Z ;
Z = une liaison directe ou un pont organique bivalent, qui est un groupe alkylène en C1-C9, alcénylène en C2-C8, alcynylène en C2-C8 ou arylène substitué ou non substitué, ou une combinaison de ceux-ci, -CRR', -C=CRR', -C=NR, -NR-, -O-, -SiRR', -S-, -S(O)-, -S(O)₂-, un groupe alkylène en C1-C9, alcénylène en C2-C8, alcynylène en C2-C8 ou arylène substitué ou non substitué interrompu par O, des unités phényle ou phényle substituée ; la ligne ondulée désignant la position à laquelle le donneur D est relié au cycle phényle dans la formule A ;
chaque R et R' étant à chaque occurrence, de manière identique ou différente, H, deutérium, azide (N₃⁻), F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R ² OSO₂R², un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R², un ou plusieurs groupes CH₂ non voisins pouvant être remplacés par R²C=CR², C=C, Si(R²)₂, Ge(R²)₂, Sn(R²)₂, C=O, C=S, C=Se, C=NR², P(=O)(R²), SO, SO₂, NR², O, S ou CONR², et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R², ou un groupe aryloxy ou hétéroaryloxy de 5 à 60 atomes de cycle aromatique, qui peut être substitué par un ou plusieurs radicaux R², ou un groupe diarylamino, un groupe dihétéroarylamino ou un groupe arylhétéroarylamino de 10 à 40 atomes de cycle aromatique, qui peut être substitué par un ou plusieurs radicaux R², ou une combinaison de ces systèmes, ou une unité réticulable qui peut être réticulée par un procédé de réticulation sous catalyse acide, thermique ou UV ; deux ou plus de ces substituants R et R' pouvant également former les uns avec les autres un système cyclique mono- ou polycyclique, aliphatique, aromatique et/ou benzoannelé ;
R² étant à chaque occurrence, de manière identique ou différente, H, deutérium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³ S(=O)₂R³ OSO₂R³, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R³, un ou plusieurs groupes CH₂ non voisins pouvant être remplacés par R³C=CR³, C≡C, Si(R³)₂, Ge(R³)₂, Sn(R³)₂, C=O, C=S, C=Se, C=NR³, P(=O)(R³), SO, SO₂, NR³, O, S ou CONR³, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R³, ou un groupe aryloxy ou hétéroaryloxy de 5 à 60 atomes de cycle aromatique, qui peut être substitué par un ou plusieurs radicaux R³, ou un groupe diarylamino, un groupe dihétéroarylamino ou un groupe arylhétéroarylamino de 10 à 40 atomes de cycle aromatique, qui peut être substitué par un ou plusieurs radicaux R³, ou une combinaison de ces systèmes, deux ou plus de ces substituants R² pouvant également former les uns avec les autres un système cyclique mono- ou polycyclique, aromatique et/ou benzoannelé ;
R³ étant à chaque occurrence, de manière identique ou différente, H, deutérium, F, CF₃ ou un radical hydrocarboné aliphatique, aromatique et/ou hétéroaromatique de 1 à 20 atomes C, dans lequel un ou plusieurs atomes H peuvent également être remplacés par F ou CF₃; deux substituants R³ ou plus pouvant également former les uns avec les autres un système cyclique aliphatique mono- ou polycyclique ;
et R" ayant la même signification que R ou étant un pont organique par lequel une deuxième unité de formule A identique ou différente est reliée et un système dimère est ainsi formé.

2. Molécule organique selon la revendication 1, présentant une structure de formule D* 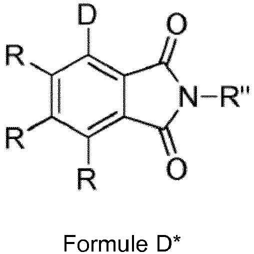 dans laquelle R, R" et D sont tels que définis dans la revendication 1, R n'étant pas un donneur et étant notamment H.

3. Molécule organique selon la revendication 2, présentant une structure de formule E 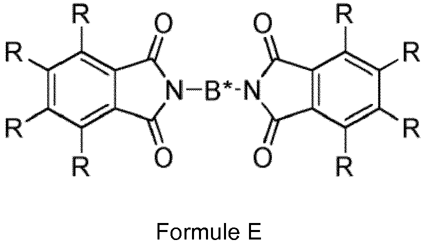 dans laquelle
au moins un R sur le cycle aryle représente un donneur ;
B* = un pont organique, qui est un groupe alkylène, alcénylène, alcynylène ou arylène substitué ou non substitué ou une combinaison de ceux-ci, ou -O-, -NR-,
-C=CR₂-, -C=NR, -SiR₂-, -S-, -S(O)-, -S(O)₂-, des groupes alkyle (également ramifiés ou cycliques), hétéroalkyle, aryle, hétéroaryle, alcényle interrompus par O, des unités phényle et phényle substituée ;
et les définitions indiquées dans la revendication 1 s'appliquent pour le reste.

4. Molécule organique selon les revendications 1 à 3, dans laquelle le donneur D est choisi dans le groupe constitué par le carbazole substitué et non substitué, l'indole substitué et non substitué, l'indoline substituée et non substituée, la dihydroacridine substituée et non substituée, le benzimidazole substitué et non substitué, le 2,3,4,9-tétrahydrocarbazole substitué et non substitué, la 1,2,3,4-tétrahydroquinoline substituée et non substituée, la phénothiazine substituée et non substituée, la phénoxazine substituée et non substituée, la dihydrophénazine substituée et non substituée, les composés spiro substitués et non substitués.

5. Molécule organique selon les revendications 1 à 4, dans laquelle le groupe donneur ayant des propriétés de donneur d'électrons de formule I présente une structure de formule II : 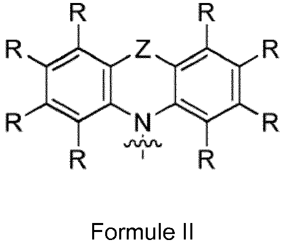 dans laquelle
Z = une liaison directe ou un pont organique bivalent qui est un groupe alkylène en C1-C9, alcénylène en C2-C8, alcynylène en C2-C8 ou arylène substitué ou non substitué, ou une combinaison de ceux-ci, -CRR', -C=CRR', -C=NR, -NR-, -O-, -SiRR'-, -S-, -S(O)-, -S(O)₂-, un groupe alkylène en C1-C9, alcénylène en C2-C8, alcynylène en C2-C8 ou arylène substitué ou non substitué interrompu par O, des unités phényle ou phényle substituée, la ligne ondulée désignant la position de liaison de D ;
chaque R et R' étant à chaque occurrence, de manière identique ou différente, H, deutérium, F, Cl, Br, I, N(R²)₂, CN, CF₃, NO₂, OH, COOH, COOR², CO(NR²)₂, Si(R²)₃, B(OR²)₂, C(=O)R², P(=O)(R²)₂, S(=O)R², S(=O)₂R² OSO₂R², un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R², un ou plusieurs groupes CH₂ non voisins pouvant être remplacés par R²C=CR², C≡C, Si(R²)₂, Ge(R²)₂, Sn(R²)₂, C=O, C=S, C=Se, C=NR², P(=O)(R²), SO, SO₂, NR², O, S ou CONR², et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R², ou un groupe aryloxy ou hétéroaryloxy de 5 à 60 atomes de cycle aromatique, qui peut être substitué par un ou plusieurs radicaux R², ou un groupe diarylamino, un groupe dihétéroarylamino ou un groupe arylhétéroarylamino de 10 à 40 atomes de cycle aromatique, qui peut être substitué par un ou plusieurs radicaux R², ou une combinaison de ces systèmes, ou une unité réticulable qui peut être réticulée par un procédé de réticulation sous catalyse acide, thermique ou UV ; deux ou plus de ces substituants R et R' pouvant également former les uns avec les autres un système cyclique mono- ou polycyclique, aliphatique, aromatique et/ou benzoannelé ;
R² étant à chaque occurrence, de manière identique ou différente, H, deutérium, F, Cl, Br, I, N(R³)₂, CN, CF₃, NO₂, OH, COOH, COOR³, CO(NR³)₂, Si(R³)₃, B(OR³)₂, C(=O)R³, P(=O)(R³)₂, S(=O)R³ S(=O)₂R³, OSO₂R³, un groupe alkyle, alcoxy ou thioalcoxy linéaire de 1 à 40 atomes C ou un groupe alcényle ou alcynyle linéaire de 2 à 40 atomes C ou un groupe alkyle, alcényle, alcynyle, alcoxy ou thioalcoxy ramifié ou cyclique de 3 à 40 atomes C, qui peut à chaque fois être substitué avec un ou plusieurs radicaux R³, un ou plusieurs groupes CH₂ non voisins pouvant être remplacés par R³C=CR³, C≡C, Si(R³)₂, Ge(R³)₂, Sn(R³)₂, C=O, C=S, C=Se, C=NR³, P(=O)(R³), SO, SO₂, NR³, O, S ou CONR³, et un ou plusieurs atomes H pouvant être remplacés par deutérium, F, Cl, Br, I, CN, CF₃ ou NO₂, ou un système cyclique aromatique ou hétéroaromatique de 5 à 60 atomes de cycle aromatique, qui peut à chaque fois être substitué par un ou plusieurs radicaux R³, ou un groupe aryloxy ou hétéroaryloxy de 5 à 60 atomes de cycle aromatique, qui peut être substitué par un ou plusieurs radicaux R³, ou un groupe diarylamino, un groupe dihétéroarylamino ou un groupe arylhétéroarylamino de 10 à 40 atomes de cycle aromatique, qui peut être substitué par un ou plusieurs radicaux R³, ou une combinaison de ces systèmes, deux ou plus de ces substituants R² pouvant également former les uns avec les autres un système cyclique mono- ou polycyclique, aromatique et/ou benzoannelé ;
R³ étant à chaque occurrence, de manière identique ou différente, H, deutérium, F, CF₃ ou un radical hydrocarboné aliphatique, aromatique et/ou hétéroaromatique de 1 à 20 atomes C, dans lequel un ou plusieurs atomes H peuvent également être remplacés par F ou CF₃; deux substituants R³ ou plus pouvant également former les uns avec les autres un système cyclique aliphatique mono- ou polycyclique.

6. Molécule organique selon la revendication 5, dans laquelle Z est une liaison directe.
